(19) Europäisches Patentamt
European Patent Office
Office européen des brevets

(11) **EP 4 592 999 A1**

(12) **EUROPEAN PATENT APPLICATION**
published in accordance with Art. 153(4) EPC

(43) Date of publication:
**30.07.2025   Bulletin 2025/31**

(21) Application number: 23950076.2

(22) Date of filing: **29.08.2023**

(51) International Patent Classification (IPC):
*G09G 3/3208* (2016.01)

(52) Cooperative Patent Classification (CPC):
G09G 3/3208

(86) International application number:
**PCT/CN2023/115538**

(87) International publication number:
**WO 2025/043483 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.
Beijing 100015 (CN)**
• **Chengdu BOE Optoelectronics Technology Co.,
Ltd.
Chengdu, Sichuan 611731 (CN)**

(72) Inventors:
• **FANG, Fei
Beijing 100176 (CN)**

• **WANG, Zhu
Beijing 100176 (CN)**
• **CHEN, Yipeng
Beijing 100176 (CN)**
• **SHI, Ling
Beijing 100176 (CN)**
• **WU, Yu
Beijing 100176 (CN)**
• **LI, Yuxiao
Beijing 100176 (CN)**
• **LI, Lu
Beijing 100176 (CN)**

(74) Representative: **Durán-Corretjer, S.L.P.
Còrsega, 329
(Paseo de Gracia/Diagonal)
08037 Barcelona (ES)**

(54) **DISPLAY SUBSTRATE AND DRIVING METHOD THEREFOR, AND DISPLAY APPARATUS**

(57)    Disclosed are a display substrate and a driving method therefor, and a display apparatus. The display substrate comprises a substrate, and K rows of sub-pixels and a plurality of types of signal lines, which are arranged on the substrate, wherein the signal lines extend in a row direction (X), there are a plurality of signal lines of each type, the plurality of signal lines of the same type are arranged at intervals in a column direction (Y), and each row of sub-pixels is electrically connected to one signal line among the signal lines of the same type; on a plane parallel to the display substrate, the row direction (X) intersects the column direction (Y); and at least some signal lines among at least one type of signal lines are each configured to electrically connect to at least two rows of sub-pixels, and for at least one type of signal lines, the number of signal lines of the same type is a positive integer less than K.

FIG. 4A

Processed by Luminess, 75001 PARIS (FR)

**Description**

Technical Field

The present disclosure relates to, but is not limited to, the field of display technology, and particularly to a display substrate, a driving method thereof and a display apparatus.

Background

An Organic Light Emitting Diode (OLED for short) and a Quantum dot Light Emitting Diode (QLED for short) are active light emitting display devices and have advantages such as self-luminescence, wide viewing angle, high contrast ratio, low power consumption, extremely high response speed, lightness and thinness, flexibility, and low cost.

Summary

The following is a summary of subject matter described herein in detail. This summary is not intended to limit the protection scope of the claims.
In the first aspect, embodiments of the present disclosure provide a display substrate including a base substrate, K rows of sub-pixels, and a plurality of kinds of signal lines extending along a row direction provided on the base substrate; the quantity of signal lines of a same kind is multiple, a plurality of signal lines of a same kind are arranged at intervals along a column direction, and each row of sub-pixels are electrically connected with one of signal lines of a same kind; on a plane parallel to the display substrate, the row direction intersects the column direction; in at least some of signal lines of at least one kind, each signal line is configured to be electrically connected to at least two rows of sub-pixels, in the signal lines of at least one kind, the quantity of signal lines of a same kind is a positive integer less than K.
In an exemplary embodiment, in at least some of the signal lines of at least one kind, each signal line is configured to electrically connected to two rows of sub-pixels adjacent thereto.
In an exemplary embodiment, the signal lines of at least one kind includes a first type of signal lines, the first type of signal lines include at least two adjacent signal lines of a same kind, in the two adjacent signal lines of a same kind, one of the signal lines is configured to be electrically connected to an i-th row of sub-pixels and an (i+1)-th row of sub-pixels, and another signal line is configured to be electrically connected to an (i+2)-th row of sub-pixels and an (i+3)-th row of sub-pixels, wherein i is an integer greater than or equal to 1 and less than K.
In an exemplary embodiment, categories of signal lines in the first type of signal lines include a first reset control line and/or a first initial signal line.
In an exemplary embodiment, the first initial signal line and the first reset control line are located at different conductive layers, and an orthographic projection of the first initial signal line on the base substrate at least partially overlaps an orthographic projection of the first reset control line on the base substrate in a same row of sub-pixels.
In an exemplary embodiment, the signal lines of at least one kind further includes a second type of signal lines, the second type of signal lines include at least two adjacent signal lines of a same kind, in the two adjacent signal lines of a same kind, one of the signal lines is configured to be electrically connected to an (i-1)-th row of sub-pixels and an i-th row of sub-pixels, and another signal line is configured to be electrically connected to an (i+1)-th row of sub-pixels and an (i+2)-th row of sub-pixels, wherein i is greater than 1.
In an exemplary embodiment, categories of signal lines in the second type of signal lines include a second reset control line and/or a second initial signal line.
In an exemplary embodiment, the second reset control line and the second initial signal line are located at different conductive layers, and an orthographic projection of the second reset control line on the base substrate at least partially overlaps an orthographic projection of the second initial signal line on the base substrate in a same row of sub-pixels.
In an exemplary embodiment, categories of signal lines in the second type of signal lines further includes at least one of a third initial signal line, a light emitting control line, and a second scan line.
In an exemplary embodiment, the light emitting control line and the third initial signal line are located at different conductive layers, and an orthographic projection of the light emitting control line on the base substrate at least partially overlaps an orthographic projection of the third initial signal line on the base substrate in a same row of sub-pixels.
In an exemplary embodiment, categories of signal lines in the second type of signal lines further includes a second scan auxiliary line, an orthographic projection of the second scan auxiliary line on the base substrate at least partially overlaps an orthographic projection of the second scan line on the base substrate in a same row of sub-pixels.
In an exemplary embodiment, the K rows of sub-pixels include a plurality of first sub-pixel rows and a plurality of second sub-pixel rows, the first sub-pixel rows and the second sub-pixel rows are alternately arranged along the column direction, in at least some of the signal lines of at least one kind, each signal line is configured to be electrically connected to a first sub-pixel row and a second sub-pixel row adjacent thereto.

In an exemplary embodiment, each row of sub-pixels includes a plurality of sub-pixels sequentially disposed along the row direction, the plurality of sub-pixels form a plurality of pixel units, and at least some of the pixel units include at least three sub-pixels sequentially disposed along the row direction.

The display substrate includes a first display region, the first display region includes a plurality of first sub-regions, a plurality of second sub-regions, a plurality of third sub-regions and a plurality of fourth sub-regions, the first sub-regions and the third sub-regions are alternately arranged along the row direction, the second sub-regions and the fourth sub-regions are alternately arranged along the row direction, a plurality of pixel units in the first sub-pixel row are respectively located in the plurality of first sub-regions, a plurality of pixel units in the second sub-pixel row are respectively located in the plurality of second sub-regions, the plurality of pixel units located in the first sub-pixel row are spaced apart through the third sub-regions, and the plurality of pixel units in the second sub-pixel row are spaced apart through the fourth sub-regions.

In an exemplary embodiment, at least some of sub-pixels include a first pixel circuit, and at least some of pixel units include four sub-pixels arranged sequentially in the row direction; in a same pixel unit, four first pixel circuits are symmetrically arranged with respect to a first midline of the four first pixel circuits extending along the column direction, a first first pixel circuit and a second first pixel circuit of the four first pixel circuits are symmetrically arranged with respect to a second midline of the two first pixel circuits extending along the column direction, and a third first pixel circuit and a fourth first pixel circuit are symmetrically arranged with respect to a third midline of the two first pixel circuits extending along the column direction.

In an exemplary embodiment, the plurality of first sub-regions form a plurality of columns of first sub-regions and the plurality of second sub-regions form a plurality of columns of second sub-regions, and the first sub-regions and the second sub-regions are staggered in the column direction; a third first pixel circuit and a fourth first pixel circuit of four first pixel circuits in a pixel unit of the first sub-region are located in a same column as a first first pixel circuit and a second first pixel circuit of four first pixel circuits in a pixel unit of an adjacent second sub-region, respectively.

In an exemplary embodiment, the pixel unit further includes four light emitting elements, the four light emitting elements are respectively electrically connected with four first pixel circuits in the pixel unit, the light emitting element includes an anode; in a same pixel unit, orthographic projections of the anodes of the four light emitting elements on the base substrate and orthographic projections of the third sub-region and the fourth sub-region on the base substrate at least partially do not overlap ; in the first sub-pixel row, orthographic projections of the anodes of the four light emitting elements on the base substrate at least partially overlap an orthographic projection of the first sub-region on the base substrate; in the second sub-pixel row, orthographic projections of the anodes of the four light emitting elements on the base substrate at least partially overlap the second sub-region.

In an exemplary embodiment, at least some of the first pixel circuits include a first transistor to an eighth transistor; in a first pixel circuit in the first sub-pixel row located in an i-th row, in the column direction, the first transistor, the second transistor, and the fourth transistor are located at a side of the third transistor close to the second sub-pixel row located in an (i+1)-th row , the second transistor is located between the first transistor and the third transistor; the fifth transistor to the eighth transistor are located at a side of the third transistor close to the second sub-pixel row located in an (i-1)-th row, and the sixth transistor is located between the third transistor and the seventh transistor; where i is a positive integer greater than 1 and less than K; in a first pixel circuit in the second sub-pixel row located in an (i+1) row, the first transistor, the second transistor and the fourth transistor are located at a side of the third transistor close to the first sub-pixel row located in the i-th row , the second transistor is located between the first transistor and the third transistor; the fifth transistor to the eighth transistor are located at a side of the third transistor close to the first sub-pixel row located in an (i+2)-th row, and the sixth transistor is located between the third transistor and the seventh transistor.

In an exemplary embodiment, in a direction perpendicular to a plane where the display substrate is located, the display substrate includes: a circuit structure layer located on the base substrate; the circuit structure layer includes the plurality of first pixel circuits; at least some of the plurality of first pixel circuits include at least one of a first type of transistors, at least one of a second type of transistors, and a storage capacitor; the first type of transistors include at least the first transistor, the third transistor to the eighth transistor, and the second type of transistors include at least the second transistor; the circuit structure layer includes a first semiconductor layer, a first conductive layer, a second conductive layer, a second semiconductor layer and a third conductive layer provided on the base substrate; the first semiconductor layer at least includes: active layers of the first type of transistors of the pixel circuit; the first conductive layer at least includes: gates of the first type of transistors and a first electrode of the storage capacitor of the pixel circuit; the second conductive layer at least includes: a second electrode of the storage capacitor of the pixel circuit; the second semiconductor layer at least includes: active layers of the second type of transistors of the pixel circuit; the third conductive layer includes at least gates of the second type of transistors of the pixel circuit.

In an exemplary embodiment, the first type of transistors may be P-type transistors and the second type of transistors may be N-type transistors.

In an exemplary embodiment, the first conductive layer further includes: a first scan line, the light emitting control line, a first reset control line, and a second reset control line electrically connected to the first type of transistors in the first pixel circuit; the first scan line, the light emitting control line, the first reset control line, and the second reset control line extend along the row direction; in the column direction, the first scan line and the first reset control line electrically connected to the first sub-pixel row bypass from a side of the third sub-region, and the light emitting control line electrically connected to the first sub-pixel row bypasses from another side of the third sub-region; the first scan line electrically connected to the second sub-pixel row bypasses a side of the fourth sub-region, and the light emitting control line and the second reset control line electrically connected to the second sub-pixel row bypass another side of the fourth sub-region.

In an exemplary embodiment, the third conductive layer further includes a first initial signal line electrically connected to the first transistor in the first pixel circuit, a second initial signal line electrically connected to the seventh transistor in the first pixel circuit, and a third initial signal line electrically connected to the eighth transistor; the first initial signal line, the second initial signal line, and the third initial signal line extend along the row direction; in a same row of sub-pixels, an orthographic projection of the first initial signal line on the base substrate at least partially overlaps an orthographic projection of the first reset control line on the base substrate, an orthographic projection of the second initial signal line on the base substrate at least partially overlaps an orthographic projection of the second reset control line on the base substrate, and an orthographic projection of the third initial signal line on the base substrate at least partially overlaps an orthographic projection of the light emitting control line on the base substrate.

In an exemplary embodiment, at a location where a first sub-region of the first sub-pixel row located in an i-th row and a second sub-region of the second sub-pixel row located in an (i-1)-th row are adjacent, the second reset control line and the second initial signal line have an annular structure, in the column direction, a side of the annular structure close to the first sub-region overlaps orthographic projections of the seventh transistor and the eighth transistor in a third first pixel circuit to a fourth first pixel circuit in the first sub-region on the base substrate, and a side of the annular structure close to the second sub-region overlaps orthographic projections of the seventh transistor and the eighth transistor in a first first pixel circuit to a second first pixel circuit in the second sub-region on the base substrate; at a location where a first sub-region of the first sub-pixel row located in an i-th row and a second sub-region of the second sub-pixel row located in an (i+1)-th row are adjacent, the first reset control line and the first initial signal line have an annular structure, in the column direction, a side of the annular structure close to the first sub-region overlaps orthographic projections of first transistors in a third first pixel circuit to a fourth first pixel circuit in the first sub-region on the base substrate; a side of the annular structure close to the second sub-region overlaps orthographic projections of first transistors in a first first pixel circuit to a second first pixel circuit in the second sub-region on the base substrate.

In an exemplary embodiment, the second conductive layer further includes a second scan auxiliary line electrically connected to a second transistor in the first pixel circuit; the third conductive layer further includes a second scan line electrically connected with the second transistor in the first pixel circuit; orthographic projections of the second scan auxiliary line and the second scan line in a same row of sub-pixels on the base substrate at least partially overlap; the second scan auxiliary line and the second scan line extend along the row direction; in the column direction, the second scan line and the second scan auxiliary line electrically connected to the first sub-pixel row bypass from a side of the third sub-region, and the second scan line and the second scan auxiliary line electrically connected to the second sub-pixel row bypass from a side of the fourth sub-region; the second scan line and the second scan auxiliary line electrically connected to the first sub-pixel row bypass the third sub-region in a direction opposite to the direction in which the second scan line and second scan auxiliary line electrically connected to the second sub-pixel row bypass the fourth sub-region.

In an exemplary embodiment, the display substrate further includes a fourth conductive layer, the fourth conductive layer includes a fourth transfer electrode; the fourth transfer electrode extends along the column direction; the second conductive layer further includes a plurality of second scan auxiliary lines and a plurality of second scan auxiliary electrodes electrically connected with a second transistor in the first pixel circuit; the third conductive layer further includes a plurality of second scan lines and a plurality of second scan electrodes electrically connected with the second transistor in the first pixel circuit; in a same row of sub-pixels, orthographic projections of the second scan auxiliary lines and the second scan lines on the base substrate at least partially overlap, and orthographic projections of the second scan electrodes and the second scan auxiliary electrodes on the base substrate at least partially overlap; the second scan auxiliary electrodes, the second scan electrodes, the second scan auxiliary lines, and the second scan lines extend along the row direction.

The plurality of second scan auxiliary electrodes and the plurality of second scan electrodes are respectively electrically connected with a plurality of pixel units in the second sub-pixel row, the plurality of second scan auxiliary lines and the plurality of second scan lines are electrically connected with a plurality of first pixel circuits in the first sub-pixel row; the second scan auxiliary lines and the second scan lines located in an i-th row are electrically connected to a plurality of second scan auxiliary electrodes and a plurality of second scan electrodes located in an (i-1)-th row through the fourth transfer electrode, and the second scan auxiliary lines and the second scan lines located in an (i+2)-th row are electrically connected to a plurality of second scan auxiliary electrodes and a plurality of second scan electrodes located in an (i+1)-th row through the fourth transfer electrode; in the column direction, the second scan lines and the second scan auxiliary lines electrically connected to the first sub-pixel row bypass from a side of the fourth sub-region; a plurality of the second scan electrodes and a plurality of the second scan auxiliary electrodes electrically connected to the second sub-pixel row are located in the second sub-region.

In an exemplary embodiment, the display substrate further includes a fourth conductive layer located at a side of the third conductive layer away from the base substrate, the fourth conductive layer includes a plurality of first transfer electrodes and a plurality of second transfer electrodes; the first transfer electrodes and the second transfer electrodes extend along the column direction; the first conductive layer further includes a plurality of light emitting control lines respectively electrically connected to a plurality of the first sub-pixel rows and a plurality of light emitting control electrodes respectively electrically connected to a plurality of the second sub-pixel rows; the light emitting control lines and the light emitting control electrodes extend along the row direction; the third conductive layer further includes a plurality of third initial signal lines respectively electrically connected to a plurality of the first sub-pixel rows and a plurality of third initial signal electrodes respectively electrically connected to a plurality of the second sub-pixel rows; the third initial signal lines and the third initial signal electrodes extend along the row direction.

A light emitting control line located in an i-th row is electrically connected with a plurality of light emitting control electrodes located in an (i-1)-th row through the first transfer electrode, and a light emitting control line located in an (i+2)-th row is electrically connected with a plurality of light emitting control electrodes located in an (i+1)-th row through the first transfer electrode; a third initial signal line located in an i-th row is electrically connected to a plurality of third initial signal electrodes located in an (i-1)-th row through the second transfer electrode, and a third initial signal line located in an (i+2)-th row is electrically connected to a plurality of third initial signal electrodes located in an (i+1)-th row through the second transfer electrode.

The light emitting control electrodes and the third initial signal electrodes are located in the second sub-region, and the light emitting control line and the third initial signal line electrically connected to the first sub-pixel row bypass from a side of the fourth sub-region in the column direction; in a same row of sub-pixels, orthographic projections of the light emitting control line and the third initial signal line on the base substrate at least partially overlap, and orthographic projections of the light emitting control electrodes and the third initial signal electrode on the base substrate at least partially overlap.

In a second aspect, embodiments of the present disclosure further provide a display apparatus including a display substrate of any of the above embodiments and a sensor located on a side of a non-display surface of the display substrate, the display substrate includes a first display region, an orthographic projection of the sensor on the display substrate at least partially overlaps the first display region of the display substrate.

In a third aspect, embodiments of the present disclosure further provide a driving method for a display substrate configured to drive the display substrate of any of the above embodiments, the display substrate includes K rows of sub-pixels and a plurality of kinds of signal lines extending along the row direction, the quantity of signal lines of a same kind is a positive integer less than or equal to K, and each row of sub-pixels are electrically connected with one of signal lines of a same kind; the driving method includes: in at least some of signal lines of at least one kind, each signal line provides an effective signal to at least two rows of sub-pixels.

In an exemplary embodiment, in at least some of the signal lines of at least one kind, each signal line simultaneously provides an effective signal to two rows of sub-pixels adjacent thereto.

In an exemplary embodiment, the signal lines of at least one kind includes a first type of signal lines, the first type of signal lines include at least one of a first reset control line and a first initial signal line; in the first type of signal lines, in two adjacent signal lines of signal lines of a same kind, one of the signal lines is configured to simultaneously provide an effective signal to an i-th row of sub-pixels and an (i+1)-th row of sub-pixels, and another signal line is configured to simultaneously provide an effective signal to an (i+2)-th row of sub-pixels and an (i+3)-th row of sub-pixels, where i is an integer greater than or equal to 1 and less than K.

In an exemplary embodiment, the signal lines of at least one kind include a second type of signal lines, the second type of signal lines include one or more of a second reset control line, a second initial signal line, a third initial signal line, a light emitting control line, and a second scan line; in the second type of signal lines, in two adjacent signal lines of signal lines of a same kind, one of the signal lines is configured to simultaneously provide an effective signal to an (i-1)-th row of sub-pixels and an i-th row of sub-pixels, and another signal line is configured to simultaneously provide an effective signal to an (i+1)-th row of sub-pixels and an (i+2)-th row of sub-pixels, where i is an integer greater than 1 and less than K.

Other aspects of the present disclosure may be comprehended after the drawings and the detailed descriptions are read and understood.

Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of each component in the drawings do not reflect actual scales, but are only intended to schematically illustrate contents of the present disclosure.

FIG. 1 is a schematic diagram of a structure of a display substrate;

FIG. 2 is an equivalent circuit diagram of a pixel circuit;

FIG. 3 is a working timing diagram of the pixel circuit provided in FIG. 2;

FIG. 4A is a schematic diagram of a planar structure of a display substrate according to an exemplary embodiment of the present disclosure;

FIG. 4B is a schematic diagram of a planar structure of a display substrate according to an exemplary embodiment of the present disclosure;

FIG. 4C is a schematic partial enlarged diagram in FIG. 4b;

FIG. 4D is a schematic partial enlarged diagram after an anode layer is formed according to an exemplary embodiment of the present disclosure;

FIG. 5A is a schematic diagram of a planar structure of a display substrate according to an exemplary embodiment of the present disclosure;

FIG. 5B is a schematic diagram of a planar structure of a display substrate according to an exemplary embodiment of the present disclosure;

FIG. 5C is a schematic partial enlarged diagram after a fourth conductive layer is formed in FIG. 5B;

FIG. 6A is a schematic diagram of a planar structure of a display substrate according to an exemplary embodiment of the present disclosure;

FIG. 6B is a schematic diagram of a planar structure of a display substrate according to an exemplary embodiment of the present disclosure;

FIG. 6C is a schematic partial enlarged diagram after a fourth conductive layer is formed in FIG. 6B;

FIG. 7A is a schematic diagram of a display substrate after a first semiconductor layer is formed according to an exemplary embodiment of the present disclosure;

FIG. 7B is a schematic partial enlarged diagram in FIG. 7A;

FIG. 8A is a schematic diagram of a display substrate after a first conductive layer is formed according to an exemplary embodiment of the present disclosure;

FIG. 8B is a schematic diagram of a planar structure of the first conductive layer in FIG. 8A;

FIG. 8C is a schematic partial enlarged diagram in FIG. 8A;

FIG. 9A is a schematic diagram of a display substrate after a second conductive layer is formed according to an exemplary embodiment of the present disclosure;

FIG. 9B is a schematic diagram of a planar structure of the second conductive layer in FIG. 9A;

FIG. 9C is a schematic partial enlarged diagram in FIG. 9A;

FIG. 10A is a schematic diagram of a display substrate after a second semiconductor layer is formed according to an exemplary embodiment of the present disclosure;

FIG. 10B is a schematic diagram of a planar structure of the second conductive layer in FIG. 10A;

FIG. 10C is a schematic partial enlarged diagram in FIG. 10A;

FIG. 11A is a schematic diagram of a display substrate after a third conductive layer is formed according to an exemplary embodiment of the present disclosure;

FIG. 11B is a schematic diagram of a planar structure of the third conductive layer in FIG. 11A;

FIG. 11C is a schematic partial enlarged diagram in FIG. 11A;

FIG. 12A is a schematic diagram of a display substrate after a fifth insulation layer is formed according to an exemplary embodiment of the present disclosure;

FIG. 12B is a schematic partial enlarged diagram in FIG. 12A;

FIG. 13A is a schematic diagram of a display substrate after a fourth conductive layer is formed according to an exemplary embodiment of the present disclosure;

FIG. 13B is a schematic diagram of a planar structure of the fourth conductive layer in FIG. 13A;

FIG. 13C is a schematic partial enlarged diagram in FIG. 13A;

FIG. 13D is a schematic diagram of a display substrate after a fourth conductive layer is formed according to an exemplary embodiment of the present disclosure;

FIG. 13E is a schematic diagram of a planar structure of the fourth conductive layer in FIG. 13D;

FIG. 13F is a schematic partial enlarged diagram in FIG. 13D;

FIG. 14A is a schematic diagram of a display substrate after a seventh insulation layer is formed according to an exemplary embodiment of the present disclosure;

FIG. 14B is a schematic partial enlarged diagram in FIG. 14A;

FIG. 15A is a schematic diagram of a display substrate after a fifth conductive layer is formed according to an exemplary embodiment of the present disclosure;

FIG. 15B is a schematic diagram of a planar structure of the fifth conductive layer in FIG. 15A;

FIG. 15C is a schematic partial enlarged diagram in FIG. 15A;

FIG. 16A is a schematic diagram of a display substrate after an eighth insulation layer is formed according to an exemplary embodiment of the present disclosure;

FIG. 16B is a schematic partial enlarged diagram in FIG. 16A;

FIG. 17A is a schematic diagram of a display substrate after a sixth conductive layer is formed according to an exemplary embodiment of the present disclosure;

FIG. 17B is a schematic diagram of a planar structure of the sixth conductive layer in FIG. 17A;

FIG. 17C is a schematic partial enlarged diagram in FIG. 17A;

FIG. 18A is a schematic diagram of a display substrate after a ninth insulation layer is formed according to an exemplary embodiment of the present disclosure;

FIG. 18B is a schematic partial enlarged diagram in FIG. 18A;

FIG. 19A is a schematic diagram of a display substrate after an anode layer is formed according to an exemplary embodiment of the present disclosure;

FIG. 19B is a schematic diagram of a planar structure of the anode layer in FIG. 19A;

FIG. 19C is a schematic partial enlarged diagram in FIG. 19A;

FIG. 20A is a schematic diagram of a display substrate after a pixel definition layer is formed according to an exemplary embodiment of the present disclosure;

FIG. 20B is a schematic diagram of a planar structure of the pixel definition layer in FIG. 20A;

FIG. 20C is a schematic partial enlarged diagram in FIG. 19A;

FIG. 21A is a schematic diagram of a display substrate after a first conductive layer is formed according to an exemplary embodiment of the present disclosure;

FIG. 21B is a schematic diagram of a planar structure of the first conductive layer in FIG. 21A;

FIG. 21C is a schematic partial enlarged diagram in FIG. 21A;

FIG. 22A is a schematic diagram of a display substrate after a third conductive layer is formed according to an exemplary embodiment of the present disclosure;

FIG. 22B is a schematic diagram of a planar structure of the third conductive layer in FIG. 22A;

FIG. 22C is a schematic partial enlarged diagram in FIG. 22A;

FIG. 23A is a schematic diagram of a display substrate after a fifth insulation layer is formed according to an exemplary embodiment of the present disclosure;

FIG. 23B is a schematic partial enlarged diagram in FIG. 23A;

FIG. 24A is a schematic diagram of a display substrate after a fourth conductive layer is formed according to an exemplary embodiment of the present disclosure;

FIG. 24B is a schematic diagram of a planar structure of the fourth conductive layer in FIG. 24A;

FIG. 24C is a schematic partial enlarged diagram in FIG. 24A;

FIG. 25A is a schematic diagram of a display substrate after a second conductive layer is formed according to an exemplary embodiment of the present disclosure;

FIG. 25B is a schematic diagram of a planar structure of the second conductive layer in FIG. 25A;

FIG. 25C is a schematic partial enlarged diagram in FIG. 25A;

FIG. 26A is a schematic diagram of a display substrate after a third conductive layer is formed according to an exemplary embodiment of the present disclosure;

FIG. 26B is a schematic diagram of a planar structure of the third conductive layer in FIG. 26A;

FIG. 26C is a schematic partial enlarged diagram in FIG. 26A;

FIG. 27A is a schematic diagram of a display substrate after a fifth insulation layer is formed according to an exemplary embodiment of the present disclosure;

FIG. 27B is a schematic partial enlarged diagram in FIG. 27A;

FIG. 28A is a schematic diagram of a display substrate after a fourth conductive layer is formed according to an exemplary embodiment of the present disclosure;

FIG. 28B is a schematic diagram of a planar structure of the fourth conductive layer in FIG. 28A;

FIG. 28C is a schematic partial enlarged diagram in FIG. 28A;

FIG. 29 is a schematic diagram of a display apparatus according to an exemplary embodiment of the present disclosure;

FIG. 30 is a flowchart of a driving method for a display substrate according to an exemplary embodiment of the present disclosure;

FIG. 31 is a timing diagram for driving the operation of a display substrate according to an exemplary embodiment of the present disclosure.

Detailed Description

Embodiments of the present disclosure will be described in detail hereinafter with reference to the drawings. Embodiments may be implemented in multiple different forms. Those of ordinary skills in the art can easily understand such a fact that embodiments and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings in the embodiments of the present disclosure relate only to the structures involved in the embodiments of the present disclosure, and other structures may be described with reference to conventional designs.

Scales of the drawings in the present disclosure may be used as a reference in actual processes, but are not limited thereto. For example, a thickness of each film layer, a pitch of film layers, a width of each signal line and a pitch of signal lines may be adjusted according to an actual situation. The drawings described in the present disclosure are only schematic diagrams of structures, and one implementation of the present disclosure is not limited to shapes or numerical values or the like shown in the drawings.

Ordinal numerals "first", "second", "third", etc., in the specification are set not to form limits in numbers but only to avoid confusion between composition elements.

In the specification, for convenience, expressions "central", "above", "below", "front", "back", "vertical", "horizontal", "top", "bottom", "inside", "outside", etc., indicating orientations or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction which is used for describing each constituent element. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or detachable connection, or integral connection; it may be mechanical connection or electrical connection; it may be direct connection, or indirect connection through an intermediate, or internal communication between two elements. Those of ordinary skills in the art can understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In cases that transistors with opposite polarities are used, or a current direction changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification. In an embodiment of the present disclosure, the gate electrode may be referred to as a control electrode.

In the specification, "electrical connection" includes connection of composition elements through an element with a certain electrical action. An "element with a certain electrical action" is not particularly limited as long as electric signals between the connected composition elements may be sent and received. Examples of the "element with the certain electrical action" not only include an electrode and a line, but also include a switch element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulation film" may be replaced with an "insulation layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In an embodiment of the present disclosure, "about" refers to a value that is not strictly limited, the value within the range of process and measurement error is allowed.

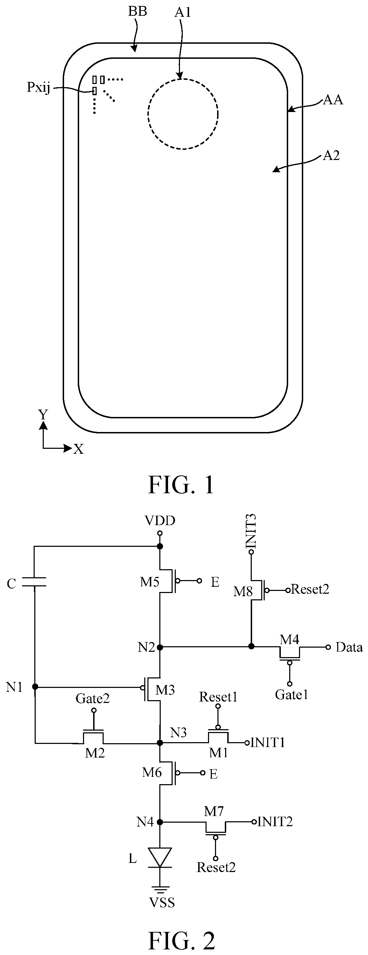

FIG. 1 is a schematic diagram of a planar structure of a display substrate. In some examples, as shown in FIG. 1, the display substrate may include a display region AA and a peripheral region BB located at a periphery of the display region AA. The display region AA of the display substrate may at least include a first display region A1 and a second display region A2. The second display region A2 may at least partially surround the first display region A1. For Example, the second display region A2 may surround the first display region A1. The peripheral region BB may surround the second display region A2. However, the embodiment is not limited thereto.

In some examples, as shown in FIG. 1, the first display region A1 may be a light transmitting display region and may also be referred to as a Full Display with Camera (FDC) region. The second display region A2 may be referred to as a normal display region. For example, an orthographic projection of a sensor (such as a camera and other hardware) on the display substrate may be located within the first display region A1 of the display substrate. In some examples, as shown in FIG. 1, the first display region A1 may be circular, and a size of an orthographic projection of the sensor on the display substrate may be less than or equal to a size of the first display region A1. However, the embodiment is not limited thereto. In some other examples, the first display region A1 may be rectangular, and a size of the orthographic projection of the sensor on the display substrate may be less than or equal to a size of an inscribed circle of the first display region A1.

In some examples, as shown in FIG. 1, the first display region A1 may be located at a middle position of a top of the display region AA. The second display region A2 may surround the first display region A1. However, the embodiment is not limited thereto. For example, the first display region A1 may be located at other positions, such as an upper left corner, a lower left corner, a lower right corner or an upper right corner of the display region AA. For example, the second display region A2 may surround at least one side of the first display region A1.

In some examples, as shown in FIG. 1, the display region AA may be in a shape of a rectangle, e.g., a rounded rectangle. The first display region A1 may be circular or elliptical. However, the embodiment is not limited thereto. For example, the first display region A1 may be rectangular, semicircular, pentagonal, or in another shape.

In some examples, the display region AA may be provided with a plurality of sub-pixels Pxij and i and j may be natural numbers. At least one sub-pixel Pxij may include a pixel circuit and a light emitting element. The pixel circuit may be configured to drive a connected light emitting element. For example, the pixel circuit may be configured to provide a driving current for driving the light emitting element to emit light. The pixel circuit may include multiple transistors and at least one capacitor. For example, the pixel circuit may be a circuit having a 3T1C, 4T1C, 5T1C, 5T2C, 6T1C, 7T1C, or 8T1C structure. Among them, in the above circuit structure, T refers to a thin film transistor, C refers to a capacitor, a number before T represents a quantity of thin film transistors in the circuit, and a number before C represents a quantity of capacitors in the circuit.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel circuit corresponding to the light emitting element. A color of light emitted from the light emitting element may be determined as required. In some examples, the light emitting element may include an anode, a cathode, and an organic emitting layer located between the anode and the cathode. The anode of the light emitting element may be electrically connected with a corresponding pixel circuit. However, the embodiment is not limited thereto.

FIG. 2 is a schematic diagram of a structure of a pixel drive circuit. FIG. 2 is illustrated by taking 8T1C as an example. As shown in FIG. 2, the pixel drive circuit may be connected to 11 signal lines (a data line Data, a first scan line Gate1, a second scan line Gate2, a first reset line Reset1, a second reset line Reset2, a light emitting line E, a first initial signal line INIT1, a second initial signal line INIT2, a third initial signal line INIT3, a first power supply line VDD and a second power supply line VSS). The gate line includes the first scan line Gate1, the second scan line Gate2, the first reset line Reset1, the second reset line Reset2, and the light emitting line E.

In an exemplary embodiment, as shown in FIG. 2, a control electrode of the first transistor M1 is connected to the first reset line Reset1, a first electrode of the first transistor M1 is connected to the first initial signal line INIT1, and a second electrode of the first transistor is connected to the third node N3. A control electrode of the second transistor M2 is connected to the second scan line Gate2, a first electrode of the second transistor M2 is connected to the first node N1, and a second electrode of the second transistor M2 is connected to the third node N3. A control electrode of the third transistor M3 is connected with the first node N1, a first electrode of the third transistor M3 is connected with the second node N2, and a second electrode of the third transistor M3 is connected with a third node N3. A control electrode of the fourth transistor M4 is connected to the first scan line Gate1, a first electrode of the fourth transistor M4 is connected to the data line Data, and a second electrode of the fourth transistor M4 is connected to the second node N2. A control electrode of the fifth transistor M5 is connected to the light emitting line E, a first electrode of the fifth transistor M5 is connected to the first power supply line VDD, and a second electrode of the fifth transistor M5 is connected to the second node N2. A control electrode of the sixth transistor M6 is connected to the light emitting line E, a first electrode of the sixth transistor M6 is connected to the third node N3, and a second electrode of the sixth transistor M6 is connected to the fourth node N4. A control electrode of the seventh transistor M7 is connected to the second reset line Reset2, a first electrode of the seventh transistor M7 is connected to the second initial signal line INIT2, and a second electrode of the seventh transistor M7 is connected to the fourth node N4. A control electrode of the eighth transistor M8 is connected to the second reset line Reset2, a first electrode of the eighth transistor M8 is connected to the third initial signal line INIT3, a second electrode of the eighth transistor M8 is connected to the second node N2, a first end of the capacitor C is connected to the first power supply line VDD, and a second end of the capacitor C is connected to the first node N1.

In an exemplary embodiment, a first electrode of the light emitting device is electrically connected to the fourth node N4, a second electrode of the light emitting device is connected to the second power supply line VSS,

In an exemplary embodiment, a signal of the second power supply line VSS is a low-level signal, and a signal of the first power supply line VDD is a continuously supplied high-level signal.

Transistors may be divided into N-type transistors and P-type transistors according to their characteristics. When a transistor is a P-type transistor, its turn-on voltage is a low-level voltage (e.g., 0V, -5 V, -10 V, or another suitable voltage), and its turn-off voltage is a high-level voltage (e.g., 5 V, 10 V, or another suitable voltage). When a transistor is an N-type transistor, its turn-on voltage is a high-level voltage (e.g., 5 V, 10 V, or another suitable voltage), and its turn-off voltage is a low-level voltage (e.g., 0 V, -5 V, -10 V, or another suitable voltage).

In an exemplary implementation, the first transistor M1 to the eighth transistor M8 may be P-type transistors or N-type transistors. Use of a same type of transistors in a pixel drive circuit may simplify a process flow, reduce a process difficulty of a display panel, and improve a product yield. In some possible implementations, the first transistor M1 to the eighth transistor M8 may include P-type transistors and N-type transistors.

In an exemplary implementation, for the first transistor M1 to the eighth transistors M8, low temperature poly-silicon thin film transistors may be used, oxide thin film transistors may be used, or both of low temperature poly-silicon thin film transistors and oxide thin film transistors may be used. An active layer of a low temperature poly-silicon thin film transistor may be made of Low Temperature Poly-Silicon (LTPS for short), and an active layer of an oxide thin film transistor may be made of an oxide semiconductor (Oxide). The low temperature poly-silicon thin film transistor has advantages such as high migration rate and fast charging. The oxide thin film transistor has advantages such as low drain current. The low temperature poly-silicon thin film transistor and the oxide thin film transistor are integrated on one display substrate to form a Low Temperature Polycrystalline Oxide (LTPO for short) display substrate, so that advantages of the low temperature poly-silicon thin film transistor and the oxide thin film transistor can be utilized, low-frequency drive can be realized, power consumption can be reduced, and display quality can be improved.

In an exemplary embodiment, as shown in FIG. 2, the second transistor M2 may be an N-type transistor, and the first transistor M1, the third transistor M3 to the eighth transistor M8 may be P-type transistors.

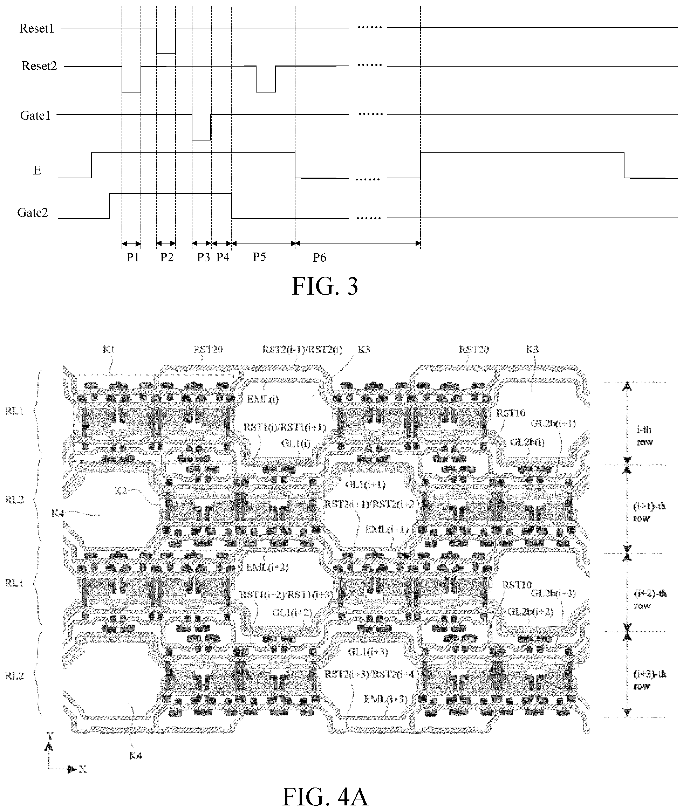

FIG. 3 is a working process of a pixel drive circuit provided in FIG. 2. In an exemplary implementation, the working process of the pixel drive circuit may include following stages.

In a first stage P1, referred to as a first reset stage, a signal of the second reset line Reset2 is a low-level signal, and signals of the first reset line Reset1, the first scan line Gate1, the second scan line Gate2, and the light emitting line E are high-level signals. A signal of the second reset line Reset2 is a low-level signal, so that the seventh transistor M7 and the eighth transistor M8 are turned on, a signal of the second initial signal line INIT2 is provided to the fourth node N4, to initialize (reset) a first electrode of the light emitting device L, and clear a pre-stored voltage inside the first electrode of the light emitting device L. A signal of the third initial signal line INIT3 is provided to the second node N2, to initialize (reset) the second node N2, and clear a pre-stored voltage in the second node N2. In this stage, the third transistor M3 is turned on. A signal of the second scan line Gate2 is a high-level signal, and the second transistor M2 is turned on. A signal of the second node N2 is provided to the first node N1 and the third node N3, the first node N1 and the third node N3 are initialized, signals of the first reset line Reset1, the first scan line Gate1 and the light emitting line E are high-level signals, and the first transistor M1, the fourth transistor M4, the fifth transistor M5 and the sixth transistor M6 are turned off. The light emitting device L does not emit light in this stage.

In a second stage P2, referred to as a second reset stage, a signal of the first reset line Reset1 is a low-level signal, and signals of the second reset line Reset2, the first scan line Gate1, the second scan line Gate2, and the light emitting line E are high-level signals. The signal of the first reset line Reset1 is a low-level signal, so that signal of the first transistor M1 and the first initial signal line INIT1 are provided to the third node N3, to initialize (reset) the third node N3 again, and clear a pre-stored voltage in the third node N3. In this stage, the third transistor M3 is continuously turned on. The signal of the second scan line Gate2 is a high-level signal, and the second transistor M2 is turned on. The third node N3 is provided to the first node N1, to continuously initialize the first node N1, signals of the second reset line Reset2, the first scan line Gate1 and the light emitting line E are high-level signals, and the fourth transistor M4, the fifth transistor M5, the sixth transistor M6, the seventh transistor M7 and the eighth transistor M8 are turned off. The light emitting device L does not emit light in this stage.

In a third stage P3, referred to as a data writing stage or a threshold compensation stage, a signal of the first scan line Gate1 is a low-level signal, and signals of the first reset line Reset1, the second reset line Reset2, the second scan line Gate2 and the light emitting line E are high-level signals. The data line Data outputs a data voltage. In this stage, the third transistor M3 is continuously turned on. The signal of the first scan line Gate1 is a low-level signal, so that the fourth transistor M4 is turned on. A signal of the second scan line Gate2 is a high-level signal, and the second transistor M2 is turned on. The data voltage outputted from the data line Data is provided to the first node N1 through the turned-on fourth transistor M4, the second node N2, the turned-on third transistor M3, the third node N3, and the turned-on second transistor M2, and the difference between the data voltage outputted from the data line Data and the threshold voltage of the third transistor M3 is charged into the capacitor C, the voltage at the second end of the capacitor C (the first node N1) is Vd-|Vth|, Vd is the data voltage outputted from the data line Data, and Vth is the threshold voltage of the third transistor M3. Signals of the first reset line Reset1, the second reset line Reset2 and the light emitting line E are high-level signals, and the first transistor M1, the fifth transistor M5, the sixth transistor M6, the seventh transistor M7 and the eighth transistor M8 are turned off. The light emitting device L does not emit light in this stage.

In a fourth stage P4, referred to as a continuous compensation stage, signals of the first reset line Reset1, the second reset line Reset2, the first scan line Gate1, the second scan line Gate2, and the light emitting line E are high-level signals. A signal of the second scan line Gate2 is a high-level signal, the second transistor M2 is continuously turned on, signals of the first scan line Gate1, the first reset line Reset1, the second reset line Reset2 and the light emitting line E are high-level signals, and the first transistor M1, the fourth transistor M4, the fifth transistor M5, the sixth transistor M6, the seventh transistor M7 and the eighth transistor M8 are turned off. Although the signal of the data line Data is stopped to write, the second node N2 is provided to the first node N1 through the turned-on third transistor M3, the third node N3, and the turned-on second transistor M2, to continuously compensate the threshold voltage of the third transistor M3.

In a fifth stage P5, referred to as a bias stage, signals of the second scan line Gate2 and the second reset line Reset2 are low-level signals, and signals of the first reset line Reset1, the first scan line Gate1 and the light emitting line E are high-level signals. A signal of the second scan line Gate2 is a low-level signal, signals of the first scan line Gate1, the first reset line Reset1 and the light emitting line E are high-level signals, and the first transistor M1, the second transistor M2, the fourth transistor M4, the fifth transistor M5 and the sixth transistor M6 are all turned off. A signal of the second reset line Reset2 is a low-level signal, the seventh transistor M7 and the eighth transistor M8 are turned on, the signal of the third initial signal line INIT3 is written to the second node N2 and the third node N3, and the signal of the second initial signal line INIT2 is written to the fourth node N3. In this stage, the third transistor M3 is in a biased state, and the light emitting device L does not emit light.

In a sixth stage P6, referred to as a light emitting stage, signals of the light emitting line E and the second scan line Gate2 are low-level signals, and signals of the first reset line Reset1, the second reset line Reset2 and the first scan line Gate1 are high-level signals. A signal of the light emitting signal line E is a low-level signal, so that the fifth transistor M5 and the sixth transistor M6 are turned on, and a power supply voltage outputted from the first power supply line VDD provides a driving voltage to a first electrode of the light emitting device L through the fifth transistor M5, the third transistor M3 and the sixth transistor M6 which are turned on, so as to drive the light emitting device L to emit light.

In a drive process of the pixel drive circuit, a drive current flowing through the third transistor M3 (drive transistor) is determined by a voltage difference between the gate electrode and the first electrode of the third transistor T3. Since the voltage of the first node N1 is Vdata-|Vth|, the drive current of the third transistor M3 is as follows.

$$I = K*(Vgs-Vth)^2 = K*[(Vdd-Vd+|Vth|)-Vth]^2 = K*[(Vdd-Vd]^2$$

Herein, I is the drive current flowing through the third transistor T3, i.e., a drive current for driving the light emitting device L, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

It can be seen from the derivation results of the above current formula that in the light emitting stage, the drive current of the third transistor M3 is not affected by the threshold voltage of the third transistor M3, thereby eliminating an influence of the threshold voltage of the third transistor M3 on the drive current, ensuring the uniformity of the display brightness of the display product, and improving the display effect of the whole display product.

With continuous development of display technologies, a camera is usually installed on a display device to meet the needs of shooting or face recognition. In order to maximize a screen-to-body ratio, technologies such as fringe screen, water drop screen and in-screen hole have successively came into being. These technologies reduce the area occupied by a camera by digging a hole locally in a display region and placing the camera under a hole-digging region, thus increasing the screen-to-body ratio. However, the above technologies need to dig out part of the display region, which will cause some regions in a display picture to be unable to be displayed, and make it impossible to further improve the screen-to-body ratio. In order to avoid punching holes in the display region and under a premise of ensuring practicability of the display substrate, it is possible to achieve a true full-screen by adopting a pixel circuit built-out method or a pixel circuit built-in method in the full display with camera (FDC) region.

The pixel circuit built-out method means that the pixel circuits connected with the light emitting elements in the FDC region is provided in the normal display region, and the light transmittance of the FDC region is improved by arranging the light emitting elements and the pixel circuits separately. Because the pixel circuit is not provided in the FDC region, there is no light-shielding layer other than the anodes of the light emitting elements in this region, and a higher light transmittance can be realized. However, in this mode, the pixel circuits and the light emitting elements need to be electrically connected through conductive connection lines, the size (e.g., aperture) of the FDC region of the display substrate using the pixel circuit built-out method is limited due to the limitation of the space for the arrangement of the conductive connection lines. Increasing the aperture of the FDC region usually requires an increased mask process of the conductive connection lines, resulting in increased cost. Moreover, the material of the conductive connection line is usually a transparent conductive material, such as indium tin oxide (ITO). Due to the large square resistance of ITO, the load of the conductive connection line is large, which easily affects the brightness of the light emitting elements in the FDC region and reduces the brightness of the FDC region, which leads to a display defect in the FDC region, such as a vertical display defect (Mura).

The pixel circuit built-in method refers to the provision of light emitting elements and the pixel circuit connected with the light emitting elements in the FDC region. Compared with the pixel circuit built-out method, the built-in method eliminates the need for long conductive connection lines for the electric connection between the pixel circuits and the light emitting elements in the FDC region, which can avoid the display defect of the FDC region caused by the conductive connection lines. Moreover, the built-in method does not limit the size of the FDC region and can support the FDC region with large aperture. However, in the display substrate using the pixel circuit built-in method, it is difficult to avoid the light transmission region due to the large number of pixel circuit signal lines in the FDC region, so the light transmittance of the FDC region will be affected.

Exemplary embodiments of the present disclosure provide a display substrate which may include: a base substrate and K rows of sub-pixels, and a plurality of kinds of signal lines extending along a row direction provided on the base substrate; the quantity of signal lines of a same kind may be multiple, a plurality of signal lines of a same kind may be arranged at intervals along a column direction, and each row of sub-pixels are electrically connected with one of signal lines of a same kind; on a plane parallel to the display substrate, the row direction intersects the column direction.

In at least some of signal lines of at least one kind, each signal line may be configured to be electrically connected to at least two rows of sub-pixels, in the signal lines of at least one kind, the quantity of signal lines of a same kind is a positive integer less than K.

In the display substrate according to an embodiment of the present disclosure, in at least some of signal lines of at least one kind in the display substrate, each signal line is configured to be electrically connected to at least two rows of sub-pixels, in the signal lines of at least one kind, the quantity of signal lines of a same kind is a positive integer less than K, so that the quantity of signal lines is reduced and the light transmittance of the display substrate can be improved.

As shown in FIGS. 4A to 4B, the display substrate according to an embodiment of the present disclosure may include a base substrate and K rows of sub-pixels, and a plurality of kinds of signal lines extending in the row direction X disposed on the base substrate; the quantity of signal lines of a same kind may be multiple, a plurality of signal lines of a same kind are arranged at intervals along a column direction Y, and each row of sub-pixels are electrically connected with one of signal lines of a same kind; on a plane parallel to the display substrate, the row direction X intersects the column direction Y.

In at least some of signal lines of at least one kind, each signal line is configured to be electrically connected to at least two rows of sub-pixels, in the signal lines of at least one kind, the quantity of signal lines of a same kind is a positive integer less than K.

In an exemplary embodiment, the row direction X may be referred to as a first direction and the column direction Y may be referred to as a second direction.

In an exemplary embodiment, each signal line may be configured to be electrically connected to at least one row of sub-pixels.

In an exemplary embodiment, in at least some of signal lines of at least one kind, each signal line may be configured to be electrically connected to two rows of sub-pixels adjacent thereto. The signal line is electrically connected with two adjacent rows of sub-pixels, so that signals can be provided to the adjacent two rows of sub-pixels. On the premise of reducing the quantity of signal lines, the connection lines between the signal lines and the sub-pixel rows can also be reduced, so that the space of the display substrate can be saved and the light transmittance can be improved.

In an exemplary embodiment, the signal lines of at least one kind includes a first type of signal lines, the first type of signal lines include at least two adjacent signal lines of a same kind, in the two adjacent signal lines of a same kind, one of the signal lines may be configured to be electrically connected to an i-th row of sub-pixels and an (i+1)-th row of sub-pixels, and another signal line may be configured to be electrically connected to an (i+2)-th row of sub-pixels and an (i+3)-th row of sub-pixels, wherein i is an integer greater than or equal to 1 and less than K.

In an exemplary embodiment, categories of signal lines in the first type of signal lines may include a first reset control line and/or a first initial signal line.

In an exemplary embodiment, as shown in FIG. 4A, the categories of signal lines in the first type of signal lines may include at least a first reset control line (e.g., first reset control lines RST1(i)/RST1(i+1), RST1(i+2)/RST1(i+3)). A first reset control line may be configured to provide a first reset control signal to two rows of sub-pixels adjacent thereto, i.e., the two adjacent rows of sub-pixels may share a first reset control line, for example, an i-th row of sub-pixels and an (i+1)-th row of sub-pixels may share a first reset control line RST1(i)/RST1(i+1), an (i+2)-th row of sub-pixels and an (i+3)-th row of sub-pixels may share a first reset control line RST1(i+2)/RST1(i+3), in other words, the first reset control line RST1(i)/RST1(i+1) may provide a first reset control signal to the i-th row of sub-pixels and the (i+1)-th row of sub-pixels, and the first reset control line RST1(i+2)/RST1(i+3) may provide a first reset control signal to the (i+2)-th row of sub-pixels and the (i+3)-th row of sub-pixels. In embodiments of the present disclosure, a first reset control signal is provided to two adjacent rows of sub-pixels through one first reset control line, so that the quantity of the first reset control lines can be reduced, thereby reducing the space occupied by the signal lines on the display substrate and improving the light transmittance of the display substrate.

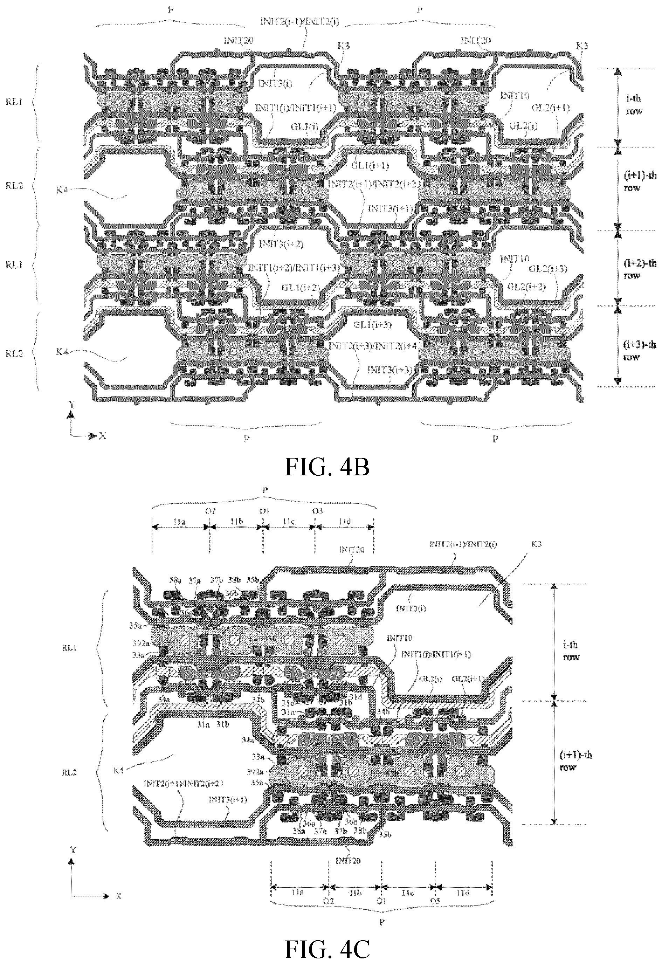

In an exemplary embodiment, the categories of signal lines in the first type of signal lines as shown in FIG. 4B may include first initial signal lines (e.g., first initial signal lines INIT1(i)/INIT1(i+1), INIT1(i+2)/INIT1(i+3)). A first initial signal line may be configured to provide a first initial signal to two rows of sub-pixels adjacent thereto, i.e., the adjacent two rows of sub-pixels may share a first initial signal line, for example, an i-th row of sub-pixels and an (i+1)-th row of sub-pixels may share a first initial signal line INIT1(i)/INIT1(i+1), an (i+2)-th row of sub-pixels and an (i+3)-th row of sub-pixels may share a first initial signal line INIT1(i+2)/INIT1(i+3), in other words, the first initial signal line INIT1(i)/INIT1(i+1) may provide a first initial signal to the i-th row of sub-pixels and the (i+1)-th row of sub-pixels, and the first initial signal line INIT1(i+2)/INIT1(i+3) may provide a first initial signal to the (i+2)-th row of sub-pixels and the (i+3)-th row of sub-pixels. In embodiments of the present disclosure, a first initial signal is provided to two adjacent rows of sub-pixels through one first initial signal line, so that the quantity of the first initial signal lines can be reduced, thereby reducing the space occupied by the signal lines on the display substrate and improving the light transmittance of the display substrate.

In an exemplary embodiment, as shown in FIGS. 4A and 4B, the first initial signal line and the first reset control line may be located in different conductive layers, and in a same row of sub-pixels, an orthographic projection of the first initial signal line on the base substrate and an orthographic projection of the first reset control line on the base substrate at least partially overlap, which may reduce the space occupied by the signal lines on the display substrate and improve the light transmittance of the display substrate. For example, orthographic projections of the first initial signal line INIT1(i)/INIT1(i+1) and the first reset control line RST1(i)/RST1(i+1) on the base substrate at least partially overlap.

In an exemplary embodiment, the signal lines of at least one kind may further include a second type of signal lines, the second type of signal lines may include at least two adjacent signal lines of a same kind, in the two adjacent signal lines of a same kind, one of the signal lines may be configured to be electrically connected to an (i-1)-th row of sub-pixels and an i-th row of sub-pixels, and another signal line may be configured to be electrically connected to an (i+1)-th row of sub-pixels and an (i+2)-th row of sub-pixels, wherein i is greater than 1..

In exemplary embodiments, as shown in FIGS. 4A and 4B, the categories of signal lines in the second type of signal lines may include second reset control lines (e.g., second reset control lines RST2(i-1)/RST2(i), RST2(i+1)/RST2(i+2), RST2(i+3)/RST2(i+4)) and/or second initial signal lines (e.g., second initial signal lines INIT2(i-1)/INIT2(i), INIT2(i+1)/INIT2(i+2), INIT2(i+3)/INIT2(i+4)).

In an exemplary embodiment, a second reset control line may be configured to provide a second reset signal to two rows of sub-pixels adjacent thereto, i.e., the adjacent two rows of sub-pixels may share a second reset control line, for example, an (i-1)-th row of sub-pixels and an i-th row of sub-pixels may share a second reset control line RST2(i-1)/RST2(i) ,an (i+1)-th row of sub-pixels and an (i+2)-th row of sub-pixels may share a second reset control line RST1(i+1)/RST1(i+2), in other words, the second reset control line RST2(i-1)/RST2(i) may provide a second reset control signal to the (i-1)-th row of sub-pixels and the i-th row of sub-pixels, and the second reset control line RST1(i+1)/RST1(i+2) may provide a second reset control line to the (i+1)-th row of sub-pixels and the (i+2)-th row of sub-pixels. In embodiments of the present disclosure, a second reset control signal is provided to two adjacent rows of sub-pixels through a second reset control line, so that the quantity of the second reset control lines can be reduced, thereby reducing the space occupied by the signal lines on the display substrate and improving the light transmittance of the display substrate.

In an exemplary embodiment, a second initial signal line may be configured to provide a second initial signal to two rows of sub-pixels adjacent thereto, i.e., the adjacent two rows of sub-pixels may share a second initial signal line, for example, an (i-1)-th row of sub-pixels and an i-th row of sub-pixels may share a second initial signal line INIT2(1-1)/INIT2(i), an (i+1)-th row of sub-pixels and an (i+2)-th row of sub-pixels may share a second initial signal line INIT2(i+1)/INIT2(i+2), in other words, the second initial signal line INIT2(i-1)/INIT2(i) may provide a second initial signal to the (i-1)-th row of sub-pixels and the i-th row of sub-pixels, and the second initial signal line INIT2(i+1)/INIT2(i+2) may provide a second initial signal to the (i+1)-th row of sub-pixels and the (i+2)-th row of sub-pixels. In embodiments of the present disclosure, a second initial signal is provided to two adjacent rows of sub-pixels through a second initial signal line, so that the quantity of the second initial signal lines can be reduced, thereby reducing the space occupied by the signal lines on the display substrate and improving the light transmittance of the display substrate.

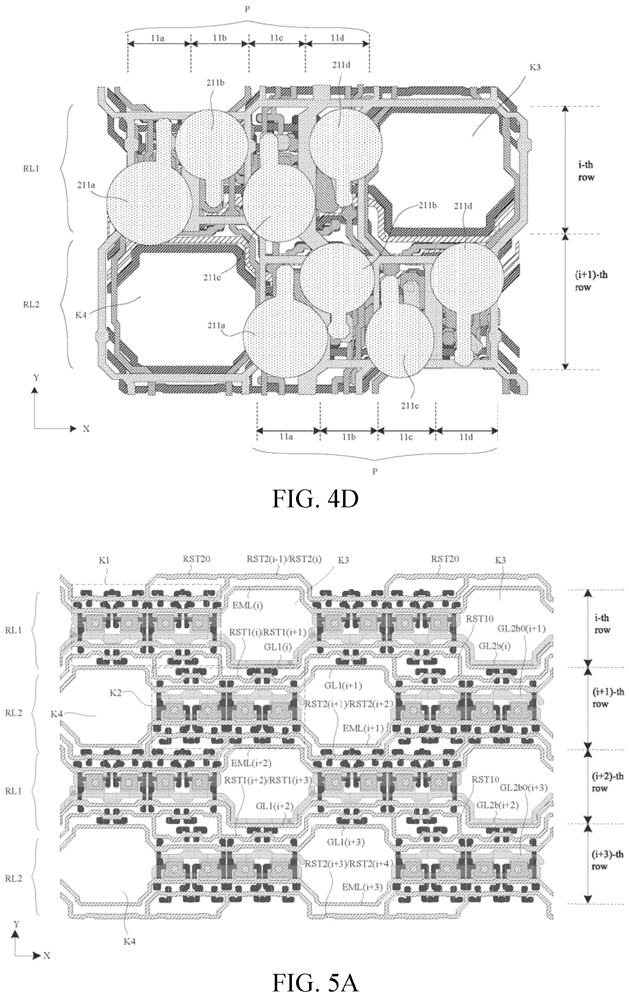

In an exemplary embodiment, the second reset control line and the second initial signal line are located in different conductive layers, and in a same row of sub-pixels, an orthographic projection of the second reset control line on the base substrate and an orthographic projection of the second initial signal line on the base substrate at least partially overlap, so that the space occupied by the signal lines on the display substrate can be reduced and the light transmittance of the display substrate can be improved. For example, orthographic projections of the second initial signal line INIT1(i+1)/INIT1(i+2) and the second reset control line RST1(i+1)/RST1(i+2) on the base substrate at least partially overlap. In an exemplary embodiment, as shown in FIGS. 5A to 5C, the categories of signal lines in the second type of signal lines may include second scan lines (e.g., second scan lines GL2(i), GL2(i+2)). In an exemplary embodiment, a second scan line may be configured to provide a second scan signal to two rows of sub-pixels adjacent thereto, i.e., the adjacent two rows of sub-pixels may share a second scan line, for example, an (i-1)-th row of sub-pixels and an i-th row of sub-pixels may share a second scan line GL2(i), an (i+1)-th row of sub-pixels and an (i+2)-th row of sub-pixels may share a second scan line GL2(i+2), in other words, the second scan line GL2(i) may provide a second scan signal to the (i-1)-th row of sub-pixels and the i-th row of sub-pixels, and the second scan line GL2(i+2) may provide a second scan signal to the (i+1)-th row of sub-pixels and the (i+2)-th row of sub-pixels. In embodiments of the present disclosure, a second scan signal is provided to two adjacent rows of sub-pixels through a second scan line, so that the quantity of the second scan lines can be reduced, thereby reducing the space occupied by the signal lines on the display substrate and improving the light transmittance of the display substrate.

In an exemplary embodiment, as shown in FIGS. 5A to 5C, categories of signal lines in the second type of signal lines may further include a second scan auxiliary line (e.g., the second scan auxiliary line may include GL2b(i), GL2b(i+2)), and in a same row of sub-pixels, orthographic projections of the second scan auxiliary line and the second scan line on the base substrate at least partially overlap, which may reduce the space occupied by the signal lines on the display substrate and improve the light transmittance of the display substrate. For example, orthographic projections of the second scan auxiliary line GL2b(i) and the second scan line GL2(i) on the base substrate may at least partially overlap.

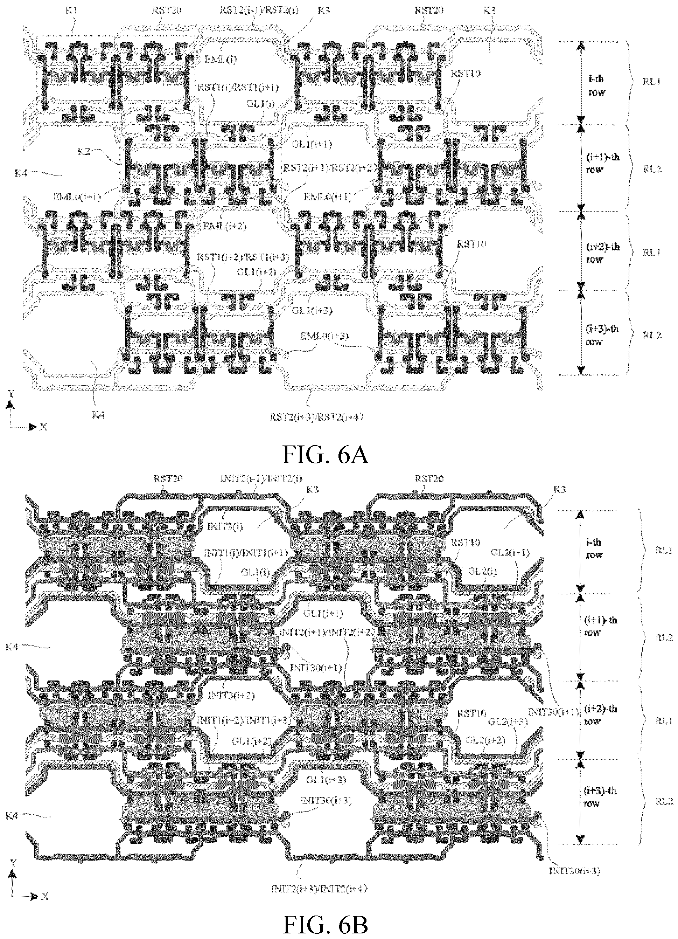

In an exemplary embodiment, as shown in FIGS. 6A to 6C, categories of signal lines in the second type of signal lines may further include at least one of a third initial signal line (e.g., third initial signal lines INIT3(i), INIT3(i+2)), a light emitting control line (e.g., light emitting control lines EML(i), EML(i+2)).

In an exemplary embodiment, a third initial signal line may be configured to provide a third initial signal to two rows of sub-pixels adjacent thereto, i.e., the adjacent two rows of sub-pixels may share a third initial signal line, for example, an (i-1)-th row of sub-pixels and an i-th row of sub-pixels may share a third initial signal line INIT3(i), an (i+1)-th row of sub-pixels and an (i+2)-th row of sub-pixels may share a third initial signal line INIT3(i+2), in other words, the third initial signal line INIT3(i) may provide a third initial signal to the (i-1)-th row of sub-pixels and the i-th row of sub-pixels, and the third initial signal line INIT3(i+2) may provide a third initial signal to the (i+1)-th row of sub-pixels and the (i+2)-th row of sub-pixels. In embodiments of the present disclosure, a third initial signal is provided to two adjacent rows of sub-pixels through a third initial signal line, so that the quantity of the third initial signal lines can be reduced, thereby reducing the space occupied by the signal lines on the display substrate and improving the light transmittance of the display substrate.

In an exemplary embodiment, a light emitting control line may be configured to provide a third initial signal to two rows of sub-pixels adjacent thereto, that is, the two adjacent rows of sub-pixels may share a light emitting control line, for example, an (i-1)-th row of sub-pixels and an i-th row of sub-pixels may share a light emitting control line EML(i), an (i+1)-th row of sub-pixels and an (i+2)-th row of sub-pixels may share a light emitting control line EML(i+2), in other words, the light emitting control line EML(i) may provide a light emitting control signal to the (i-1)-th row of sub-pixels and the i-th row of sub-pixels, and the light emitting control line EML(i+2) may provide a light emitting control signal to the (i+1)-th row of sub-pixels and the (i+2)-th row of sub-pixels. In embodiments of the present disclosure, a light emitting control signal is provided to two adjacent rows of sub-pixels through a light emitting control line, so that the quantity of the light emitting control signal lines can be reduced, thereby reducing the space occupied by the signal lines on the display substrate and improving the light transmittance of the display substrate.

In an exemplary embodiment, as shown in FIGS. 6A to 6C, the light emitting control line and the third initial signal line may be located in different conductive layers, and in a same row of sub-pixels, an orthographic projection of the light emitting control line on the base substrate and an orthographic projection of the third initial signal line on the base substrate at least partially overlap, so that the space occupied by the signal lines on the display substrate can be reduced and the light transmittance of the display substrate can be improved. For example, the orthographic projection of the light emitting control line EML(i) on the base substrate at least partially overlaps the orthographic projection of the third initial signal line INIT3(i) on the base substrate.

In an exemplary embodiment, as shown in FIGS. 4A to 4D, the K rows of sub-pixels may include a plurality of first sub-pixel rows RL1 and a plurality of second sub-pixel rows RL2, the first sub-pixel rows RL1 and the second sub-pixel rows RL2 may be alternately arranged along the column direction Y, in at least some of the signal lines of at least one kind, each signal line is configured to be electrically connected to a first sub-pixel row RL1 and a second sub-pixel row RL2 adjacent thereto.

In an exemplary embodiment, shown in FIGS. 4A to 6C, each row of sub-pixels may include a plurality of sub-pixels sequentially arranged along the row direction X, the plurality of sub-pixels form a plurality of pixel units P, and at least some of the pixel units P may include at least three sub-pixels sequentially arranged along the row direction X.

The display substrate may include a first display region A1(as shown in FIG. 1), the first display region A1 may include a plurality of first sub-regions K1, a plurality of second sub-regions K2, a plurality of third sub-regions K3, and a plurality of fourth sub-regions K4, the first sub-regions K1 and the third sub-regions K3 are alternately arranged along the row direction X, the second sub-regions K2 and the fourth sub-regions K4 are alternately arranged along the row direction X, a plurality of pixel units P in the first sub-pixel row RL1 are respectively located in the plurality of first sub-regions K1, a plurality of pixel units P in the second sub-pixel row RL2 are respectively located in the plurality of second sub-regions K2, the plurality of pixel units P located in the first sub-pixel row RL1 are spaced apart through the third sub-regions K3, the plurality of pixel units P located in the second sub-pixel row RL2 are spaced apart through the fourth sub-regions K4, the third sub-regions K3 and the fourth sub-region s K4 are not provided with pixel units, so that the light transmittance can be improved.

In an exemplary embodiment, as shown in FIG. 4C, which is an schematic enlarged diagram of structures of adjacent first sub-regions K1 to fourth sub-regions in FIG. 4B, at least some of sub-pixels may include a first pixel circuit, and at least some of the pixel units P may include four sub-pixels (e.g., first pixel circuits 11a, 11b, 11c, 11d) arranged sequentially along the row direction X; in a same pixel unit P, four first pixel circuits are symmetrically arranged with respect to a first midline O1 of the four first pixel circuits extending along the column direction Y, a first first pixel circuit 11a and a second first pixel circuit 11b of the four first pixel circuits are symmetrically arranged with respect to a second midline O2 of the two first pixel circuits extending along the column direction Y, and a third first pixel circuit 11c and a fourth first pixel circuit 11d are symmetrically arranged with respect to a third midline O3 of the two first pixel circuits extending in the column direction Y.

In an exemplary embodiment, as shown in FIGS. 4A to 4B, the plurality of first sub-regions K1 form a plurality of columns of first sub-regions K1, and the plurality of second sub-regions K2 form a plurality of columns of second sub-regions K2, the first sub-regions K1 and the second sub-regions K2 are staggered in the column direction Y.

The third first pixel circuit 11c and the fourth first pixel circuit 11d of the four first pixel circuits in the pixel unit P of the first sub-region K1 are located in a same column as the first first pixel circuit 11a and the second first pixel circuit 11b of the four first pixel circuits in the pixel unit of an adjacent second sub-region K2, respectively.

In an exemplary embodiment, as shown in FIG. 4D, the pixel unit P may further include four light emitting elements which are respectively electrically connected to four first pixel circuits (e.g., first pixel circuits 11a, 11b, 11c, 11d) in the pixel unit P, the light emitting elements include anodes (e.g., anodes 211a, 211b, 211c, 211d); in a same pixel unit P, orthographic projections of the anodes (e.g., the anodes 211a, 211b, 211c, 211d) of the four light emitting elements on the base substrate and orthographic projections of the third sub-region K3 and the fourth sub-region K4 on the base substrate at least partially do not overlap , thereby improving the light transmittance of the display substrate; in the first sub-pixel row RL1, the orthographic projections of the anodes of the four light emitting elements on the base substrate at least partially overlap an orthographic projection of the first sub-region K1 on the base substrate; in the second sub-pixel row RL2, the orthographic projections of the anodes of the four light emitting elements on the base substrate at least partially overlaps the second sub-region K2. In an exemplary embodiment, orthographic projections of an anode of any one of the light emitting elements and a first pixel circuit electrically connected to the anode on the base substrate may at least partially overlap.

In an exemplary embodiment, as shown in FIG. 4C, at least some of the first pixel circuits may include a first transistor (e.g., first transistors 31a, 31b) to an eighth transistor (e.g., eighth transistors 38a, 38b).

In a first pixel circuit in the first sub-pixel row RL1 located in an i-th row, in the column direction Y, the first transistor, the second transistor, and the fourth transistor are located at a side of the third transistor close to the second sub-pixel row RL2 located in an (i+1)-th row , the second transistor is located between the first transistor and the third transistor; the fifth transistor to the eighth transistor are located at a side of the third transistor close to the second sub-pixel row RL2 located in an (i-1)-th row, and the sixth transistor is located between the third transistor and the seventh transistor; where i is a positive integer greater than 1 and less than K.

In a first pixel circuit in the second sub-pixel row RL2 located in an (i+1) row, the first transistor, the second transistor and the fourth transistor are located at a side of the third transistor close to the first sub-pixel row RL1 located in the i-th row, the second transistor is located between the first transistor and the third transistor; the fifth transistor to the eighth transistor are located at a side of the third transistor close to the first sub-pixel row RL1 located in an (i+2)-th row, and the sixth transistor is located between the third transistor and the seventh transistor.

In an exemplary embodiment, in a direction perpendicular to a plane where the display substrate is located, the display substrate may include: a circuit structure layer located on the base substrate; the circuit structure layer includes the plurality of first pixel circuits; at least some of the plurality of first pixel circuits may include at least one of a first type of transistors, at least one of a second type of transistors, and a storage capacitor; the first type of transistors include at least the first transistor, the third transistor to the eighth transistor, and the second type of transistors include at least the second transistor.

The circuit structure layer includes a first semiconductor layer, a first conductive layer, a second conductive layer, a second semiconductor layer and a third conductive layer provided on the base substrate; the first semiconductor layer at least includes: active layers of the first type of transistors of the pixel circuit; the first conductive layer at least comprises: gates of the first type of transistors and a first electrode of the storage capacitor of the pixel circuit; the second conductive layer at least comprises: a second electrode of the storage capacitor of the pixel circuit; the second semiconductor layer at least includes: active layers of the second type of transistors of the pixel circuit; the third conductive layer includes at least gates of the second type of transistors of the pixel circuit.

In an exemplary embodiment, the first type of transistors may be P-type transistors and the second type of transistors may be N-type transistors.

In an exemplary embodiment, as shown in FIG. 4A, the first conductive layer may further include a first scan line (e.g., first scan lines GL1(i), GL1(i+1), GL1(i+2), GL1(i+3)), a light emitting control line (e.g., light emitting control lines EML(i), EML(i+1), EML(i+2), EML(i+3)), a first reset control line (e.g., first reset control lines RST1(i)/RST1(i+1), RST1(i+2)/RST1(i+3)), and a second reset control line (e.g., second reset control lines RST2(i-1)/RST2, RST2(i+1)/RST2(i+2), RST2(i+3)/RST2(i+4)) electrically connected to the first type of transistors in the first pixel circuit; the first scan line, the light emitting control line, the first reset control line, and the second reset control line may extend along the row direction X.

In the column direction Y, the first scan line and the first reset control line electrically connected to the first sub-pixel row RL1 bypass from a side of the third sub-region K3, and the light emitting control line electrically connected to the first sub-pixel row RL1 bypasses from another side of the third sub-region K2, so as to avoid shielding the third sub-region and improve the light transmittance of the display substrate; the first scan line electrically connected to the second sub-pixel row RL2 bypasses a side of the fourth sub-region K4, and the light emitting control line and the second reset control line electrically connected to the second sub-pixel row RL2 bypass another side of the fourth sub-region K4, so as to avoid shielding the fourth sub-region K4 and improve the light transmittance of the display substrate.

In an exemplary embodiment, as shown in FIG. 4B, the third conductive layer may further include a first initial signal line (e.g., first initial signal lines INIT1(i)/INIT1(i+1), INIT1(i+2)/INIT1(i+3)) electrically connected to the first transistor in the first pixel circuit, a second initial signal line (e.g., second initial signal lines INIT2(1-1)/INIT2(i), INIT2(i+1)/INIT2(i+2), INIT2(i+3) /INIT2(i+4)) electrically connected to the seventh transistor in the first pixel circuit, and a third initial signal line (e.g., third initial signal lines INIT3(i), INIT3(i+1), INIT3(i+2), INIT3(i+3)) electrically connected to the eighth transistor; the first initial signal line, the second initial signal line, and the third initial signal line may extend along the row direction X.

In a same row of sub-pixels, an orthographic projection of the first initial signal line on the base substrate at least partially overlaps an orthographic projection of the first reset control line on the base substrate, an orthographic projection of the second initial signal line on the base substrate at least partially overlaps an orthographic projection of the second reset control line on the base substrate, and an orthographic projection of the third initial signal line on the base substrate at least partially overlaps an orthographic projection of the light emitting control line on the base substrate, so that the space occupied by the signal lines on the display substrate can be reduced and the light transmittance of the display substrate can be improved.

In an exemplary embodiment, as shown in FIGS. 4A and 4B, at a location where the first sub-region K1 of the first sub-pixel row RL1 located in an i-th row and the second sub-region K2 of the second sub-pixel row RL2 located in an (i-1)-th row are adjacent, the second reset control line and the second initial signal line may be of an annular structure (e.g., an annular structure RST20 in the second reset control line, an annular structure INIT20 in the second initial signal line), in the column direction Y, an orthographic projection of a side of the annular structure (e.g., the annular structure RST20, the annular structure INIT20) close to the first sub-region K1 overlaps orthographic projections of the seventh transistor and the eighth transistor in a third first pixel circuit to a fourth first pixel circuit (e.g., 11c, 11d) of the first sub-region K1 on the base substrate, and an orthographic projection of a side of the annular structure (e.g., the annular structure RST20, the annular structure INIT20) close to the second sub-region K2 overlaps orthographic projections of the seventh transistor and the eighth transistor in a first first pixel circuit to a second first pixel circuit (e.g., the first pixel circuits 11a, 11b) in the second sub-region K2 on the base substrate.

At a location where the first sub-region K1 of the first sub-pixel row RL1 located in an i-th row and the second sub-region K2 of the second sub-pixel row RL2 located in an (i+1)-th row are adjacent, the first reset control line and the first initial signal line may be of an annular structure (e.g., an annular structure RST10 in the first reset control line, an annular structure INIT10 in the first initial signal line). In the column direction Y, an orthographic projection of a side of the annular structure (e.g., the annular structure RST10, the annular structure INIT10) close to the first sub-region K1 overlaps orthographic projections of first transistors (31a, 31b) in a third first pixel circuit to a fourth first pixel circuit (e.g., first pixel circuits 11c, 11d) in the first sub-region K1 on the base substrate, and an orthographic projection of a side of the annular structure (e.g., the annular structure RST10, the annular structure INIT10) close to the second sub-region K2 overlaps orthographic projections of first transistors (31a, 31b) in a first first pixel circuit to a second first pixel circuit (e.g., first pixel circuits 11a, 11b) in the second sub-region K2 on the base substrate.

In an exemplary embodiment, as shown in FIGS. 4A and 4B, the second conductive layer may further include a second scan auxiliary line (e.g., second scan auxiliary lines GL2b(i), GL2b(i+1), GL2b(i+2), GL2b(i+3)) electrically connected to a second transistor in the first pixel circuit; the third conductive layer may further include a second scan line (e.g., second scan lines GL2(i), GL2(i+1), GL2(i+2), GL2(i+3)) electrically connected to the second transistor in the first pixel circuit; orthographic projections of the second scan auxiliary line and the second scan line in a same row of sub-pixels on the base substrate at least partially overlap; the second scan auxiliary line and the second scan line extend along the row direction X;

In the column direction Y, the second scan line and the second scan auxiliary line electrically connected to the first sub-pixel row RL1 bypass from a side of the third sub-region K3, and the second scan line and the second scan auxiliary line electrically connected to the second sub-pixel row RL2 bypass from a side of the fourth sub-region K4, thereby avoiding shielding the third sub-region K3 and the fourth sub-region K4 and improving the light transmittance of the display substrate; the second scan line and the second scan auxiliary line electrically connected to the first sub-pixel row RL1 bypass the third sub-region K3 in a direction opposite to the direction in which the second scan line and the second scan auxiliary line electrically connected to the second sub-pixel row RL2 bypass the fourth sub-region K4.

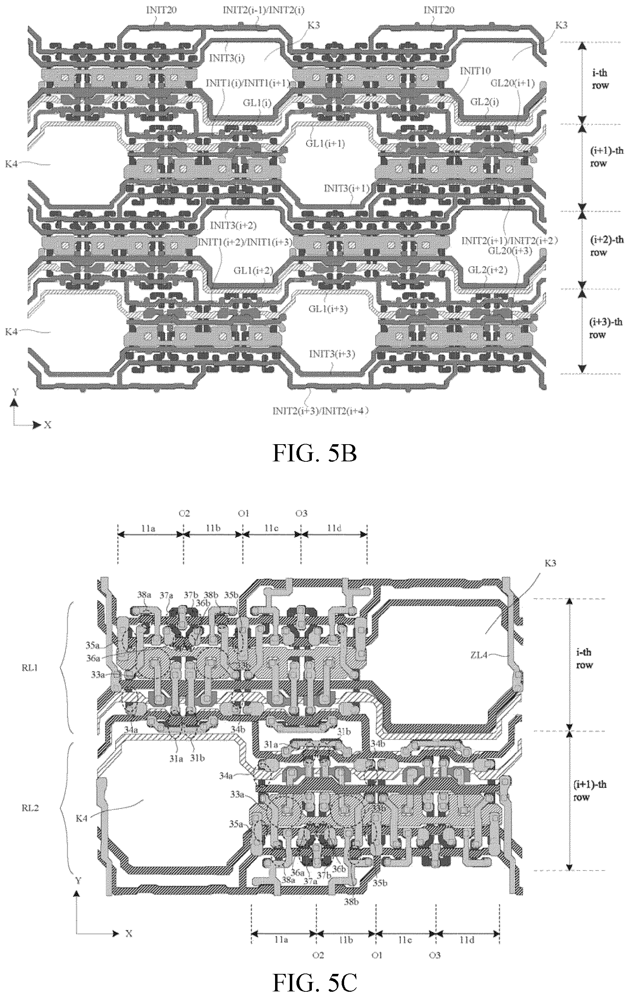

In an exemplary embodiment, as shown in FIGS. 5A to 5C, FIG. 5A is a schematic planar structure diagram after a second conductive layer is formed, FIG. 5B is a schematic planar structure diagram after a third conductive layer is formed, and FIG. 5C is an enlarged structure schematic diagram after a fourth conductive layer is formed in the first sub-region K1 to the fourth sub-region K4 in FIG. 5B, and the display substrate may further include the fourth conductive layer, and the fourth conductive layer includes a fourth transfer electrode ZL4; the fourth transfer electrode extends along the column direction Y.

The second conductive layer may further include a plurality of second scan auxiliary lines (e.g., second scan auxiliary lines GL2b(i), GL2b(i+2)) and a plurality of second scan auxiliary electrodes (e.g., second scan auxiliary electrodes GL2b0 (i+1), GL2b0 (i+3)) electrically connected to the second transistor in the first pixel circuit; the third conductive layer may further include a plurality of second scan lines (e.g., second scan lines GL2(i), GL2(i+2)) and a plurality of second scan electrodes (e.g., second scan electrodes GL20 (i+1), GL20 (i+3)) electrically connected to the second transistor in the first pixel circuit; in a same row of sub-pixels, orthographic projections of the second scan auxiliary line and the second scan line on the base substrate at least partially overlap, and orthographic projections of the second scan electrode and the second scan auxiliary electrode on the base substrate at least partially overlap; the second scan auxiliary electrode, the second scan electrode, the second scan auxiliary line, and the second scan line extend along the row direction X.

The plurality of second scan auxiliary electrodes and the plurality of second scan electrodes are electrically connected with a plurality of pixel units P in the second sub-pixel row RL2, respectively, and the plurality of second scan auxiliary lines and the plurality of second scan lines are electrically connected to a plurality of first pixel circuits in the first sub-pixel row RL1; the second scan auxiliary line and the second scan line located in an i-th row are electrically connected to a plurality of second scan auxiliary electrodes and a plurality of second scan electrodes located in an (i-1)-th row through the fourth transfer electrode ZL4, and the second scan auxiliary line and the second scan line located in an (i+2)-th row are electrically connected to a plurality of second scan auxiliary electrodes and a plurality of second scan electrodes located in an (i+1)-th row through the fourth transfer electrode; so that the second scan auxiliary line GL2b(i) and the second scan line GL2(i) located in the i-th row can provide signals to an i-th row of sub-pixels and an (i+1)-th row of sub-pixels, and the second scan auxiliary line GL2(i+2) and the second scan line GL2(i+2) located in an (i+2)-th row can provide signals to an (i+2)-th row of sub-pixels and an (i+3)-th row of sub-pixels, thereby reducing the space occupied by the signal lines on the display substrate and improving the light transmittance of the display substrate;

In the column direction Y, the second scan line and the second scan auxiliary line electrically connected to the first sub-pixel row RL1 bypass from a side of the fourth sub-region K4; a plurality of second scan electrodes and a plurality of second scan auxiliary electrodes electrically connected to the second sub-pixel row RL2 are respectively located in a plurality of second sub-regions K2.

In an exemplary embodiment, in the schemes of FIGS. 5A to 5C, the quantity of signal lines can be reduced, the space of the display substrate can be saved, and the light transmittance of the display substrate can be improved (the light transmittance of the third sub-region and the fourth sub-region can be improved) by providing signals to two rows of the first pixel circuits by a second scan auxiliary line and providing scan signals to two rows of the first pixel circuits by a second scan line.

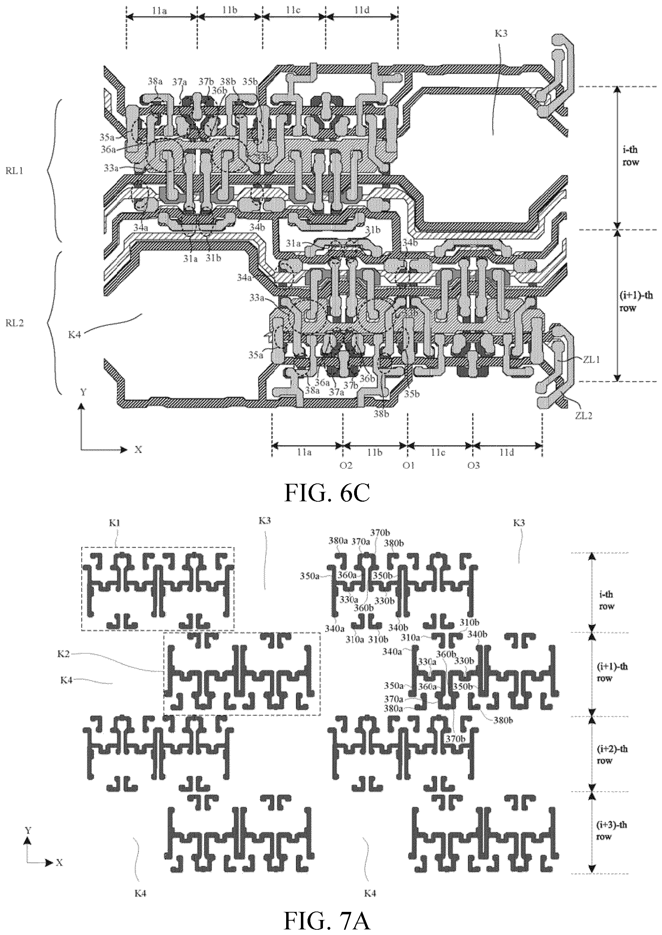

In an exemplary embodiment, as shown in FIGS. 6A to 6B, FIG. 6A is a schematic planar structure diagram after a second conductive layer is formed, FIG. 6B is a schematic planar structure diagram after a third conductive layer is formed, and FIG. 6C is an enlarged structure schematic diagram after a fourth conductive layer is formed in the first sub-region K1 to the fourth sub-region K4 in FIG. 6B, the display substrate may further include a fourth conductive layer located at a side of the third conductive layer away from the base substrate, and the fourth conductive layer includes a plurality of first transfer electrodes ZL1 and a plurality of second transfer electrodes ZL2; the first transfer electrodes ZL1 and the second transfer electrodes ZL2 extend along the column direction Y.

The first conductive layer may further include a plurality of light emitting control lines (e.g., light emitting control lines EML(i), EML(i+2)) electrically connected to the plurality of first sub-pixel rows RL1, respectively, and a plurality of light emitting control electrodes (e.g., light emitting control electrodes EMLO (i+1), EMLO (i+3)) electrically connected to the plurality of second sub-pixel rows RL2, respectively; the light emitting control lines and the light emitting control electrodes extend along the row direction X; the third conductive layer may further include a plurality of third initial signal lines (e.g.,

third initial signal lines INIT3(i), INIT3(i+2)) electrically connected to the plurality of first sub-pixel rows RL1, respectively, and a plurality of third initial signal electrodes (e.g., third initial signal electrodes INIT30 (i+1), INIT30 (i+3)) electrically connected to the plurality of second sub-pixel rows RL2, respectively; the third initial signal lines and the third initial signal electrodes extend along the row direction X.

The light emitting control line EML(i) located in an i-th row is electrically connected to the plurality of light emitting control electrodes EMLO (i-1) located in an (i-1)-th row through the first transfer electrodes ZL1, and the light emitting control line EML(i+2) located in an (i+2)-th row is electrically connected to the plurality of light emitting control electrodes EMLO (i+1) located in an (i+1)-th row through the first transfer electrodes ZL1, so that the light emitting control line EML(i) located in an i-th row can provide light emitting control signals to an i-th row of sub-pixels and an (i+1)-th row of sub-pixels, and the light emitting control line EML(i+2) located in an (i+2)-th row can provide light emitting control signals to an (i+1)-th row of sub-pixels and an (i+2)-th row of sub-pixels; the third initial signal line INIT3(i) located in an i-th row is electrically connected to the plurality of third initial signal electrodes INIT30 (i-1) located in an (i-1)-th row through the second transfer electrodes XL2, and the third initial signal line INIT3(i+2) located in an (i+2)-th row is electrically connected to the plurality of third initial signal electrodes INIT30 (i+1) located in an (i+1)-th row through the second transfer electrodes ZL2, so that the third initial signal line INIT3(i) located in an i-th row can provide a third initial signal to an i-th row of sub-pixels and an (i-1)-th row of sub-pixels, and the third initial signal line INIT3(i+2) located in an (i+2)-th row can provide a third initial signal to an (i+1)-th row of sub-pixels and an (i+2)-th row of sub-pixels.

The light emitting control electrode and the third initial signal electrode may be located in the second sub-region K2, and in the column direction Y, the light emitting control line and the third initial signal line electrically connected with the first sub-pixel row RL1 bypass from a side of the fourth sub-region K4, thereby avoiding shielding the fourth sub-region K4 and improving the light transmittance of the fourth sub-region K4; in a same row of sub-pixels, orthographic projections of the light emitting control line and the third initial signal line on the base substrate at least partially overlap, orthographic projections of the light emitting control electrode and the third initial signal electrode on the base substrate at least partially overlap, so that the space occupied by the signal lines on the display substrate can be reduced and the light transmittance of the display substrate can be improved.

In an exemplary embodiment, in the schemes of FIGS. 6A to 6C, a third initial signal line provides an initial signal to two rows of first pixel circuits, and a light emitting control signal is provided to two rows of first pixel circuits by a light emitting control line, so that the quantity of signal lines can be reduced, space of the display substrate can be saved, and the light transmittance of the display substrate can be improved (the light transmittance of the third sub-region and the fourth sub-region can be improved).

In the scheme according to an embodiment of the present disclosure, in at least some of signal lines of at least one kind, each signal line is configured to be electrically connected to at least two rows of sub-pixels, in the signal lines of at least one kind, the quantity of signal lines of a same kind is less than the quantity of rows of sub-pixels, signals are provided to at least two rows of sub-pixels by one signal, the quantity of signal lines is reduced, and the third sub-region and the fourth sub-region are formed, so that the aperture ratio of the display substrate can be improved by 2% to 6%, and the transmittance (or light transmittance) can be improved by 1% to 4%.

In an exemplary embodiment, the third sub-region K3 and the fourth sub-region K4 may be provided with a sensor (e.g., a camera or a fingerprint sensor), which may prevent the first sub-pixel circuit and the anode from blocking light and improve light transmittance.

In an exemplary embodiment, as shown in FIG. 1, the display substrate may include a first display region A1 and a second display region A2, the second display region A2 may be located at least one side of the first display region A1, for example, the second display region A2 is disposed around the first display region A1. In an exemplary embodiment, the second display region A2 is provided with a second pixel circuit, and the second pixel circuit may be arranged in a manner consistent with or inconsistent with the first pixel circuit, which is not limited here in the present disclosure. In an exemplary embodiment, the first display region A1 and the second display region A2 may be provided with a plurality of pixel units, the pixel units of the second display region A2 may be arranged in a manner consistent with or inconsistent with the pixel units in the first display region A1, and the aperture ratio of the second display region A2 may be improved in a case where the arrangement mode of the second pixel circuit and the pixel units in the second display region A2 are arranged in a manner consistent with that in the first display region A1.

A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a material on a substrate (or base substrate) using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary implementation of the present disclosure, "an orthographic projection of B being within a range of an orthographic projection of A" or "an orthographic projection of A containing an orthographic projection of B"means that a boundary of the orthographic projection of B falls within a range of a boundary of the orthographic projection of A, or the boundary of the orthographic projection of A is overlapped with the boundary of the orthographic projection of B. Exemplary description is made below through a preparation process of a display substrate.

In some examples, the preparing process of the display substrate may include the following operations. The circuit structure layer of the first display region is described below. This example is explained a case in which the first pixel circuit is of the aforementioned 8T1C structure as an example. Herein, the first first pixel circuit (i.e., the first pixel circuit 11a) may include a first transistor 31a, a second transistor 32a, a third transistor 33a, a fourth transistor 34a, a fifth transistor 35a, a sixth transistor 36a, a seventh transistor 37a, an eighth transistor 38a and a storage capacitor; the second first pixel circuit (i.e., the first pixel circuit 11b) may include a first transistor 31b, a second transistor 32b, a third transistor 33b, a fourth transistor 34b, a fifth transistor 35b, a sixth transistor 36b, a seventh transistor 37b, an eighth transistor 38b and a storage capacitor. A connection relationship between the eight transistors and the storage capacitor in each first pixel circuit may be referred to the equivalent circuit diagram shown in FIG. 2.

(101) A base substrate is provided. In some examples, the base may be a rigid base or a flexible base. For example, the rigid base substrate may be made of, but not limited to, one or more of glass and quartz. The flexible base substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible base may include a first flexible material layer, a first inorganic material layer, a second flexible material layer and a second inorganic material layer which are stacked. The first flexible material layer and the second flexible material layer may be made of a material such as polyimide (PI), polyethylene terephthalate (PET), or a polymer soft film on which surface treatment is performed, and a material of the first inorganic material layer and the second inorganic material layer may be silicon nitride (SiNx, x>0) or silicon oxide (SiOy, y>0), etc., which are used to improve resistance to water and oxygen of the base.

(102) A first semiconductor layer is formed. In some examples, a first semiconductor thin film is deposited on the base substrate, and the first semiconductor thin film is patterned through a patterning process to form the first semiconductor layer disposed on the base substrate. In some examples, a material of the first semiconductor layer may be amorphous silicon (a-Si), polycrystalline silicon (p-Si), hexathiophene or polythiophene, or other materials.

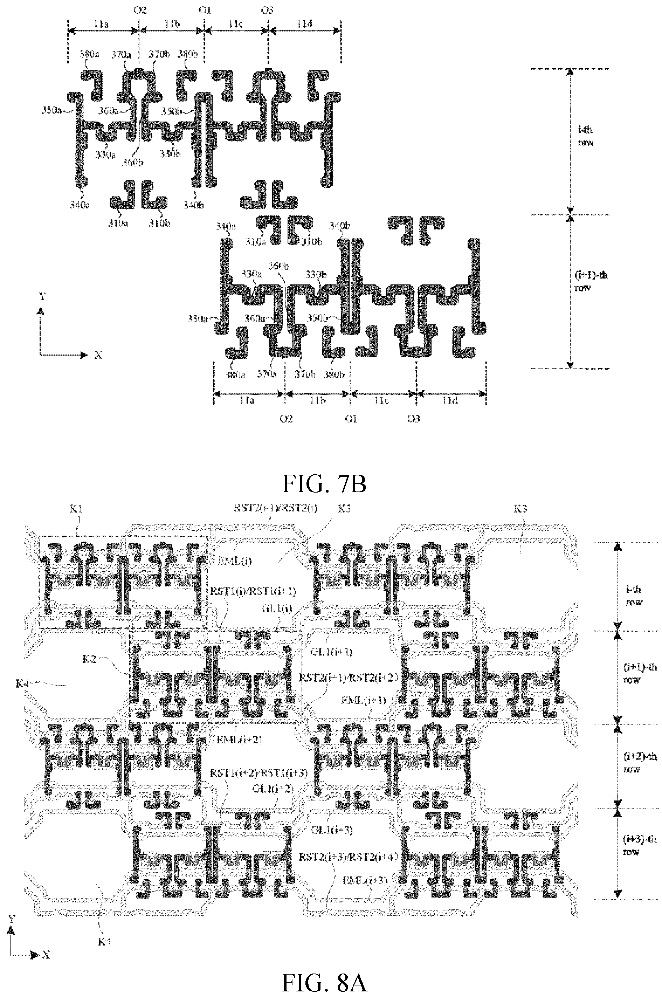

FIG. 7A is a schematic diagram of the first display region after a first semiconductor layer is formed. FIG. 7B is a schematic partial enlarged diagram in FIG. 7A.

In some examples, as shown in FIGS. 7A and 7B, the first semiconductor layer of the first display region may include at least active layers of a plurality of transistors of the first type of a plurality of first pixel circuits (e.g., a first active layer 310a of the first transistor, a third active layer 330a of the third transistor, a fourth active layer 340a of the fourth transistor, a fifth active layer 350a of the fifth transistor, a sixth active layer 360a of the sixth transistor, a seventh active layer 370a of the seventh transistor, and an eighth active layer 380a of the eighth transistor of the first pixel circuit 11a, a first active layer 310b of the first transistor, a third active layer 330b of the third transistor, a fourth active layer 340b of the fourth transistor, a fifth active layer 350b of the fifth transistor, a sixth active layer 360b of the sixth transistor, a seventh active layer 370b of the seventh transistor, and an eighth active layer 380b of the eighth transistor of the first pixel circuit 11b in the first sub-region and the second sub-region).

In some examples, within the first sub-region and the second sub-region, patterns of the first semiconductor layer of the four first pixel circuits may be substantially symmetrical with respect to the first midline O1, patterns of the first semiconductor layer of the first pixel circuit 11a and the first pixel circuit 11b may be substantially symmetrical with respect to the second midline O2, and patterns of the first semiconductor layer of the first pixel circuit 11c and the first pixel circuit 11d may be substantially symmetrical with respect to the third midline O3. Patterns of the first semiconductor layer in different first sub-regions may be independent of each other, and patterns of the first semiconductor layer in different second sub-regions may be independent of each other. In the first sub-region and the second sub-region, the first midline O1 may be a midline of the four first pixel circuits extending along the second direction, the second midline O2 may be a midline of the first pixel circuit 11a and the first pixel circuit 11b extending along the second direction, and the third midline O3 may be a midline of the first pixel circuit 11c and the first pixel circuit 11d extending along the second direction.

In some examples, within the first sub-region and the second sub-region, the first active layer, the third active layer, the fourth active layer, the fifth active layer, the sixth active layer, and the seventh active layer of the four first pixel circuits may be of an interconnected integral structure. The seventh active layer 370a of the first pixel circuit 11a and the seventh active layer 370b of the first pixel circuit 11b may be connected to each other. The fifth active layer 350b of the first pixel circuit 11b and the fifth active layer of the first pixel circuit 11c may be connected to each other. The seventh active layer of the first pixel circuit 11c and the seventh active layer of the first pixel circuit 11d may be connected to each other. Within the first sub-region, in each first pixel circuit, the first active layer and the fourth active layer may be located at a side of the third active layer in an opposite direction of the second direction Y, and the fifth active layer and the seventh active layer, and the eighth active layer may be located at a side of the third active layer along the second direction Y; Within the second sub-region, in each first pixel circuit, the first active layer and the fourth active layer may be located at a side of the third active layer along the second direction Y, and the fifth active layer, the seventh active layer, and the eighth active layer may be located at a side of the third active layer in an opposite direction of the second direction Y. One end of the sixth active layer of each first pixel circuit is connected to the third active layer, and another end is connected to the seventh active layer. In some examples, the third active layer 330a and the third active layer 330b may be substantially u-shaped (or in a shape of an inverted Chinese character "⊓" or an inverted "Ω"), the fourth active layer 340a and the fourth active layer 340b, the fifth active layer 350a and the fifth active layer 350b may be substantially I-shaped, the first active layer 310a and the first active layer 310b, the sixth active layer 360a and the sixth active layer 360b, the seventh active layer 370a and the seventh active layer 370b, and the eighth active layer 380a and the eighth active layer 380b may be substantially L-shaped. However, the embodiment is not limited thereto.

In some examples, an active layer of each transistor may include: a first region, a second region, and a channel region located between the first region and the second region. The material of the first semiconductor layer may include, for example, polysilicon. The channel region may not be doped with an impurity, and has characteristics of a semiconductor. The first region and the second region may be doped regions at two sides of the channel region and are doped with impurities and are therefore electrically conductive. The impurities may be changed according to a type of a transistor. In some examples, a doped region of the active layer may be interpreted as a source or a drain of a transistor. A part of the active layer between the transistors may be interpreted as a wiring doped with an impurity, and may be used for electrically connecting the transistors. This embodiment is not limited thereto.

(103) Forming a first conductive layer. In some examples, a first insulation thin film and a first conductive thin film are deposited sequentially on the base substrate on which the aforementioned structures are formed, and the first conductive thin film is patterned through a patterning process to form a first insulation layer and a first conductive layer disposed on the first insulation layer. In some examples, the first conductive layer may also be referred to as a first gate metal layer.

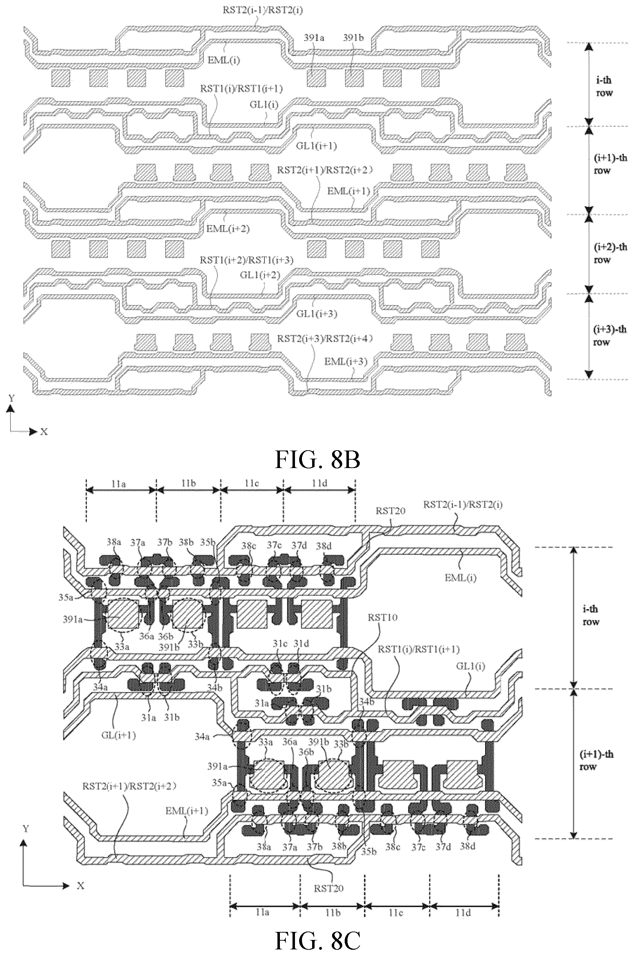

FIG. 8A is a schematic diagram of the first display region after the first conductive layer is formed. FIG. 8B is a schematic diagram of the first conductive layer in FIG. 8A. FIG. 8C is a schematic partial enlarged diagram in FIG. 8A.

In some examples, as shown in FIGS. 8A to 8C, the first conductive layer of the first display region may include at least a plurality of first scan lines (e.g., first scan lines GL1(i), GL1(i+1), GL1(i+2), GL1(i+3)), a plurality of light emitting control lines (e.g., light emitting control lines EML(i), EML(i+1), EML(i+2), EML(i+3)), a plurality of first reset control lines (e.g., first reset control lines RST1(i), RST1(i+1), RST1(i+2), RST1(i+3)), and a plurality of second reset control lines (e.g., second reset control lines RST2(i-1), RST2(i), RST2(i+1), RST2(i+2), RST2(i+3) , RST2(i+4)), first electrodes (e.g., first electrodes 391a, 391b) of storage capacitors of a plurality of first pixel circuits. In an exemplary embodiment, the first electrode of the storage capacitor may be understood as the first plate of the storage capacitor.

In some examples, within the first sub-region, the first scan line GL1(i) may be located at a side of the first electrode (e.g., 391a and 391b) of the storage capacitor of the first pixel circuit in an opposite direction of the second direction Y, and the first reset control line RST1(i) may be located at a side of the first scan line GL1(i) in an opposite direction of the second direction Y; the light emitting control line EML(i) may be located at a side of the first electrode (e.g., 391a and 391b) of the storage capacitor of the first pixel circuit in the second direction Y, and the second reset control line RST2(i) may be located at a side of the light emitting control line EML(i) in the second direction Y. In the second sub-region, the first scan line GL1(i+1) may be located at a side of the first electrode (e.g., 391a and 391b) of the storage capacitor of the first pixel circuit in the second direction Y, and the first reset control line RST1(i+1) may be located at a side of the first scan line GL1(i) in an opposite direction of the second direction Y and at a side of the first scan line GL1(i+1) in the second direction Y, that is, in the second direction Y, the first reset control line RST1(i+1) may be located between the first scan line GL1(i) and the first scan line GL1(i+1); the light emitting control line EML(i+1) may be located at a side of the first electrode (e.g., 391a and 391b) of the storage capacitor of the first pixel circuit in an opposite direction of the second direction Y, and the second reset control line RST2(i+1) may be located at a side of the light emitting control line EML(i+1) in an opposite direction of the second direction Y.

In some examples, the first reset control line RST1(i) of the first pixel circuit in an i-th row and the first reset control line RST1(i+1) of the first pixel circuit in an (i+1)-th row may be the same one, and the second reset control line RST2(i+1) of the pixel circuit in an (i+1)-th row and the second reset control line RST2(i+1) in an (i+2)-th row may be the same one, where i may be a positive integer greater than 1.

In some examples, the first reset control line RST1(i)/RST1(i+1), the first scan line GL1(i), and the light emitting control line EML(i) may bypass a third sub-region adjacent to the first sub-region in which they are located in the first direction X by being bent. For example, the first reset control line RST1(i)/RST1(i+1) and the first scan line GL1(i) may bypass from a side of the third sub-region in an opposite direction of the second direction Y, and the light emitting control line EML(i) may bypass from a side of the second sub-region in the second direction Y. In this example, the lines of the first conductive layer are configured to be bent to bypass the third sub-region, which is beneficial to improve the light transmittance of the third sub-region.

In some examples, the first scan line GL1(i+1), the second reset control line RST2(i+1)/RST2(i+2), and the light emitting control line EML(i+1) may bypass a fourth sub-region adjacent to the second sub-region in which they are located in the first direction X by being bent. For example, the second reset control line RST2(i+1)/RST2(i+2) and the light emitting control line EML(i+1) may bypass from a side of the fourth sub-region in an opposite direction of the second direction Y, and the first scan line GL1(i+1) may bypass from a side of the fourth sub-region in the second direction Y. In this example, the lines of the first conductive layer are configured to be bent to bypass the fourth sub-region, which is beneficial to improve the light transmittance of the fourth sub-region.

In some examples, the first reset control line RST1(i)/RST1(i+1) may be substantially in a shape of a bending line extending along the first direction X. Within the first sub-region and the second sub-region, an overlapping region between the first reset control line RST1(i)/RST1(i+1) and first active layers of the four first pixel circuits may serve as gates of the first transistors of the four first pixel circuits (including, for example, a gate of the first transistor 31a and a gate of the first transistor 31b in the first sub-region, and a gate of the first transistor 31c and a gate of the first transistor 31d in the second sub-region). In some examples, the first reset control line RST1(i)/RST1(i+1) has a first annular structure RST10 at a location where the first sub-region and the second sub-region are adjacent. In the second direction Y, a side of the first annular structure RST10 close to the first sub-region overlaps first active layers of the first sub-pixel circuit 11c and the first pixel circuit 11d in an i-th row, and a side of the first annular structure RST10 close to the second sub-region overlaps first active layers of the first pixel circuit 11a and the first pixel circuit 11b in an (i+1)-th row. The first annular structure RST10 can make a plurality of first sub-pixel circuits in an i-th row and a plurality of first sub-pixel circuits in an (i+1)-th row share a first reset control line RST1(i)/ RST1(i+1), so that the quantity of signal lines is reduced, space of the display substrate is saved, and the light transmittance of the display substrate is improved (the light transmittance of the third sub-region and the fourth sub-region can be improved).

In some examples, the first scan line GL1(i) may be substantially in a shape of a bending line extending along the first direction X. Within the first sub-region, an overlapping region between the first scan line GL1(i) and fourth active layers of four first pixel circuits located in an i-th row may serve as gates of the fourth transistors of the four first pixel circuits (for example, including the gate of the fourth transistor 34a and the gate of the fourth transistor 34b). In the second sub-region, an overlapping region between the first scan line GL1(i+1) and fourth active layers of four first pixel circuits located in an (i+1)-th row may serve as gates of the fourth transistors of the four first pixel circuits (including, for example, the gate of the fourth transistor 34a and the gate of the fourth transistor 34b).

In some examples, the light emitting control line EML(i) may be substantially in a shape of a bending line extending along the first direction X. Within the first sub-region, an overlapping region between the light emitting control line EML(i) and fifth active layers of four first pixel circuits located in an i-th row may serve as gates of the fifth transistors of the four first pixel circuits (including, for example, a gate of the fifth transistor 35a and a gate of the fifth transistor 35b), and an overlapping region between the light emitting control line EML(i) and sixth active layers of the four first pixel circuits may serve as gates of the sixth transistors of the four first pixel circuits (including, for example, a gate of the sixth transistor 36a and a gate of the sixth transistor 36b). Within the second sub-region, an overlapping region between the light emitting control line EML(i+1) and fifth active layers of four first pixel circuits located in an (i+1)-th row may serve as gates of fifth transistors of the four first pixel circuits (including, for example, a gate of the fifth transistor 35a and a gate of the fifth transistor 35b ), and an overlapping region between the light emitting control line EML(i) and sixth active layer of the four first pixel circuits may serve as gates of sixth transistors of the four first pixel circuits (including, for example, a gate of the sixth transistor 36a and a gate of the sixth transistor 36b).

In some examples, the second reset control line RST2(i-1)/RST2(i) may be substantially in a shape of a bending line extending along the first direction X. Within the first sub-region and the second sub-region, an overlapping region between the second reset control line RST2(i) and seventh active layers of four first pixel circuits located in an (i-1)-th row and an i-th row may serve as gates of seventh transistors of the four first pixel circuits (including, for example, a gate of the seventh transistor 37a and a gate of the seventh transistor 37b), and an overlapping region between the second reset control line RST2(i-1)/RST2(i) and eighth active layers of the four first pixel circuits may serve as gates of eighth transistors of the four first pixel circuits (including, for example, a gate of the eighth transistor 38a and a gate of the eighth transistor 38b). In some examples, the second reset control line RST2(i-1)/RST2(i) has a second annular structure RST20 at a location where the first sub-region and the second sub-region are adjacent. In the second direction Y, a side of the second annular structure RST20 close to the first sub-region overlaps the first active layers of the first sub-pixel circuit 11c and the first pixel circuit 11d in an i-th row, and a side of the second annular structure RST20 close to the second sub-region overlaps the first active layers of the first pixel circuit 11a and the first pixel circuit 11b in an (i-1)-th row, the second annular structure RST20 can make a plurality of first sub-pixel circuits in an i-th row and a plurality of first sub-pixel circuits in an (i-1)-th row share a second reset control line RST2(i-1)/RST2(i), so that the quantity of signal lines is reduced, space of the display substrate is saved, and the light transmittance of the display substrate is improved (the light transmittance of the third sub-region and the fourth sub-region can be improved).

In some examples, the first electrode 391a of the storage capacitor of the first pixel circuit 11a may simultaneously serve as a gate of the third transistor 33a, and the first electrode 391b of the storage capacitor of the first pixel circuit 11b may simultaneously serve as a gate of the third transistor 33b. Orthographic projections of the first electrodes 391a and 391b on the base substrate may be substantially rectangular. This embodiment is not limited thereto.

(104) Forming a second conductive layer. In some examples, a second insulation thin film and a second conductive thin film are deposited sequentially on the base substrate on which the aforementioned structures are formed, and the second conductive thin film is patterned through a patterning process to form a second insulation layer and a second conductive layer disposed on the second insulation layer. In some examples, the second conductive layer may be also referred to as a second gate metal layer.

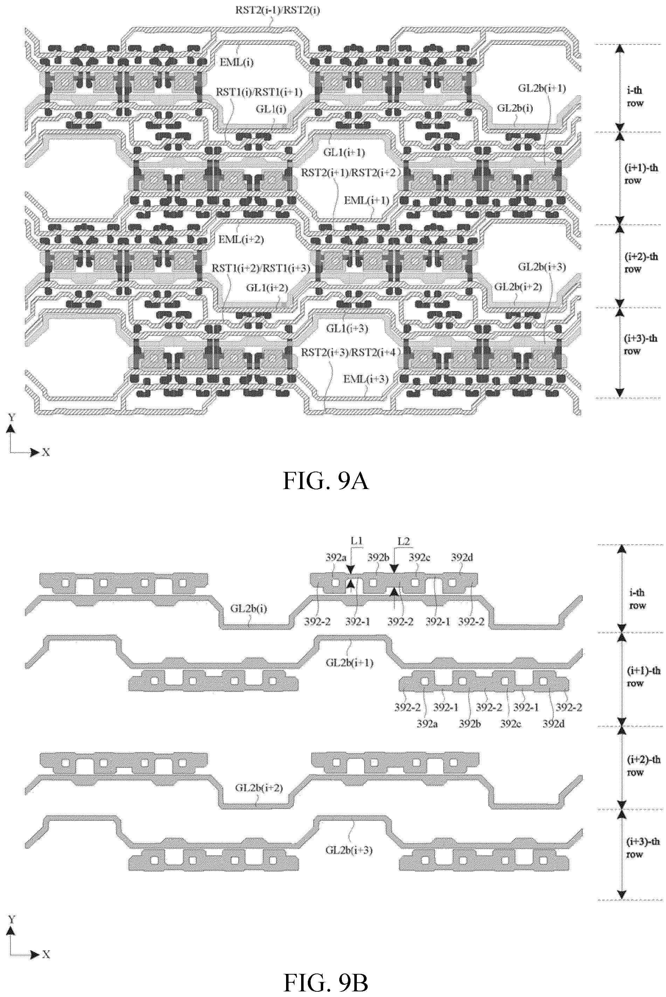

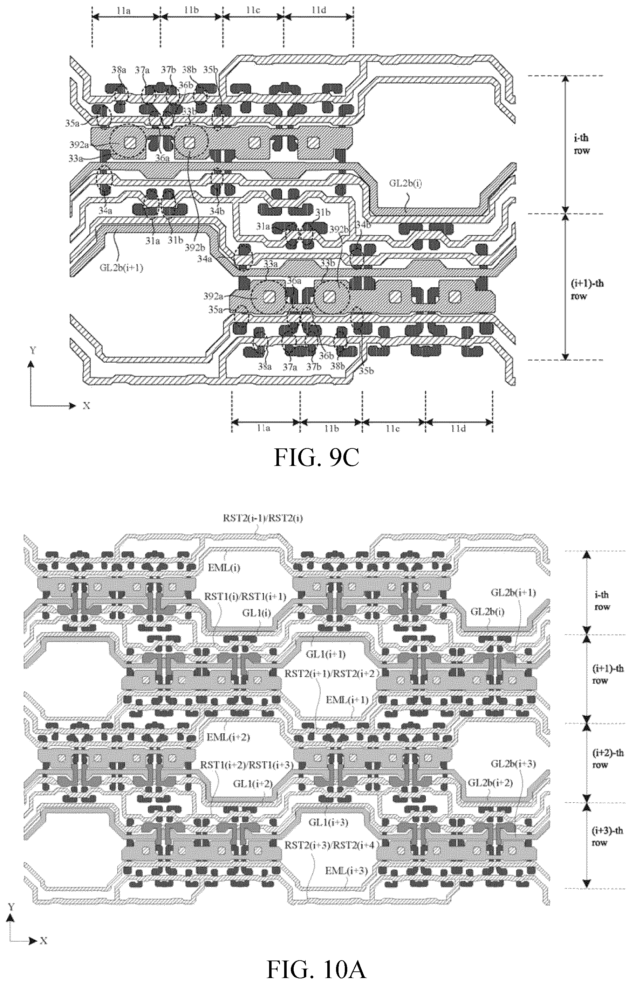

FIG. 9A is a schematic diagram of the first display region after a second conductive layer is formed. FIG. 9B is a schematic diagram of the second conductive layer in FIG. 9A. FIG. 9C is a schematic partial enlarged diagram in FIG. 9A.

In some examples, as shown in FIGS. 9A to 9C, the second conductive layer of the first display region may include at least a plurality of second scan auxiliary lines (e.g., second scan auxiliary lines GL2b(i), GL2b(i+1), GL2b(i+2), GL2b(i+3)), a plurality of second electrodes of storage capacitors of a plurality of first pixel circuits (e.g., second electrodes 392a, 392b).

In some examples, the second scan auxiliary line GL2b(i) may be substantially in a shape of a bending line extending along the first direction X. Within the first sub-region, the second scan auxiliary line GL2b(i) may be located at a side of the second electrode (e.g., 392a and 392b) of the storage capacitor of the first pixel circuit in an opposite direction of the second direction Y. The second scan auxiliary line GL2b(i) may bypass the third sub-region from a side in an opposite direction of the second direction Y and be located at a side of the first scan line GL1(i) along the second direction Y, i.e., in the second direction Y, the second scan auxiliary line GL2b(i) may be located between a second electrode of the storage capacitor of the first pixel circuit and the first scan line GL1(i). Within the second sub-region, the second scan auxiliary line GL2b(i+1) may be located at a side of the second electrode (e.g., 392a and 392b) of the storage capacitor of the first pixel circuit in the second direction Y. The second scan auxiliary line GL2b(i+1) may bypass the fourth sub-region from a side in the second direction Y and be located at a side of the first scan line GL1(i+1) in an opposite direction of the second direction Y, that is, in the second direction Y, the second scan auxiliary line GL2b(i+1) may be located between the second electrode of the storage capacitor of the first pixel circuit and the first scan line GL1(i+1).

In some examples, within the first sub-region and the second sub-region, an orthographic projection of the second electrode of the storage capacitor of each first pixel circuit on the base substrate may has substantially a rectangular structure with a hollowed area, an orthographic projection of the hollowed area on the base substrate may be substantially in a rectangular shape, and the rectangular shape may have rounded corners or chamfered corners. The second electrode 392a of the storage capacitor of the first pixel circuit 11a and the second electrode 392b of the storage capacitor of the first pixel circuit 11b may be electrically connected through a first plate connection block 392-1, the second electrode 392b of the storage capacitor of the first pixel circuit 11b and the second electrode of the storage capacitor of the first pixel circuit 11c may be electrically connected through a second plate connection block 392-2, and the second electrode of the storage capacitor of the first pixel circuit 11c and the second electrode of the storage capacitor of the first pixel circuit 11d may be electrically connected through another first plate connection block 392-1. A side of the second electrodes of the storage capacitors of the first pixel circuits 11a and 11d away from remaining first pixel circuits may be electrically connected to a second plate connection block 392-2. The length L1 of the first plate connection block 392-1 in the second direction Y may be less than the length L2 of the second plate connection block 392-2 in the second direction Y. The second electrode of the storage capacitor may subsequently be electrically connected to the first power supply line through the second plate connection block. In this example, the second electrodes of the storage capacitors of the four first pixel circuits in the first sub-region can be of an interconnected integral structure, which is beneficial to ensure the uniform transmission of a first voltage signal along the first direction X. The second electrodes of the storage capacitors of the four first pixel circuits in the second sub-region may be of an interconnected integral structure, which is beneficial to ensure the uniform transmission of the first voltage signal along the first direction X.

In an exemplary embodiment, the second electrode of the storage capacitor may be understood as the second plate of the storage capacitor.

(105) A second semiconductor layer is formed. In some examples, a third insulation thin film and a second semiconductor thin film are sequentially deposited on a base substrate on which the above-mentioned patterns are formed, and the second semiconductor thin film is patterned by a patterning process to form a third insulation layer and a second semiconductor layer disposed on the third insulation layer. In some examples, the material of the second semiconductor layer may include Indium Gallium Zinc Oxide (IGZO).

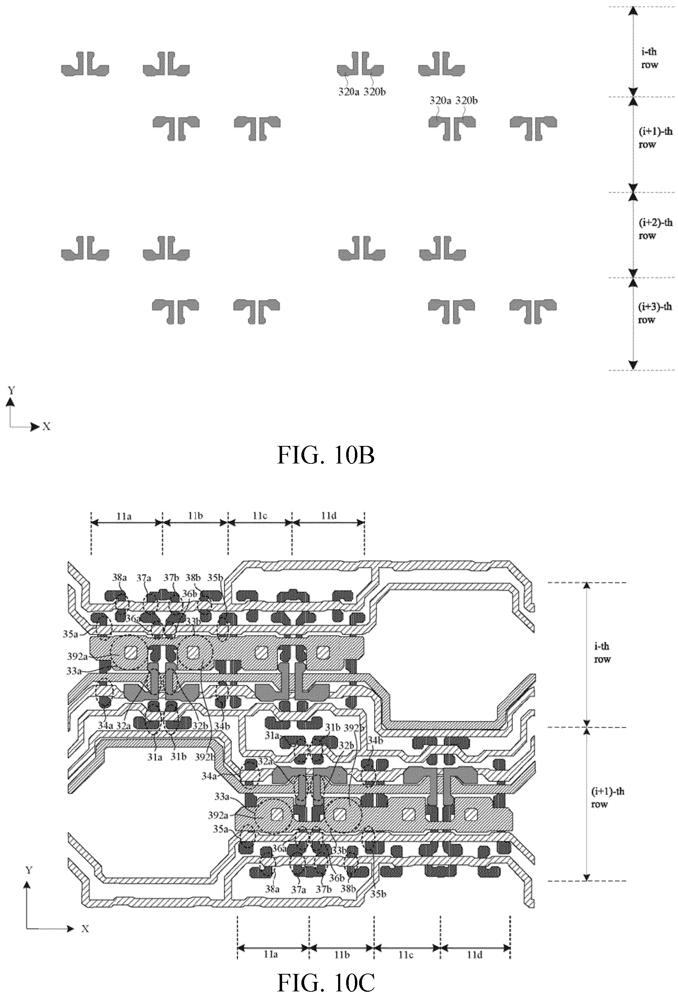

FIG. 10A is a schematic diagram of the first display region after a second semiconductor layer is formed. FIG. 10B is a schematic diagram of the second semiconductor layer in FIG. 10A. FIG. 10C is a schematic partial enlarged diagram in FIG. 10A.

In some examples, as shown in FIGS. 10A to 10C, the second semiconductor layer of the first display region may include at least active layers of the second type of transistors of a plurality of first pixel circuits (e.g., a second active layer 320a of the second transistor 32a of the first pixel circuit 11a, a second active layer 320b of the second transistor 32b of the first pixel circuit 11bin the first sub-region and the second sub-region).

In some examples, within the first sub-region and the second sub-region, patterns of the second semiconductor layer of the four first pixel circuits may be substantially symmetrical with respect to the first midline O1, patterns of the second semiconductor layer of the first pixel circuit 11a and the first pixel circuit 11b may be substantially symmetrical with respect to the second midline O2, and patterns of the second semiconductor layer of the first pixel circuit 11c and the first pixel circuit 11d may be substantially symmetrical with respect to the third midline O3.

In some examples, the second active layers 320a and 320b may be substantially L-shaped. In the first sub-region, an overlapping region between the second scan auxiliary line GL2b(i) and the second active layer 320a may serve as a bottom gate of the second transistor 32a, and an overlapping region between the second scan auxiliary line GL2b(i) and the second active layer 320b may serve as a bottom gate of the second transistor 32b. In the second sub-region, an overlapping region between the second scan auxiliary line GL2b(i+1) and the second active layer 320a may serve as a bottom gate of the second transistor 32a, and an overlapping region between the second scan auxiliary line GL2b(i+1) and the second active layer 320b may serve as a bottom gate of the second transistor 32b.

(106) Forming a third conductive layer. In some examples, a fourth insulation thin film and a third conductive thin film are sequentially deposited on the base on which the aforementioned patterns are formed, and the third conductive thin film is patterned through a patterning process to form a fourth insulation layer and a third conductive layer disposed on the fourth insulation layer. In some examples, the third conductive layer may also be referred to as a third gate metal layer.

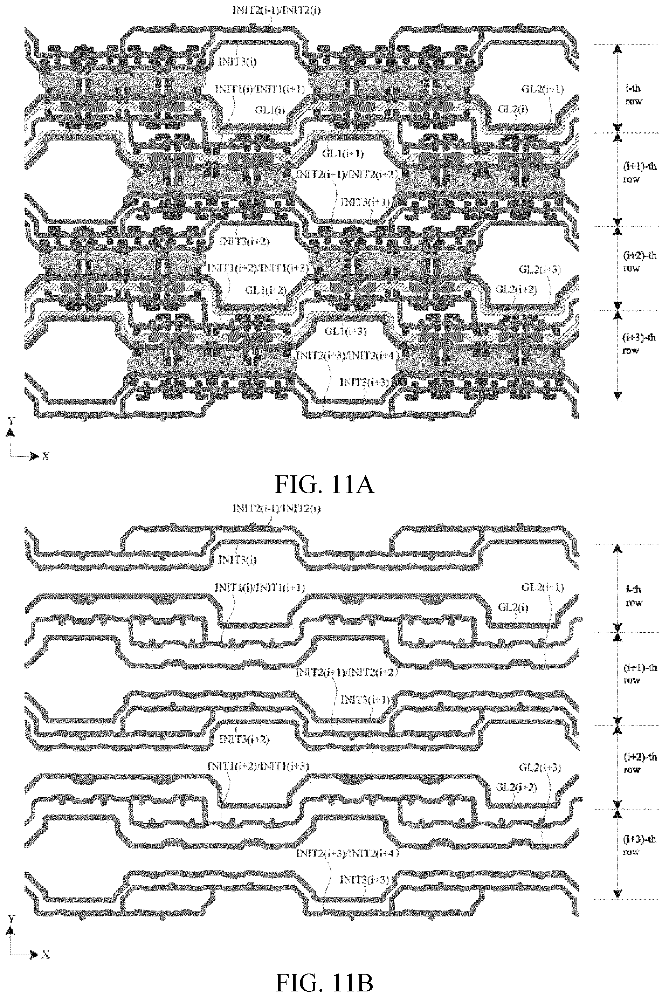

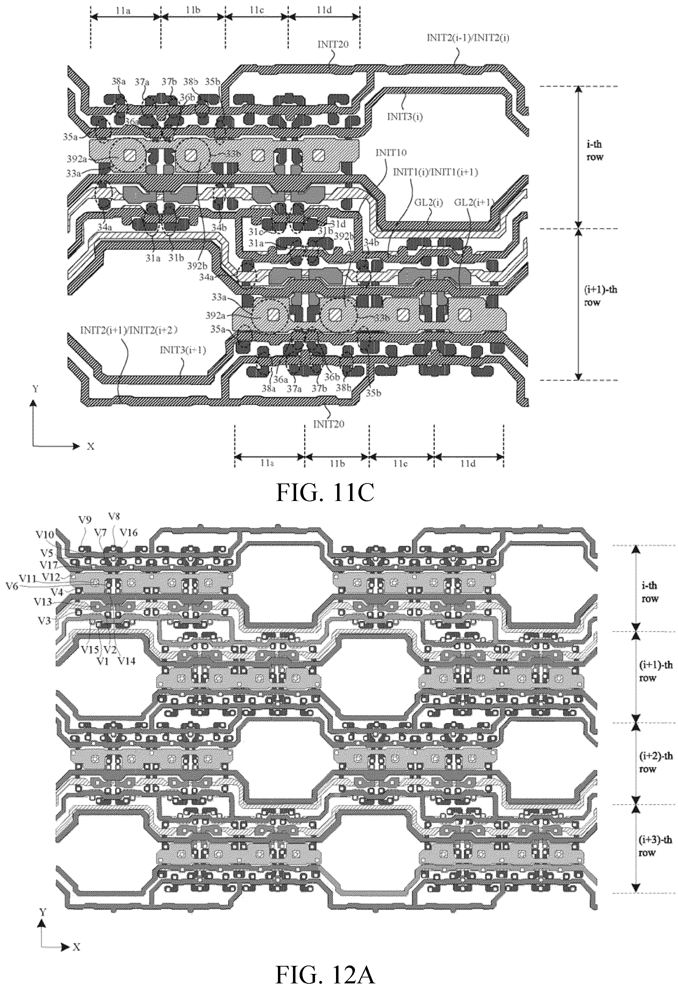

FIG. 11A is a schematic diagram of the first display region after a third conductive layer is formed. FIG. 11B is a schematic diagram of the third conductive layer in FIG. 11A. FIG. 11C is a schematic partial enlarged diagram in FIG. 11A.

In some examples, as shown in FIGS. 11A to 11C, the third conductive layer of the first display region may include at least a plurality of second scan lines (e.g., second scan lines GL2(i), GL2(i+1), GL2(i+2), GL2(i+3)), a plurality of first initial signal lines (e.g., first initial signal lines INIT1(i), INIT1(i+1), INIT1(i+2), INIT1(i+3)), a plurality of second initial signal lines (e.g., second initial signal lines INIT2(i-1), INIT2(i), INIT2(i+1), INIT2(i+2) , INIT2(i+3) , INIT2(i+4)), and a plurality of third initial signal lines (e.g., third initial signal lines INIT3(i), INIT3(i+1), INIT3(1+2), INIT3(i+3)). The first initial signal line, the second scan line, the second initial signal line, and the third initial signal line may each be substantially in a shape of a bending line extending along the first direction X.

In some examples, within the first sub-region, the first initial signal line INIT1(i)/INIT1(i+1) and the second scan line GL2(i) may be located at a side of the storage capacitor along an opposite direction of the second direction Y, and the second initial signal line INIT2(i-1)/INIT2(i) and the third initial signal line INIT3(i) may be located at a side of the storage capacitor along the second direction Y. The first initial signal line INIT1(i)/INIT1(i+1) may be located at a side of the second scan line GL2(i) along an opposite direction of the second direction Y; the second initial signal line INIT2(1-1)/INIT2(i) may be located at a side of the third initial signal line INIT3(i) along the second direction Y. Within the second sub-region, the first initial signal line INIT1(i)/INIT1(i+1) and the second scan line GL2(i+1) may be located at a side of the storage capacitor along the second direction Y, and the second initial signal line INIT2(i+1)/INIT2(i+2) and the third initial signal line INIT3(i+1) may be located at a side of the storage capacitor along an opposite direction of the second direction Y. The first initial signal line INIT1(i)/INIT1(i+1) may be located at a side of the second scan line GL2(i+1) along the second direction Y; the second initial signal line INIT2(i+1)/INIT2(i+2) may be located at a side of the third initial signal line INIT3(i+1) in an opposite direction of the second direction Y.

In some examples, the first initial signal line INIT1(i)/INIT1(i+1), the second scan line GL2(i), and the third initial signal line INIT3(i) may bypass a third sub-region adjacent to the first sub-region in which they are located in the first direction X by being bent. For example, the first initial signal line INIT1(i)/INIT1(i+1) and the second scan line GL2(i) may bypass from a side of the third sub-region in an opposite direction of the second direction Y, and the third initial signal line INIT3(i) may bypass from a side of the third sub-region in the second direction Y. In this example, the lines of the third conductive layer are configured to be bent to bypass the third sub-region, which is beneficial to improve the light transmittance of the third sub-region.

In some examples, the second scan line GL2(i+1), the second initial signal line INIT2(i+1)/INIT2(i+2), and the third initial signal line INIT3(i+1) may bypass a fourth sub-region adjacent to the second sub-region in which they are located in the first direction X by being bent. For example, the second scan line GL2(i+1) may bypass from a side of the fourth sub-region along the second direction Y, the third initial signal line INIT3(i+1) may bypass from a side of the fourth sub-region along an opposite direction of the second direction Y, and the second initial signal line INIT2(i+1)/INIT2(i+2) may bypass from a side of the fourth sub-region along an opposite side of the second direction Y. In this example, the lines of the third conductive layer are configured to be bent to bypass the fourth sub-region, which is beneficial to improve the light transmittance of the fourth sub-region.

In some examples, an orthographic projection of the first initial signal line INIT1(i)/INIT1(i+1) on the base substrate and an orthographic projection of the first reset control line RST1(i)/RST1(i+1) on the base substrate may at least partially overlap, an orthographic projection of the second scan line GL2(i) on the base substrate and an orthographic projection of the second scan auxiliary line GL2b(i) on the base substrate may at least partially overlap, an orthographic projection of the third initial signal line INIT3(i) on the base substrate and an orthographic projection of the light emitting control line EML(i) on the base substrate may at least partially overlap, and an orthographic projection of the second initial signal line INIT2 (i-1)/INIT2 (i) on the substrate and an orthographic projection of the second reset control line RST2 (i-1)/RST2 (i) on the substrate may at least partially overlap. In some examples, an orthographic projection of the first initial signal line INIT1(i+2)/INIT1(i+3) on the base substrate and an orthographic projection of the first reset control line RST1(i+2)/RST1(i+3) on the base substrate may at least partially overlap, an orthographic projection of the second scan line GL2(i+1) on the base substrate and an orthographic projection of the second scan auxiliary line GL2b(i+1) on the base substrate may at least partially overlap, an orthographic projection of the third initial signal line INIT3(i+1) on the base substrate and an orthographic projection of the light emitting control line EML(i+1) on the base substrate may at least partially overlap, and an orthographic projection of the second initial signal line INIT2 (i+1)/INIT2 (i+2) on the substrate and an orthographic projection of the second reset control line RST2 (i+1)/RST2 (i+2) on the substrate may at least partially overlap. In this example, by designing lines of different conductive layers to be stacked, it is possible to avoid occupying too much lines space, which is beneficial for saving routing space and thereby improving the light transmittance of the first display region.

In some examples, the first initial signal line INIT1(i)/INIT1(i+1) has a third annular structure INIT10 at a location where the first sub-region and the second sub-region are adjacent, in the second direction Y, a side of the third annular structure INIT10 close to the first sub-region overlaps the first active layers of the first pixel circuits 11c and 11d in an i-th row, a side of third annular structure INIT10 close to the second sub-region overlaps first active layers of the first pixel circuit 11a and the first pixel circuit 11b in an (i+1)-th row. The third annular structure INIT10 can make a plurality of first sub-pixel circuits in an i-th row and a plurality of first sub-pixel circuits in an (i+1)-th row share one first initial signal line INIT1(i)/INIT1(i+1), so that the quantity of signal lines is reduced, space of the display substrate is saved, and the light transmittance of the display substrate is improved (the light transmittance of the third sub-region and the fourth sub-region can be improved).

In some examples, the second initial signal line INIT2(i-1)/INIT2(i) has a fourth annular structure INIT20 at a location where the first sub-region and the second sub-region are adjacent. In the second direction Y, a side of the fourth annular structure INIT20 close to the first sub-region overlaps first active layers of the first sub-pixel circuit 11c and the first pixel circuit 11d in an i-th row, and a side of the fourth annular structure INIT20 close to the second sub-region overlaps the first active layers of the first sub-pixel circuit 11a and the first pixel circuit 11b in an (i-1)-th row. The fourth annular structure INIT20 can make a plurality of first sub-pixel circuits in an i-th row and a plurality of first sub-pixel circuits in an (i-1)-th row share one second reset control line RST2(i-1)/RST2(i), so that the quantity of signal lines is reduced, space of the display substrate is saved, and the light transmittance of the display substrate is improved (the light transmittance of the third sub-region and the fourth sub-region can be improved).

In some examples, a region where the second scan line overlaps the active layer of the second transistor may serve as a gate of the second transistor (which may be referred to as a control electrode or a top gate), and the signals of the second scan auxiliary line and the corresponding second scan line can be the same, i.e., they are connected in parallel and connected to the same signal source, so that the second scan auxiliary line may serve as a bottom gate electrode (i.e., a bottom control electrode) of the second transistor, forming a second transistor T2 with a double-gate structure.

(107) Forming a fifth insulation layer. In some examples, a fifth insulation thin film is deposited on the base on which the aforementioned patterns are formed, and the fifth insulation thin film is patterned through a patterning process to form a fifth insulation layer.

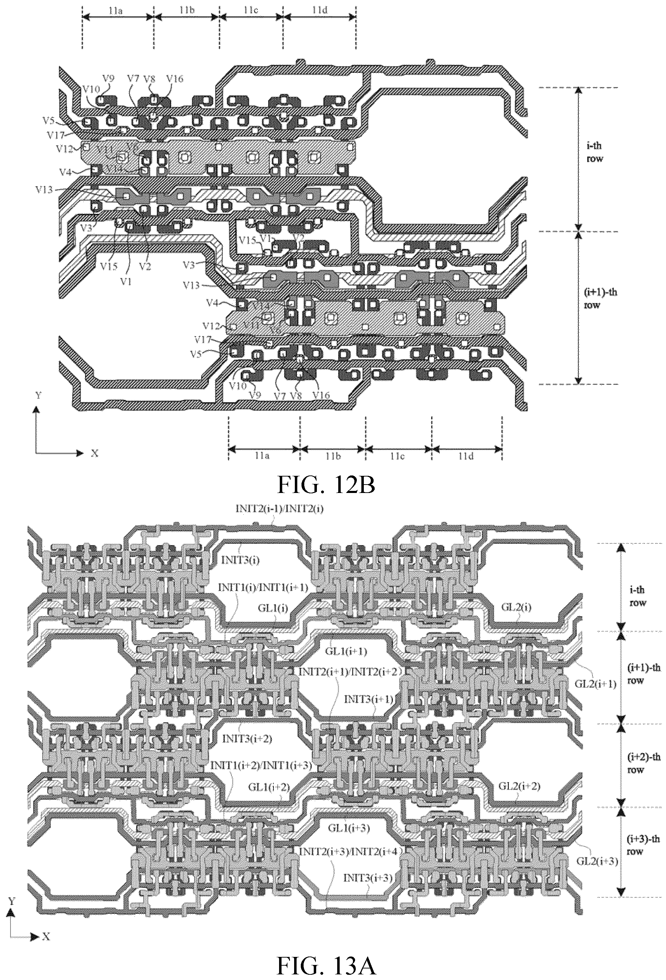

FIG. 12A is a schematic diagram of a first sub-region and a second sub-region after the fifth insulation layer is formed, and FIG. 12B is a schematic partial enlarged diagram of FIG. 12A. In some examples, as shown in FIGS. 12A and 12B, the fifth insulation layer of the first display region may be provided with a plurality of vias, for example, including a first via V1 to a seventeenth via V17.

In some examples, the fifth insulation layer, the fourth insulation layer, the third insulation layer, the second insulation layer and the first insulation layer within the first via V1 to the tenth via V10 may be removed to expose a portion of a surface of the first semiconductor layer. The fifth insulation layer, the fourth insulation layer, the third insulation layer, and the second insulation layer in the eleventh via V11 may be removed to expose a portion of a surface of the first conductive layer. The fifth insulation layer, the fourth insulation layer, and the third insulation layer in the twelfth via V12 may be removed to expose a portion of a surface of the second conductive layer. The fifth insulation layer and the fourth insulation layer in the thirteenth via V13 and the fourteenth via V14 can be removed to expose a surface of the second semiconductor layer. The fifth insulation layer in the fifteenth via V15 to the seventeenth via V17 can be removed to expose a portion of a surface of the third conductive layer.

In some examples, an orthographic projection of the first via V1 on the base substrate is within the range of an orthographic projection of the first active layer of the first transistor on the base substrate, and the fifth insulation layer, the fourth insulation layer, the third insulation layer, the second insulation layer and the first insulation layer within the first via V1 may be removed to expose a surface of the first region of the first active layer. The first via V1 is configured such that a first electrode of a subsequently formed first transistor is connected to the first active layer of the first transistor through this via.

In some examples, an orthographic projection of the second via V2 on the base substrate is within the range of an orthographic projection of the second active layer of the first transistor on the base substrate, and the fifth insulation layer, the fourth insulation layer, the third insulation layer, the second insulation layer and the first insulation layer within the second via V2 may be removed to expose a surface of the second region of the second active layer. The second via V2 is configured such that the second electrode of the first transistor formed subsequently is connected to the first active layer of the first transistor through this via.

In some examples, an orthographic projection of the third via V3 on the base substrate is within the range of an orthographic projection of the fourth active layer of the fourth transistor on the base substrate, and the fifth insulation layer, the fourth insulation layer, the third insulation layer, the second insulation layer and the first insulation layer within the third via V3 may be removed to expose a surface of the first region of the fourth active layer. The third via V3 is configured so that the first electrode of the fourth transistor formed subsequently is connected to the fourth active layer of the fourth transistor through this via.

In some examples, an orthographic projection of the fourth via V4 on the base substrate is within the range of an orthographic projection of the fourth active layer of the fourth transistor on the base substrate, and the fifth insulation layer, the fourth insulation layer, the third insulation layer, the second insulation layer and the first insulation layer within the fourth via V4 may be removed to expose a surface of the second region of the fourth active layer. The fourth via V4 is configured so that the second electrode of the fourth transistor formed subsequently is connected to the fourth active layer of the fourth transistor through this via.

In some examples, an orthographic projection of the fifth via V5 on the base substrate is within the range of an orthographic projection of the fifth active layer of the fifth transistor on the base substrate, and the fifth insulation layer, the fourth insulation layer, the third insulation layer, the second insulation layer and the first insulation layer within the fifth via V5 may be removed to expose a surface of the first region of the fifth active layer. The fifth via V5 is configured such that the first electrode of the subsequently formed fifth transistor is connected to the fifth active layer of the fifth transistor through this via.

In some examples, an orthographic projection of the sixth via V6 on the base substrate is within the range of an orthographic projection of the sixth active layer of the sixth transistor on the base substrate, and the fifth insulation layer, the fourth insulation layer, the third insulation layer, the second insulation layer and the first insulation layer within the sixth via V6 may be removed to expose a surface of the first region of the sixth active layer. The sixth via V6 is configured so that the first electrode of the sixth transistor formed subsequently is connected to the sixth active layer of the sixth transistor through this via.

In some examples, an orthographic projection of the seventh via V7 on the base substrate is within the range of an orthographic projection of the sixth active layer of the sixth transistor on the base substrate, and the fifth insulation layer, the fourth insulation layer, the third insulation layer, the second insulation layer and the first insulation layer within the seventh via V7 may be removed to expose a surface of the second region of the sixth active layer (also a surface of the second region of the seventh transistor). The seventh via V7 is configured such that the second electrode of the subsequently formed sixth transistor is connected to the sixth active layer of the sixth transistor through this via, and the second electrode of the subsequently formed seventh transistor is connected to the seventh active layer of the seventh transistor through this via.

In some examples, an orthographic projection of the eighth via V8 on the base substrate is within the range of an orthographic projection of the seventh active layer of the seventh transistor on the base substrate, and the fifth insulation layer, the fourth insulation layer, the third insulation layer, the second insulation layer and the first insulation layer within the eighth via V8 may be removed to expose a surface of the first region of the seventh active layer. The eighth via V8 is configured so that the first electrode of the seventh transistor formed subsequently is connected to the seventh active layer of the seventh transistor through this via. In some examples, the first pixel circuit 11a and the first pixel circuit 11b may share one eighth via and the first pixel circuit 11c and the first pixel circuit 11d may share one eighth via.

In some examples, an orthographic projection of the ninth via V9 on the base substrate is within the range of an orthographic projection of the eighth active layer of the eighth transistor on the base substrate, and the fifth insulation layer, the fourth insulation layer, the third insulation layer, the second insulation layer and the first insulation layer within the ninth via V9 may be removed to expose a surface of the first region of the eighth active layer. The ninth via V9 is configured so that the first electrode of the eighth transistor formed subsequently is connected to the eighth active layer of the eighth transistor through this via.

In some examples, an orthographic projection of the tenth via V10 on the base substrate is within the range of an orthographic projection of the eighth active layer of the eighth transistor on the base substrate, and the fifth insulation layer, the fourth insulation layer, the third insulation layer, the second insulation layer and the first insulation layer within the tenth via V10 may be removed to expose a surface of the second region of the eighth active layer. The tenth via V10 is configured so that the second electrode of the eighth transistor formed subsequently is connected to the eighth active layer of the eighth transistor through this via.

In some examples, an orthographic projection of the eleventh via V11 on the base substrate is within the range of an orthographic projection of the first electrode of the storage capacitor on the base substrate, and the fifth insulation layer, the fourth insulation layer, the third insulation layer and the second insulation layer within the eleventh via V11 may be removed to expose a surface of the first electrode of the storage capacitor. The eleventh via V11 is configured so that the second connection electrode formed subsequently is connected to the first electrode of the storage capacitor through this via.

In some examples, an orthographic projection of the twelfth via V12 on the base substrate is within the range of an orthographic projection of the second plate connection block 392-2 of the storage capacitor on the base substrate, and the fifth insulation layer, the fourth insulation layer, and the third insulation layer within the twelfth via V12 may be removed to expose a surface of the second plate connection block 392-2. The twelfth via V12 is configured so that the fifth connection electrode formed subsequently is connected to the second plate connection block 392-2 through this via.

In some examples, an orthographic projection of the thirteenth via V13 on the base substrate is within the range of an orthographic projection of the second active layer of the second transistor on the base substrate, and the fifth insulation layer and the fourth insulation layer within the thirteenth via V13 may be removed to expose a surface of the first region of the second active layer. The thirteenth via V13 is configured so that the first electrode of the second transistor formed subsequently is connected to the second active layer of the second transistor through this via.

In some examples, an orthographic projection of the fourteenth via V14 on the base substrate is within the range of an orthographic projection of the second active layer of the second transistor on the base substrate, and the fifth insulation layer and the fourth insulation layer within the fourteenth via V14 may be removed to expose a surface of the second region of the second active layer. The fourteenth via V14 is configured so that the second electrode of the second transistor formed subsequently is connected to the second active layer of the second transistor through this via.

In some examples, an orthographic projection of the fifteenth via V15 on the base substrate is within the range of an orthographic projection of the first initial signal line INIT1(i)/INIT1(i+1) on the base substrate, and the fifth insulation layer within the fifteenth via V15 may be removed to expose a surface of the first initial signal line INIT1(i)/INIT1(i+1). The fifteenth via V15 is configured so that the ninth connection electrode formed subsequently is connected to the first initial signal line INIT1(i)/INIT1(i+1) through this via.

In some examples, an orthographic projection of the sixteenth via V16 on the base substrate is within the range of an orthographic projection of the second initial signal line INIT2(i-1)/INIT2(i) on the base substrate, and the fifth insulation layer within the sixteenth via V16 may be removed to expose a surface of the second initial signal line INIT2(i-1)/INIT2(i). The sixteenth via V16 is configured so that the ninth connection electrode formed subsequently is connected to the second initial signal line INIT2(i-1)/INIT2(i) through this via.

In some examples, an orthographic projection of the seventeenth via V17 on the base substrate is within the range of an orthographic projection of the third initial signal line INIT3(i) on the base substrate, and the fifth insulation layer within the seventeenth via V17 may be removed to expose a surface of the third initial signal line INIT3(i). The seventeenth via V17 is configured so that the seventh connection electrode (the first electrode of the eighth transistor) formed subsequently is connected to the third initial signal line INIT3(i) through this via.

(108) Forming a fourth conductive layer. In some examples, a fourth conductive thin film is deposited on the base substrate on which the aforementioned patterns are formed, and the fourth conductive thin film is patterned through a patterning process to form the fourth conductive layer on the fifth insulation layer. In some examples, the fourth conductive layer is also referred to as a first source-drain metal layer.

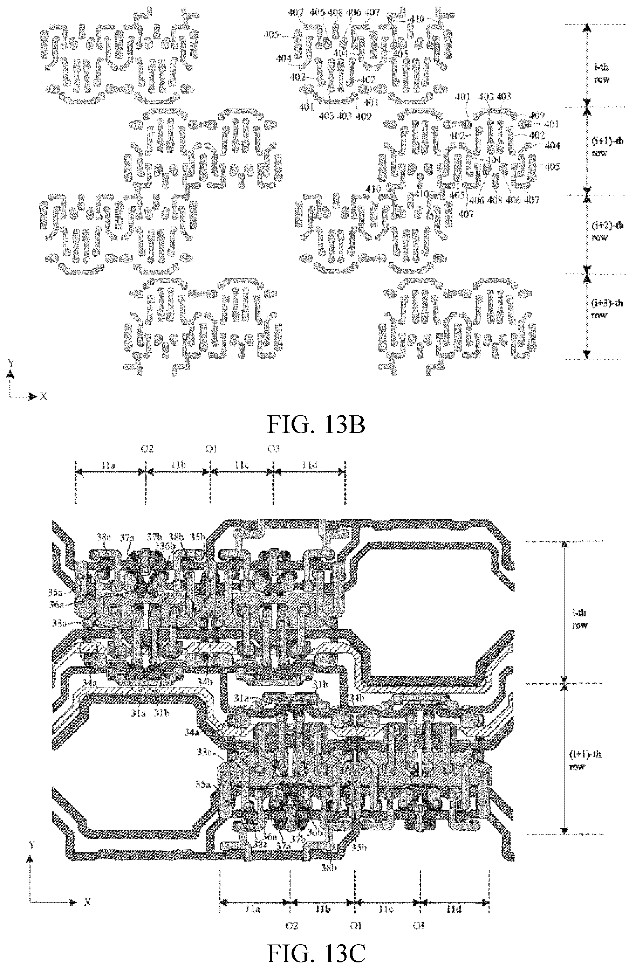

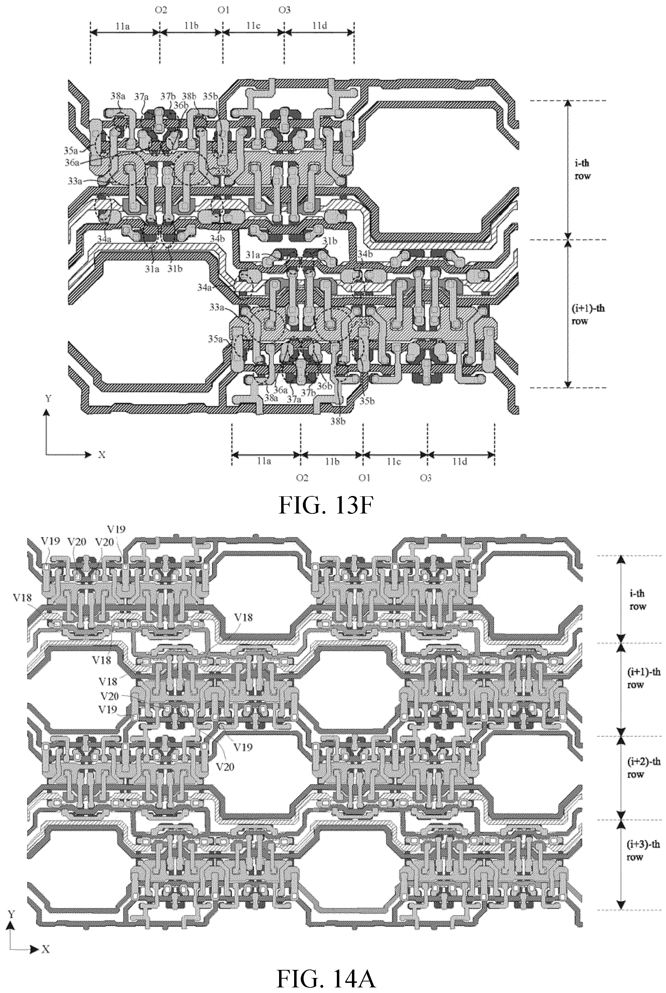

FIG. 13A is a schematic diagram of the first display region after a fourth conductive layer is formed. FIG. 13B is a schematic diagram of the fourth conductive layer in FIG. 13A. FIG. 13C is a schematic partial enlarged diagram in FIG. 13A.

In some examples, as shown in FIGS. 13A to 13C, the fourth conductive layer of the first display region may include at least a plurality of connection electrodes (e.g., including a first connection electrode 401 to a ninth connection electrode 409).

In some examples, the first connection electrode 401 may be substantially rectangular. The first connection electrode 401 may be electrically connected to the fourth active layer of the fourth transistor 34a of the first pixel circuit 11a through the third via V3. In some examples, the first connection electrode 401 may serve as the first electrode of the fourth transistor 34a.

In some examples, the second connection electrode 402 may be substantially in a shape of a strip extending in the second direction Y. One end of the second connection electrode 402 may be electrically connected to the second active layer of the second transistor 32a of the first pixel circuit 11a through the thirteenth via V13, and another end may be electrically connected to the first electrode 391a of the storage capacitor through the eleventh via V11. The second connection electrode 402 may serve as a first electrode of the second transistor 32a, is electrically connected to a gate of the third transistor 33a and the first electrode 391a of the storage capacitor through the eleventh via V11, and is electrically connected to a second active layer of the second transistor 32a through the thirteenth via V13, and the second connection electrode 402 may serve as a first node of the first pixel circuit 11a.

In some examples, the third connection electrode 403 may be substantially in a shape of a strip extending in the second direction Y. One end of the third connection electrode 403 may be electrically connected to the first active layer of the first transistor 31a of the first pixel circuit 11a through the second via V2, another end may be electrically connected to the second active layer of the second transistor 32a through the fourteenth via V14, and may be electrically connected to the third active layer of the third transistor 33a (also the sixth active layer of the sixth transistor 36a) through the sixth via V6. In some examples, the third connection electrode 403 may serve as the second electrode of the first transistor, the second electrode of the second transistor, the second electrode of the third transistor and the first electrode of the sixth transistor in the first pixel circuit.

In some examples, the fourth connection electrode 404 may be substantially in a shape of a bending line extending in the second direction Y. The fourth connection electrode 404 may be electrically connected to the fourth active layer of the fourth transistor 34a of the first pixel circuit 11a through the fourth via V4, and may be electrically connected to the eighth active layer of the eighth transistor 38a through the tenth via V10. In some examples, the fourth connection electrode 404 may serve as the second electrodes of the fourth transistor and the eighth transistor in the first pixel circuit.

In some examples, the fifth connection electrode 405 may be substantially in a shape of a strip extending in the second direction Y. The fifth connection electrode 405 may be electrically connected to the fifth active layer of the fifth transistor 35a of the first pixel circuit 11a through the fifth via V5, and may be electrically connected to the second plate connection block 392-2 through the twelfth via V12, thereby achieving an electrical connection to the second electrode 392a of the storage capacitor. In some examples, the fifth connection electrode 405 may serve as the first electrode of the fifth transistor of the first pixel circuit. In some examples, in the first sub-region, the first sub-pixel 11b and the first sub-pixel 11c may share one fifth connection electrode 405; in the first sub-region, the first sub-pixel 11b and the first sub-pixel 11c may share one fifth connection electrode 405.

In some examples, the sixth connection electrode 406 may be substantially rectangular-shaped. The sixth connection electrode 406 may be electrically connected to the sixth active layer of the sixth transistor 36a and the seventh active layer of the seventh transistor 37a of the first pixel circuit 11a through the seventh via V7. In some examples, the sixth connection electrode 406 may serve as the second electrodes of the sixth transistor and the seventh transistor in the first pixel circuit.

In some examples, the seventh connection electrode 407 may be substantially L-shaped. The seventh connection electrode 407 may be electrically connected to the eighth active layer of the eighth transistor 38a of the first pixel circuit 11a through the ninth via V9, and may be electrically connected to the third initial signal line INIT3(i) through the seventeenth via V17. In some examples, the seventh connection electrode 407 may serve as the first electrode of the eighth transistor in the first pixel circuit.

In some examples, the eighth connection electrode 408 may be substantially in a shape of a strip extending in the second direction Y. The eighth connection electrode 408 may be electrically connected to the seventh active layer of the seventh transistor 37a of the first pixel circuit 11a through the eighth via V8, and may be electrically connected to the second initial signal line INIT2(i-1)/INIT2(i) through the sixteenth via V16. In some examples, the eighth connection electrode 408 may serve as the first electrode of the seventh transistor in the first pixel circuit. In some examples, the first pixel circuit 11a and the first pixel circuit 11b may share one eighth connection electrode 408 and the first pixel circuit 11c and the first pixel circuit 11d may share one eighth connection electrode 408.

In some examples, the ninth connection electrode 409 may be substantially in a shape of an arch extending in the second direction Y. One end of the ninth connection electrode 409 (located at one end of the first sub-pixel circuit 11a) may be electrically connected to the first active layer of the first transistor 31a of the first sub-pixel circuit 11a through the first via V1 located in the first sub-pixel circuit 11a, and may be electrically connected to the first initial signal line INIT1(i)/-INIT1(1+1) through the fifteenth via V15 located in the first pixel circuit 11a, and another end of the ninth connection electrode 409 (located at one end of the first pixel circuit 11b) may be electrically connected to the first active layer of the first transistor 31b of the first pixel circuit 11b through the first via V1 in the first pixel circuit 11b, and may be electrically connected to the first initial signal line INIT1(i)/INIT1(i+1) through the fifteenth via V15 in the first pixel circuit 11b. In some examples, the first pixel circuit 11a and the first pixel circuit 11b may share one ninth connection electrode 409 and the first pixel circuit 11c and the first pixel circuit 11d may share one ninth connection electrode 409. In some examples, the ninth connection electrode 409 may serve as the first electrode of the first transistor in the first pixel circuit.

In some examples, within the first sub-region, the first pixel circuit 11a and the first pixel circuit 11b may be substantially symmetrical with respect to the second midline O2, the first pixel circuit 11c and the first pixel circuit 11d may be substantially symmetrical with respect to the third midline O3, and the first pixel circuit 11a and the first pixel circuit 11b, the first pixel circuit 11c and the first pixel circuit 11d may be substantially symmetrical with respect to the first midline O1. Within the second sub-region, the first pixel circuit 11a and the first pixel circuit 11b may be substantially symmetrical with respect to the second midline O2, the first pixel circuit 11c and the first pixel circuit 11d may be substantially symmetrical with respect to the third midline O3, and the first pixel circuit 11a and the first pixel circuit 11b, the first pixel circuit 11c and the first pixel circuit 11d may be substantially symmetrical with respect to the first midline O1.

In some examples, first pixel circuits within a plurality of first sub-regions arranged along the first direction X may be aligned in the first direction X, and first pixel circuits within a plurality of first sub-regions arranged along the second direction Y may be aligned in the second direction Y. For example, four columns of first pixel circuits may be arranged within one column of first sub-regions. In some examples, first pixel circuits within a plurality of second sub-regions arranged along the first direction X may be aligned in the first direction X, and first pixel circuits within a plurality of second sub-regions arranged along the second direction Y may be aligned in the second direction Y. For example, four columns of first pixel circuits may be arranged within one column of second sub-regions.

In some examples, a plurality of rows of first sub-regions and a plurality of rows of second sub-regions may be alternately arranged along the second direction Y, for example, the first sub-region may be located an i-th row and an (i+2)-th row, and the second sub-region may be located in an (i+1)-th row and an (i+3)-th row; the first pixel circuit 11c and the first pixel circuit 11d in the first sub-region may be substantially aligned with the first pixel circuit 11a and the first pixel circuit 11b in an adjacent second sub-region in the second direction Y, respectively.

In some examples, the fourth conductive layer may include a plurality of tenth connection electrodes 410 which may be substantially in a shape of a strip extending in the second direction Y. In the second direction Y, one end of the tenth connection electrode 410 is connected to the seventh connection electrode 407 located in the first sub-region, and another end is connected to the seventh connection electrode 407 located in the second sub-region. For example, description is given by taking the first sub-region located in an (i+2)-th row and the second sub-region located in an (i+1)-th row as an example, the seventh connection electrode 407 in the first pixel circuit 11c in the first sub-region can be electrically connected to the seventh connection electrode 407 in the first pixel circuit 11a in an adjacent second sub-region through the tenth connection electrode 410, and the seventh connection electrode 407 in the first pixel circuit 11d in the first sub-region can be electrically connected to the seventh connection electrode 407 in the first pixel circuit 11b in an adjacent second sub-region through the tenth connection electrode 410, so that the third initial signal line INIT3(i+1) in the (i+1)-th row is electrically connected to the third initial signal line INIT3(i+2) in the (i+2)-th row. In some examples, the tenth connection electrode 410 may be of an integrally formed structure with the seventh connection electrode 407 connected thereto. In the scheme according to an embodiment of the present disclosure, the third initial signal lines in two adjacent rows are connected together by the seventh connection electrode 407 and the tenth connection electrode 410 (for example, the third initial signal lines in an (i+1)-th row and an (i+2)-th row are electrically connected , and the third initial signal lines in an (i+3)-th row and an (i+4)-th row are electrically connected, so that the initial signals provided to the first pixel circuits in two adjacent rows are substantially consistent, and thus the display uniformity can be improved.

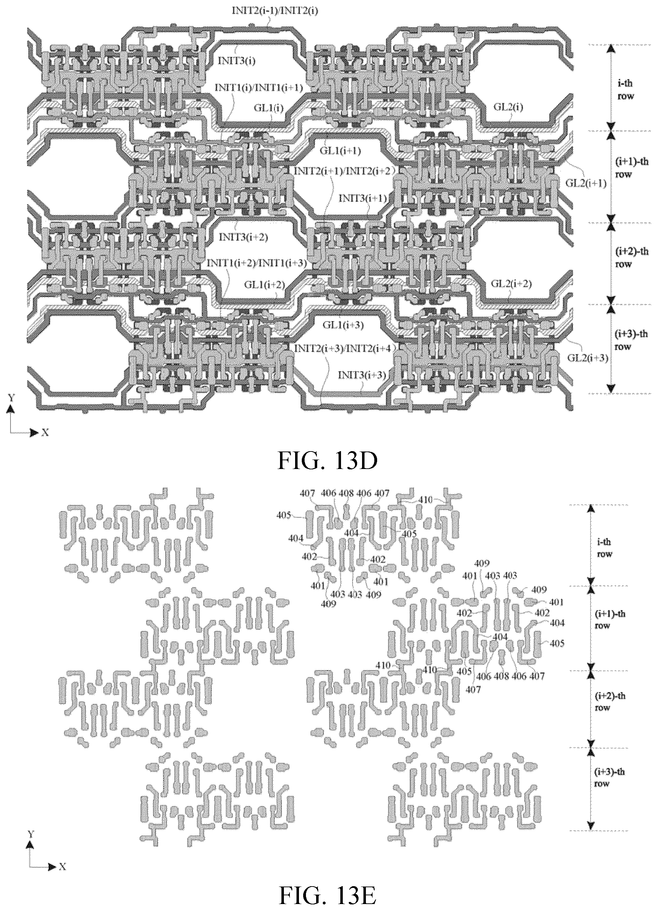

In other embodiments, FIG. 13D is a schematic diagram of the first display region after a fourth conductive layer is formed in FIG. 6. FIG. 13E is a schematic diagram of the fourth conductive layer in FIG. 13D. FIG. 13C is a schematic diagram of a first sub-region and a second sub-region in FIG. 13A. As shown in FIGS. 13D to 13F, the first pixel circuit 11a and the first pixel circuit 11b may not share one ninth connection electrode 409, and the first pixel circuit 11c and the first pixel circuit 11d may not share one ninth connection electrode 409, that is, the first pixel circuit 11a, the first pixel circuit 11b, the first pixel circuit 11c and the first pixel circuit 11d are electrically connected to four ninth connection electrodes 409, respectively.

(109) Forming a sixth insulation layer and a seventh insulation layer. In some examples, the sixth insulation thin film is deposited on the base substrate on which the aforementioned patterns are formed, and then the seventh insulation thin film is coated, and the seventh insulation thin film and the sixth insulation thin film are patterned through a patterning process to form the sixth insulation layer and the seventh insulation layer. In some examples, the sixth insulation layer may be referred to as a passivation layer and the seventh insulation layer may be referred to as a first planarization layer.

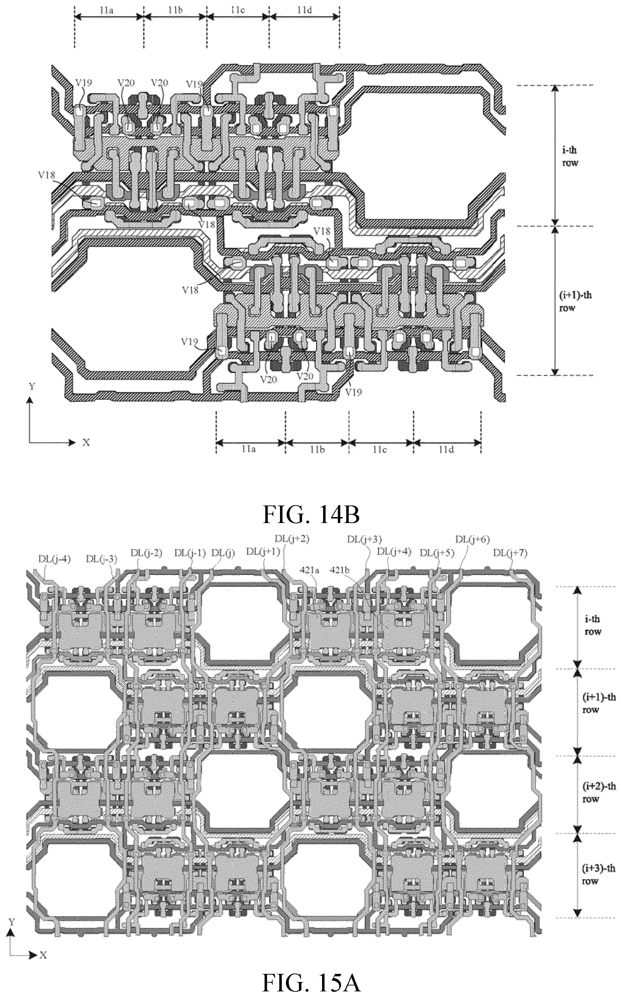

FIG. 14A is a schematic diagram of a first sub-region and a second sub-region after the seventh insulation layer is formed, and FIG. 14B is a schematic partial enlarged diagram of FIG. 14A. In some examples, as shown in FIGS. 14A and 14B, the seventh insulation layer of the first display region may be provided with a plurality of vias, for example, may include an eighteenth via V18 to a twentieth via V20. The seventh insulation layer and the sixth insulation layer in the eighteenth via V18 to the twentieth via V20 can be removed to expose a portion of a surface of the fourth conductive layer.

In some examples, an orthographic projection of the eighteenth via V18 on the base substrate is within the range of an orthographic projection of the first connection electrode 401 on the base substrate, and the seventh insulation layer and the sixth insulation layer within the eighteenth via V18 may be removed to expose a surface of the first connection electrode 401. The eighteenth via V18 is configured so that a data line formed subsequently is connected to the first connection electrode 401 through this via.

In some examples, an orthographic projection of the nineteenth via V19 on the base substrate is within the range of an orthographic projection of the fifth connection electrode 405 on the base substrate, and the seventh insulation layer and the sixth insulation layer within the nineteenth via V19 may be removed to expose a surface of the fifth connection electrode 405. The nineteenth via V19 is configured so that the first power supply connection electrode formed subsequently is connected to the fifth connection electrode 405 through this via. In some examples, in the first sub-region, the first sub-pixel 11b and the first sub-pixel 11c may share one nineteenth via V19; in the first sub-region, the first sub-pixel 11b and the first sub-pixel 11c may share one nineteenth via V19.

In some examples, an orthographic projection of the twentieth via V20 on the base substrate is within the range of an orthographic projection of the sixth connection electrode 406 on the base substrate, and the seventh insulation layer and the sixth insulation layer within the twentieth via V20 may be removed to expose a surface of the sixth connection electrode 406. The twentieth via V20 is configured so that the first anode connection electrode formed subsequently is connected to the sixth connection electrode 406 through this via.

(110) Forming a fifth conductive layer. In some examples, a fifth conductive thin film is deposited on the base substrate on which the aforementioned patterns are formed, the fifth conductive thin film is patterned by a patterning process to form a fifth conductive layer on the seventh insulation layer. In some examples, the fifth conductive layer may be referred to as a second source-drain metal layer.

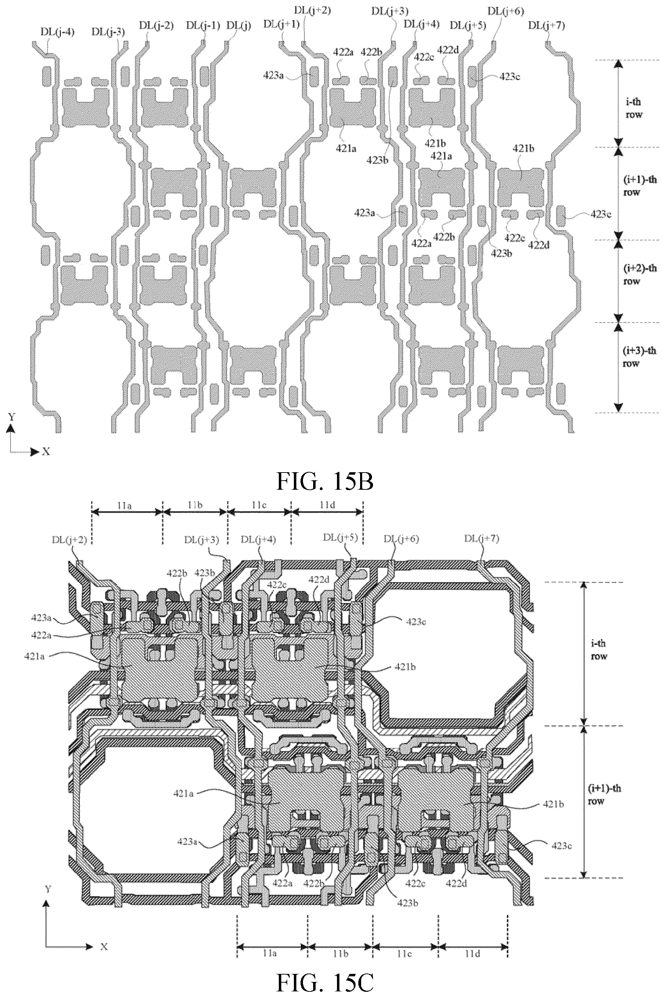

FIG. 15A is a schematic diagram of the first display region after a fifth conductive layer is formed. FIG. 15B is a schematic diagram of the fifth conductive layer in FIG. 15A. FIG. 15C is a schematic partial enlarged diagram in FIG. 15A.

In some examples, as shown in FIGS. 15A to 15C, the fifth conductive layer of the first display region may include at least a plurality of data lines (e.g., data lines DL(j-4), DL(j-3), DL(j-2), DL(j-1), DL(j), DL(j+1), DL(j+2), DL(j+3), DL(j+4), DL(j+5), DL(j+6), DL(j+7)), a plurality of first anode connection electrodes (e.g., first anode connection electrodes 422a, 422b, 422c, and 422d), a plurality of first power supply connection electrodes (e.g., first power supply connection electrodes 423a, 423b, and 423c) and a plurality of first shielding electrodes (e.g. first shielding electrodes 421a and 421b).

In some examples, the plurality of data lines may be substantially in a shape of a bending line extending in the second direction Y. Four first sub-pixels in each first sub-region are electrically connected to four data lines in one-to-one correspondence, and four first sub-pixels in each second sub-region are electrically connected to four data lines in one-to-one correspondence. The data line may be electrically connected to the corresponding first connection electrode 401 through the eighteenth via V18, thereby electrically connected to the fourth transistor of the first pixel circuit. For example, within the first sub-region, the data line DL(j+2) may be electrically connected to the corresponding first connection electrode 401 through the eighteenth via V18, thereby electrically connected to the fourth transistor of the first pixel circuit 11a, the data line DL(j+3) may be electrically connected to the first connection electrode 401 through the eighteenth via V18, thereby electrically connected to the fourth transistor of the first pixel circuit 11b, the data line DL(j+4) may be electrically connected to the fourth transistor of the first pixel circuit 11c, the data line DL(j+5) may be electrically connected to the fourth transistor of the first pixel circuit 11d; in the second sub-region, the data line DL(j+4) may be electrically connected to the corresponding first connection electrode 401 through the eighteenth via V18, thereby electrically connected to the fourth transistor of the first pixel circuit 11a, the data line DL(j+5) may be electrically connected to the first connection electrode 401 through the eighteenth via V18, thereby electrically connected to the fourth transistor of the first pixel circuit 11b, the data line DL(j+6) may be electrically connected to the fourth transistor of the first pixel circuit 11c, and the data line DL(j+7) may be electrically connected to the fourth transistor of the first pixel circuit 11d.

In some examples, two data lines electrically connected to two of the first pixel circuits within the first sub-region may be divided into two groups to bypass a fourth sub-region adjacent to the present first sub-region in the second direction Y, and data lines electrically connected to the other two first pixel circuits may extend to the second sub-region and may be electrically connected to two first pixel circuits in the second sub-region, respectively. For example, the data line DL(j+2) connected to the first pixel circuit 11a may bypass a fourth sub-region adjacent in the second direction Y from a side in an opposite direction of the first direction X; the data line DL(j+3) connected to the first pixel circuit 11b may bypass a fourth sub-region adjacent in the second direction Y from a side of the first direction X; the data line DL(j+4) connected to the first pixel circuit 11c may extend to the second sub-region in the second direction Y and is electrically connected to the first pixel circuit 11a in the second sub-region; the data line DL(j+5) connected to the first pixel circuit 11d may extend to the second sub-region in the second direction Y and be electrically connected to the first pixel circuit 11b in the second sub-region. In this example, the data line is configured to be bent to bypass the fourth sub-region, which is beneficial to reduce the occupied space of the lines, thereby improving the light transmittance of the first display region. In embodiments of the present disclosure, the first pixel circuit 11c in the first sub-region and the first pixel circuit 11a in the second sub-region share one data line, and the first pixel circuit 11d in the first sub-region and the first pixel circuit 11b in the second sub-region share one data line, so that the quantity of data lines can be reduced, which is beneficial to reduce the occupied space of the lines, and the light transmittance of the first display region is improved.

In some examples, two data lines electrically connected to two of the first pixel circuits within the second sub-region may be divided into two groups to bypass a third sub-region adjacent to the present first sub-region in the second direction Y, and data lines electrically connected to the other two first pixel circuits may extend to the first sub-region and may be electrically connected to two first pixel circuits in the first sub-region, respectively. For example, the data line DL(j+1) connected to the first pixel circuit 11d may bypass a third sub-region adjacent in the second direction Y from a side of the first direction X; the data line DL(j) connected to the first pixel circuit 11c may bypass a third sub-region adjacent in the second direction Y from a side in an opposite direction of the first direction X; the data line DL(j-1) connected to the first pixel circuit 11b may extend to the first sub-region in the second direction Y and is electrically connected to the first pixel circuit 11d in the first sub-region; the data line DL(j-2) connected to the first pixel circuit 11a may extend to the first sub-region in the second direction Y and be electrically connected to the first pixel circuit 11c in the first sub-region. In this example, the data line is configured to be bent to bypass the third sub-region, which is beneficial to reduce the occupied space of the line, thereby improving the light transmittance of the first display region. According to an embodiments of the present disclosure, the first pixel circuit 11c in the first sub-region and the first pixel circuit 11a in the second sub-region shares one data line, and the first pixel circuit 11d in the first sub-region and the first pixel circuit 11b in the second sub-region shares one data line, so that the quantity of data lines can be reduced, which is beneficial to reduce the occupied space of the lines, and the light transmittance of the first display region is improved.

In some examples, the first anode connection electrodes 422a, 422b, 422c and 422d may be substantially rectangular. In the first sub-region, the first anode connection electrode 422a and the first anode connection electrode 422b may be located between the data line DL(j+2) and the data line DL(j+3), and the first anode connection electrode 422c and the first anode connection electrode 422d may be located between the data line DL(j+4) and the data line DL(j+5). In the second sub-region, the first anode connection electrode 422a and the first anode connection electrode 422b may be located between the data line DL(j+4) and the data line DL(j+5), and the first anode connection electrode 422c and the first anode connection electrode 422d may be located between the data line DL(j+6) and the data line DL(j+7).

In some examples, the first anode connection electrode may be electrically connected to the sixth connection electrode 406 through the twentieth via V20. For example, the first anode connection electrode 422a may be electrically connected to the corresponding sixth connection electrode 406 through the twentieth via V20 thereby achieving an electrical connection to the sixth transistor of the corresponding first pixel circuit 11a; the first anode connection electrode 422b may be electrically connected to a corresponding sixth connection electrode 406 through the twentieth via V20 thereby achieving an electrical connection to a sixth transistor of the first pixel circuit 11b; the first anode connection electrode 422c may be electrically connected to a sixth transistor of the first pixel circuit 11c; the first anode connection electrode 422d may be electrically connected to a sixth transistor of the first pixel circuit 11d.

In some examples, the first power supply connection electrodes 423a, 423b and 423c may be substantially rectangular. In the first sub-region, in the first direction X, the first power supply connection electrode 423a may be located at a side of the data line DL(j+2) in an opposite direction of the first direction X, the first power supply connection electrode 423b may be located between the data lines DL(j+3) and DL(j+4), and the first power supply connection electrode 423c may be located between the data lines DL(j+5) and DL(j+6). In the second sub-region, in the first direction X, the first power supply connection electrode 423a may be located between the data lines DL(j+3) and DL(j+4), the first power supply connection electrode 423b may be located between the data lines DL(j+5) and DL(j+6), and the first power supply connection electrode 423c may be located at a side of the data line DL(j+5) in the first direction X.

In some examples, the first power supply connection electrode may be electrically connected with the fifth connection electrode 405 through the nineteenth via V19, thereby achieving an electrical connection to the fifth transistor and the storage capacitor of the first pixel circuit. For example, the first power supply connection electrode 423a may be electrically connected to the fifth connection electrode 405 through the nineteenth via V19 thereby achieving an electrical connection to the fifth transistor and the storage capacitor of the first pixel circuit 11a; the second power supply connection electrode 423b may be electrically connected to the corresponding fifth connection electrode 405 through the nineteenth via V19, thereby achieving an electrical connection to the fifth transistor and the storage capacitor of the first pixel circuits 11b and 11c; the third power supply connection electrode 423c may be electrically connected to the fifth transistor and the storage capacitor of the first pixel circuit 11d.

In some examples, within the first sub-region, the first shielding electrodes 421a and 421b may be substantially inverted n-shaped; within the second sub-region, the first shielding electrodes 421a and 421b may be substantially n-shaped. within the first sub-region, in the first direction X, the first shielding electrode 421a may be located between the data line DL(j+2) and the data line DL(j+3), and the first shielding electrode 421b may be located between the data line DL(j+4) and the data line DL(j+5); Within the second sub-region, in the first direction X, the first shielding electrode 421a may be located between the data line DL(j+4) and the data line DL(j+5), and the first shielding electrode 421b may be located between the data line DL(j+6) and the data line DL(j+7). An orthographic projection of the first shielding electrode 421a on the base substrate may cover an orthographic projection of the second connection electrode 402 on the base substrate, and shielding for the first node of the first pixel circuit 11a and the first node of the first pixel circuit 11b may be achieved, thereby shielding from the influence of remaining signals on the first nodes of the first pixel circuit 11a and the first pixel circuit 11b. The second shielding electrode 421b may achieve shielding for the first node of the first pixel circuit 11c and the first node of the first pixel circuit 11d, thereby shielding from the influence of the remaining signals on the first nodes of the first pixel circuit 11c and the first pixel circuit 11d.

(111) An eighth insulation layer is formed. In some examples, an eighth insulating thin film is coated on the base on which the aforementioned patterns are formed, and the eighth insulating thin film is patterned by a patterning process to form an eighth insulation layer. In some examples, the eighth insulation layer may be referred to as a second planarization layer.

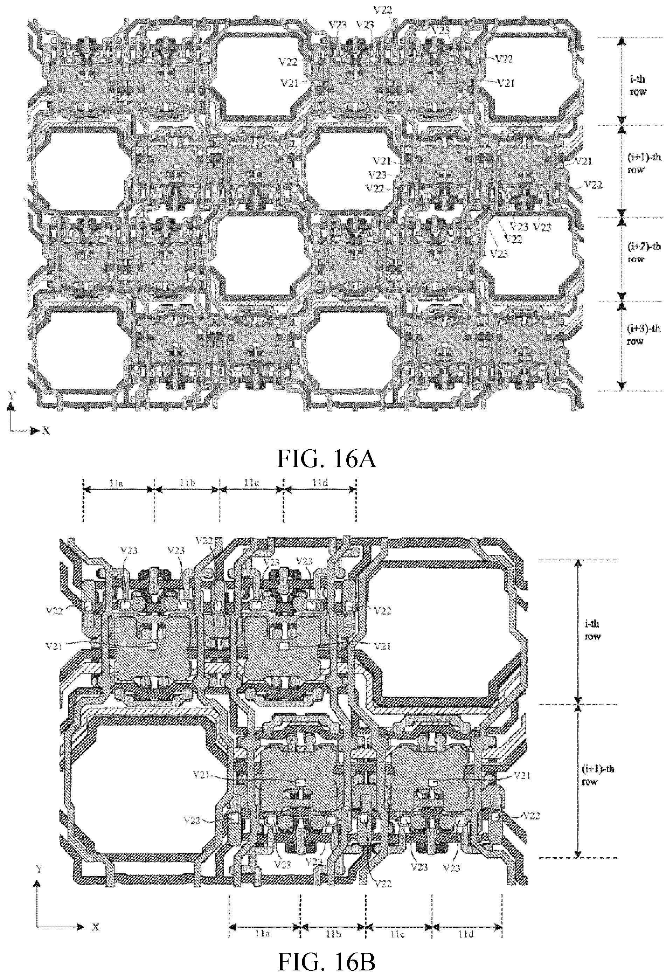

FIG. 16A is a schematic diagram of a first sub-region and a second sub-region after the eighth insulation layer is formed in FIG. 6, and FIG. 16B is a schematic partial enlarged diagram in FIG. 16A. In some examples, as shown in FIGS.

16A and 16B, the eighth insulation layer of the first display region may be provided with a plurality of vias, for example, may include a twenty-first via V21 to a twenty-third via V23. The eighth insulation layer in the twenty-first via V21 to the twenty-third via V23 may be removed to expose a portion of a surface of the fifth conductive layer.

In some examples, an orthographic projection of the twenty-first via V21 on the base substrate is within the range of an orthographic projection of the first shielding electrode on the base substrate, and the eighth insulation layer within the twenty-first via V21 may be removed to expose a surface of the first shielding electrode. The twenty-first via V21 is configured so that the first planarization electrode formed subsequently is connected to the first shielding electrode through this via.

In some examples, an orthographic projection of the twenty-second via V22 on the base substrate is within the range of an orthographic projection of the first power supply connection electrode on the base substrate, and the eighth insulation layer within the twenty-second via V22 may be removed to expose a surface of the first power supply connection electrode. The twenty-second via V22 is configured so that the first power supply line formed subsequently is connected to the first power supply connection electrode through this via.

In some examples, an orthographic projection of the twenty-third via V23 on the base substrate is within the range of an orthographic projection of the first anode connection electrode on the base substrate, and the eighth insulation layer within the twenty-third via V23 may be removed to expose a surface of the first anode connection electrode. The twenty-third via V23 is configured so that the second anode connection electrode formed subsequently is connected to the first anode connection electrode through this via.

(112) A sixth conductive layer is formed. In some examples, a sixth conductive thin film is deposited on the base substrate on which the aforementioned patterns are formed, the sixth conductive thin film is patterned by a patterning process to form a sixth conductive layer on the eighth insulation layer. **In** some examples, the sixth conductive layer may be referred to as a third source-drain metal layer.

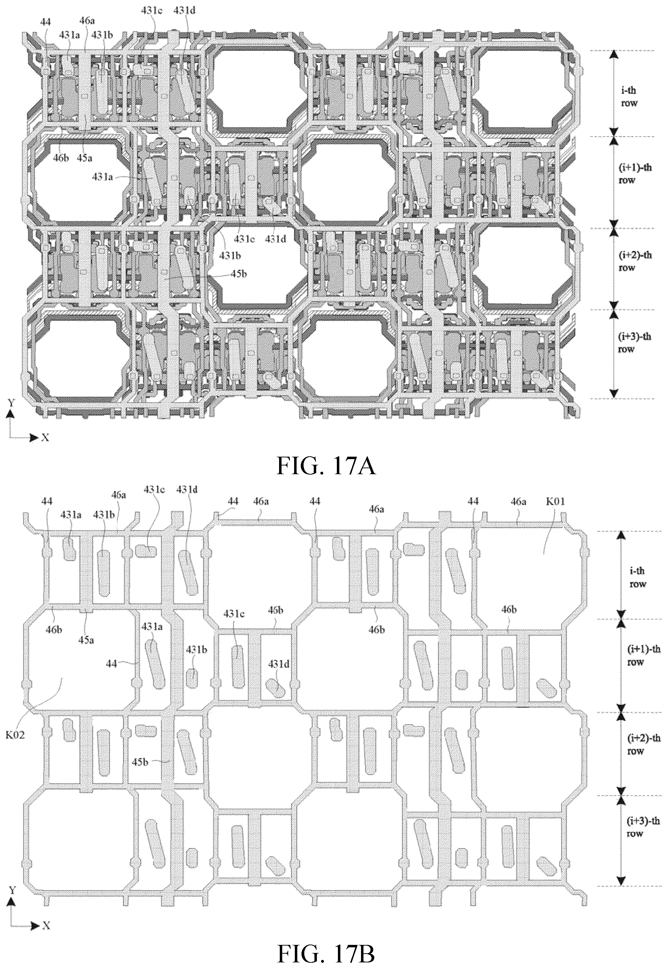

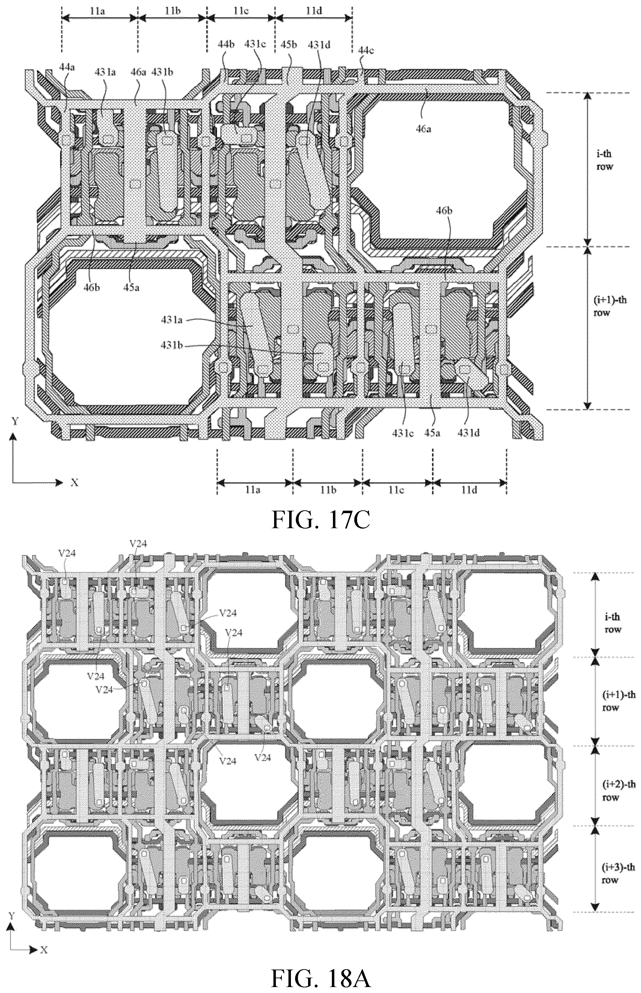

FIG. 17A is a schematic diagram of the first display region after the sixth conductive layer is formed. FIG. 17B is a schematic diagram of the sixth conductive layer in FIG. 17A. FIG. 17C is a schematic partial enlarged diagram in FIG. 17A.

**In** some examples, as shown in FIGS. 17A to 17C, the sixth conductive layer of the first display region may include at least a plurality of second anode connection electrodes (e.g., second anode connection electrodes 431a, 431b, 431c, and 431d), a plurality of first power supply lines (e.g., first power supply lines 44a, 44b, 44c), a plurality of first power supply connection lines (e.g., first power supply connection lines 45a, 45b), and a plurality of second power supply connection lines (e.g., second power supply connection lines 46a, 46b).

**In** some examples, the first power supply line may be substantially in a shape of a bending line extending in the second direction Y. **In** four first pixel circuits in each first sub-region, in the first direction X, two first pixel circuits located on two sides can be electrically connected with a first power supply line respectively, and two first pixel circuits located in the middle can be electrically connected with one of the first power supply lines; **In** four first pixel circuits in each second sub-region, in the first direction X, two first pixel circuits located on two sides may be electrically connected to a first power supply line respectively, and two first pixel circuits located in the middle may be electrically connected to one of the first power supply lines. The first power supply line may be electrically connected to a fifth transistor of the corresponding first pixel circuit through the twenty-second via V22. For example, in the first sub-region, the first power supply line 44a may be electrically connected to the first power supply connection electrode 423a through the twenty-second via V22, thereby achieving an electrical connection to the fifth transistor of the first pixel circuit 11a, the first power supply line 44b may be electrically connected to the first power supply connection electrode 423b through the twenty-second via V22, thereby achieving an electrical connection with the fifth transistor of the first pixel circuits 11b and 11c, and the first power supply line 44c may be electrically connected to the first power supply connection electrode 423c through the twenty-second via V22, thereby achieving an electrical connection with the fifth transistor of the first pixel circuit 11d; in the second sub-region, the first power supply line 44a may be electrically connected to the first power supply connection electrode 423c through the twenty-second via V22, thereby achieving an electrical connection with the fifth transistor of the first pixel circuit 11d, the first power supply line 44b may be electrically connected to the first power supply connection electrode 423b through the twenty-second via V22, thereby achieving an electrical connection with the fifth transistor of the first pixel circuits 11b and 11c, and the first power supply line 44c may be electrically connected to the first power supply connection electrode 423a through the twenty-second via V22, thereby achieving an electrical connection with the fifth transistor of the first pixel circuit 11a.

In some examples, two of the first power supply lines within the first sub-region may be divided into two groups to bypass a fourth sub-region adjacent to the first sub-region in the second direction Y and electrically connected to one of the first pixel circuits located at two ends in the second sub-region in the first direction X, and another first power supply line may extend to the second sub-region and may be electrically connected to two first pixel circuits located in the middle in the second sub-region in the first direction X. For example, within the first sub-region, the first power supply line 44a connected to the first pixel circuit 11a may bypass a fourth sub-region adjacent in the second direction Y from a side in an opposite direction of the first direction X and be electrically connected to the first pixel circuit 11c in the second sub-region; the first power supply line 44b connected to the first pixel circuit 11b and the first pixel circuit 11c may bypass a fourth sub-region adjacent in the second direction Y from a side of the first direction X and be electrically connected to the first pixel circuit 11a in the second sub-region; the first power supply line 44c connected to the first pixel circuit 11d may extend to the second sub-region in the second direction Y and be electrically connected to the first pixel circuit 11b and the first pixel circuit 11c in the second sub-region; In this example, the data line is configured to be bent to bypass the fourth sub-region, which is beneficial to reduce the occupied space of the line and reduce the shielding for the fourth sub-region, thereby improving the light transmittance of the first display region. Three first power supply lines located in the first sub-region do not overlap an orthographic projection of the third sub-region adjacent to the present first sub-region in the first direction X on the base substrate, so that the third sub-region is not shielded, and the light transmittance of the first display region can be improved.

In some examples, the first power supply connection line 45a may be substantially in a shape of a strip extending in the second direction Y. In the first sub-region, the first power supply connection line 45a may be electrically connected to the first shielding electrode 421a through the twenty-first via V21; in the second sub-region, the first power supply connection line 45a may be electrically connected to the first shielding electrode 421b through the twenty-first via V21.

In some examples, the shape of the first power supply connection line 45b may be substantially in a shape of a bending line extending in the second direction Y. In the first sub-region, the first power supply connection line 45b is electrically connected to the first shielding electrode 421b through the twenty-first via V21, and in the second sub-region, the first power supply connection line is electrically connected to the first shielding electrode 421a through the twenty-first via V21, and a plurality of first shielding electrodes 421b and first shielding electrodes 421a located in the same column can be electrically connected to the same first power supply connection line 45b.

In some examples, the second power supply connection lines 46a, 46b are in a shape of a bending line extending along the first direction X, and in a second direction Y, the second power supply connection lines 46a and 46b are located substantially at two ends of the first power supply connection line 45a in the first sub-region and the second sub-region, respectively, and are integrally formed with the first power supply connection lines 45a, 45b and the first power supply lines 44a, 44b, 44c. The second power supply connection lines 46a, 46b and the first power supply lines (44a, 44b, 44c) and the first power supply connection lines (45a, 54b) are connected to each other to form a grid-like structure so that the power supply signals provided by the first power supply lines 44 to the display substrate are as consistent as possible. In the first sub-region and the second sub-region, the second power supply connection lines 46a, 46b and the first power supply connection lines (45a, 45b) and the first power supply lines (44a, 44b, 44c) are connected to each other to form four accommodation regions for accommodating four second anode connection electrodes 431a, 431b, 431c and 431d in the first sub-region and the second sub-region, respectively. In an exemplary embodiment, in the second direction, the second power supply connection lines 46a, 46b bypass along two sides of the third sub-region such that the second power supply connection lines 46a, 46b and the first power supply connection lines 45a, 45b form a first hollowed area K01 in the third sub-region, an orthographic projection of the first hollowed area K01 on the base substrate at least partially overlaps an orthographic projection of the third sub-region on the base substrate, avoiding the third sub-region being blocked by the second power supply connection lines 46a, 46b and the first power supply connection lines 45a, 45b; in the second direction, the second power supply connection lines 46a, 46b bypass along two sides of the fourth sub-region such that the second power supply connection lines 46a, 46b and the first power supply connection lines 45a, 45b form a second hollowed area K02 in the fourth sub-region, an orthographic projection of the second hollowed area K02 on the base substrate at least partially overlaps an orthographic projection of the fourth sub-region on the base substrate, avoiding the fourth sub-region being shielded by the second power supply connection lines 46a, 46b and the first power supply connection lines 45a, 45b.

In some examples, the second anode connection electrode 431a may be electrically connected to the first anode connection electrode 422a through the twenty-third via V23 to achieve an electrical connection to a sixth transistor of the first pixel circuit 11a; within the first sub-region, the second anode connection electrode 431a may be substantially in a shape of a rectangle extending in the second direction Y, and in the first direction X, the second anode connection electrode 431a may be located between the first power supply line 44a and the first planarization electrode 45a; within the second sub-region, the second anode connection electrode 431a may be substantially in a shape of a rectangle extending in a direction intersecting both the first direction X and the second direction Y, and in the first direction X, the second anode connection electrode 431a may be located between the first power supply line 44b and the first planarization electrode 45b.

In some examples, the second anode connection electrode 431b may be electrically connected to the first anode connection electrode 422b through the twenty-third via V23 to achieve an electrical connection to the sixth transistor of the first pixel circuit 11b; within the first sub-region, the second anode connection electrode 431b may be substantially in a shape of a rectangle extending in the second direction Y, and in the first direction X, the second anode connection electrode 431b may be located between the first power supply line 44b and the first planarization electrode 45a; within the second sub-region, the second anode connection electrode 431b may be substantially in a shape of a rectangle extending in the second direction Y, and in the first direction X, the second anode connection electrode 431b may be located between the first power supply line 44c and the first planarization electrode 45b.

In some examples, the second anode connection electrode 431c may be electrically connected to the first anode connection electrode 422c through the twenty-third via V23 to achieve an electrical connection to a sixth transistor of the first pixel circuit 11c; within the first sub-region, the second anode connection electrode 431c may be substantially in a shape of a rectangle extending in the first direction X, in the first direction X, the second anode connection electrode 431c may be located between the first power supply line 44b and the first planarization electrode 45b; within the second sub-region, the second anode connection electrode 431c may be substantially in a shape of a rectangle extending in the second direction Y, and in the first direction X, the second anode connection electrode 431c may be located between the first power supply line 44c and the first planarization electrode 45a.

**In** some examples, the second anode connection electrode 431d may be electrically connected with the first anode connection electrode 422d through the twenty-third via V23 to achieve an electrical connection with the sixth transistor of the first pixel circuit 11d; within the first sub-region, the second anode connection electrode 431d may be substantially in a shape of a rectangle extending in a direction intersecting both the first direction X and the second direction Y, in the first direction X, the second anode connection electrode 431d may be located between the first power supply line 44c and the first planarization electrode 45b; in the second sub-region, the second anode connection electrode 431d may be substantially in a shape of a rectangle extending in a direction intersecting both the first direction X and the second direction Y, and in the first direction X, the second anode connection electrode 431d may be located between the first power supply line 44a and the first planarization electrode 45a.

(113) A ninth insulation layer is formed. In some examples, a ninth insulation thin film is coated on the base substrate on which the aforementioned patterns are formed, and the ninth insulation thin film is patterned by a patterning process to form a ninth insulation layer. In some examples, the ninth insulation layer may be referred to as a third planarization layer.

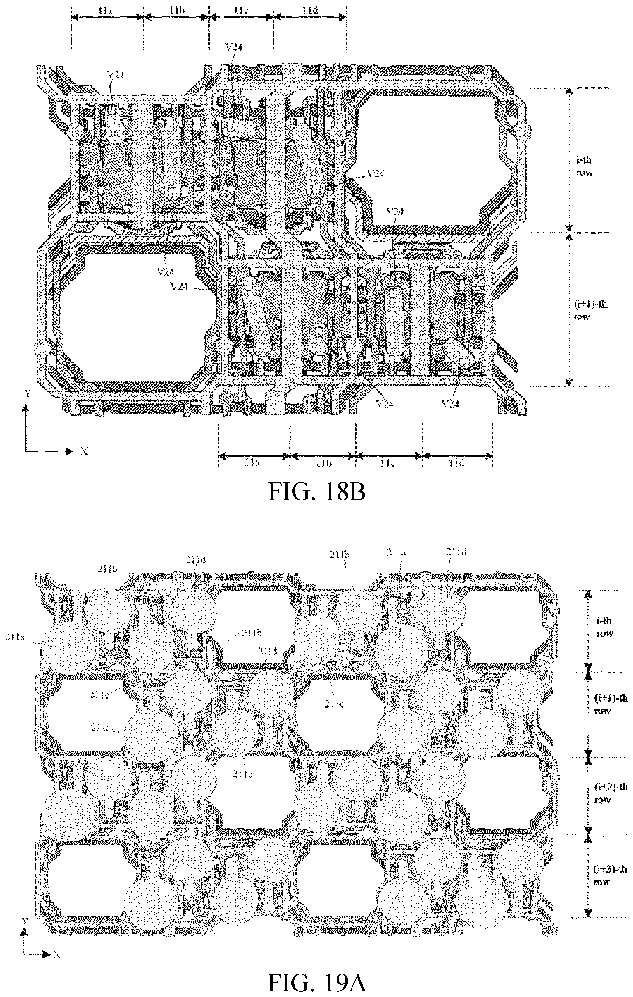

FIG. 18A is a schematic diagram of the first display region after the ninth insulation layer is formed, and FIG. 18B is a schematic partial enlarged diagram in FIG. 18A. In some examples, as shown in FIGS. 18A and 18B, the ninth insulation layer of the first display region may be provided with a plurality of vias, for example, which may include a plurality of twenty-fourth vias V24. The ninth insulation layer in the twenty-fourth via V24 can be removed to expose a portion of a surface of the sixth conductive layer.

In some examples, an orthographic projection of the twenty-fourth via V24 on the base substrate is within the range of an orthographic projection of the second anode connection electrode on the base substrate, and the ninth insulation layer within the twenty-fourth via V24 may be removed to expose a surface of the second anode connection electrode. The twenty-fourth via V24 is configured so that the second anode connection electrode formed subsequently is connected to the second anode connection electrode through this via.

So far, the circuit structure layer can be prepared. The film layer structure of the circuit structure layer of the second display region is similar to the film layer structure of the first display region, and therefore, it will not be repeated here.

In an exemplary embodiment, after the circuit structure layer is prepared, a light emitting structure layer is prepared on the circuit structure layer, and the preparation process of the light emitting structure layer may include the following operations: forming a pattern of a fourth planarization layer, at least an anode via is provided on the fourth planarization layer; forming a pattern of an anode (i.e., an anode conductive layer), and the anode is connected with an anode connection electrode through the anode via; forming a pixel definition layer, wherein a pixel opening is provided on the pixel definition layer, and the pixel opening exposes an anode; forming an organic light emitting layer using an evaporation or inkjet printing process, and the organic light emitting layer is connected with the anode through the pixel opening to form a cathode on the organic light emitting layer; forming an encapsulation layer, the encapsulation layer may include a first encapsulation layer, a second encapsulation layer and a third encapsulation layer which are stacked, the first encapsulation layer and the third encapsulation layer may be made of an inorganic material, the second encapsulation layer may be made of an organic material, and the second encapsulation layer is arranged between the first encapsulation layer and the third encapsulation layer to ensure that external water vapor cannot enter the light emitting structure layer. The acts of forming the anode conductive layer and the pixel definition layer are as follows:

(114) Forming an anode conductive layer. In some examples, a tenth insulation thin film is coated on the base substrate on which the aforementioned patterns are formed, and the tenth insulation thin film is patterned by a patterning process to form a tenth insulation layer, which may be referred to as a fourth planarization layer in some examples. The tenth insulation layer may be provided with a plurality of anode vias, the plurality of anode vias may expose a portion of a surface of the conductive connection layer, and orthographic projections of the plurality of anode vias on the base substrate are respectively at least partially overlap orthographic projections of the plurality of twenty-fourth vias V24 on the base substrate. Subsequently, an anode thin film is deposited on the base substrate on which the aforementioned patterns are formed, and the anode thin film is patterned through a patterning process to form an anode conductive layer.

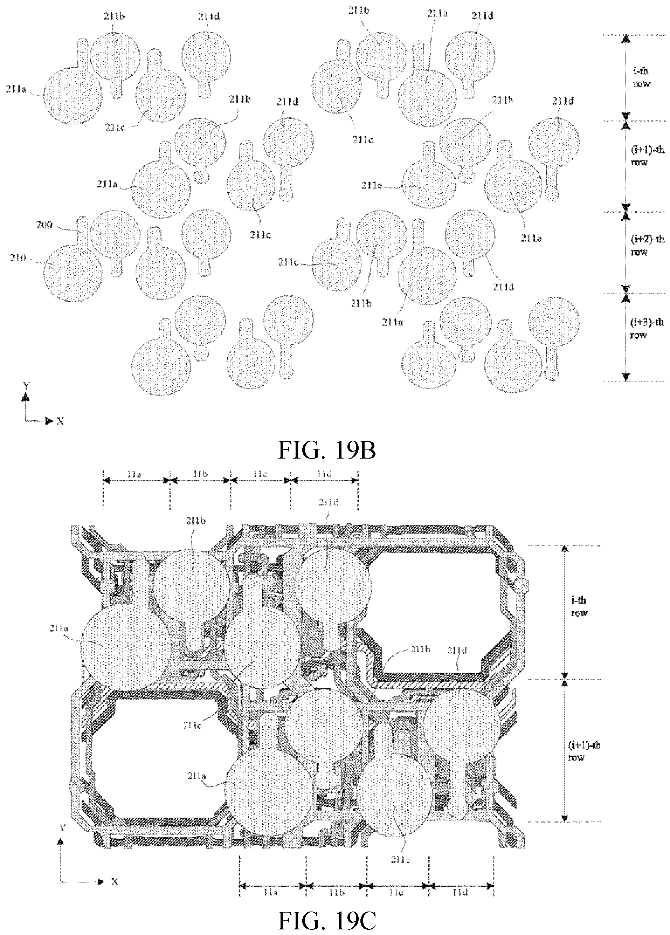

FIG. 19A is a schematic diagram of the first display region after the anode layer is formed. FIG. 19B is a schematic diagram of the anode conductive layer in FIG. 19A. FIG. 19C is a schematic partial enlarged diagram in FIG. 19A.

In some examples, as shown in FIGS. 19A to 19C, the first display region may include anodes of a plurality of light emitting elements (e.g., an anode 211a of the light emitting element, an anode 211b of the light emitting element, an anode 211c of the light emitting element, an anode 211d of the light emitting element).

In some examples, in the first sub-region and the second sub-region, the anode 211a of the light emitting element emitting light of a first color may be electrically connected to the second anode connection electrode 431a through an anode via on the tenth insulation layer and a twenty-fourth via V24 opened in the ninth insulation layer. The anode 211b of the light emitting element emitting light of a second color may be electrically connected to the second anode connection electrode 431b through an anode via on the tenth insulation layer and a twenty-fourth via V24 opened in the ninth insulation layer. The anode 211c of the light emitting element emitting light of a third color may be electrically connected to the second anode connection electrode 431c through an anode via on the tenth insulation layer and a twenty-fourth via V24 opened in the ninth insulation layer. The anode 211d of the light emitting element emitting light of a fourth color may be electrically connected to the second anode connection electrode 431d through an anode via on the tenth insulation layer and a twenty-fourth via V24 opened in the ninth insulation layer. In another first sub-region and second sub-region adjacent to one of the first sub-region and the second sub-region in the row direction, respectively, the anode 211a of the light emitting element emitting light of a first color may be electrically connected to the second anode connection electrode 431c through an anode via on the tenth insulation layer and a twenty-fourth via V24 opened in the ninth insulation layer. The anode 211b of the light emitting element emitting light of a second color may be electrically connected to the second anode connection electrode 431b through an anode via on the tenth insulation layer and a twenty-fourth via V24 opened in the ninth insulation layer. The anode 211c of the light emitting element emitting light of a third color may be electrically connected to the second anode connection electrode 431a through an anode via on the tenth insulation layer and a twenty-fourth via V24 opened in the ninth insulation layer. The anode 211d of the light emitting element emitting light of a fourth color may be electrically connected to the second anode connection electrode 431d through an anode via on the tenth insulation layer and a twenty-fourth via V24 opened in the ninth insulation layer.

In an exemplary embodiment, an area of the anode 211a of the light emitting element emitting light of a first color may be larger than an area of the anode 211b of the light emitting element emitting light of a second color and an area of the anode 211d of the light emitting element emitting light of a fourth color, and an area of the anode 211c of the light emitting element emitting light of a third color may be smaller than an area of the anode 211a of the light emitting element emitting light of a first color, larger than an area of the anode 211b of the light emitting element emitting light of a second color and an area of the anode 211d of the light emitting element emitting light of a fourth color. In an exemplary embodiment, an area of the anode 211b of the light emitting element emitting light of a second color and an area of the anode 211d of the light emitting element emitting light of a fourth color may be equal. In an exemplary embodiment, the light emitting element emitting light of a first color may be a light emitting element B emitting blue light, the light emitting element emitting light of a second color and the light emitting element emitting light of a fourth color may be a light emitting element G emitting green light, and the light emitting element emitting light of a third color may be a light emitting element R emitting red light.

In some examples, the anode of the light emitting element may include a body part 210 and a connection part 200, the connection part 212 is disposed on a side of the body part 210 and is of an integrally formed structure with the body part 210, and the connection part 200 is electrically connected with a corresponding second anode connection electrode through an anode via on the tenth insulation layer and a twenty-fourth via V24 opened in the ninth insulation layer. The body part 210 of the anode may be circular or elliptical and the connection part 200 may be substantially of a strip structure extending in one of the directions. In an exemplary embodiment of the present disclosure, the body part 210 is connected to the corresponding second anode connection electrode through the connection part 200, so that an orthographic projection of the body part 210 of the anode on the base substrate and orthographic projections of the anode via and the twenty-fourth via on the base substrate do not overlap, the flatness of the anode body part 210 can be avoided from decreasing due to the vias, and the flatness of the body part 210 of the anode can be improved.

(115) Forming a pixel definition layer. In some examples, a pixel definition thin film is coated on the base substrate on which the aforementioned patterns are formed, and a pixel definition layer is formed through mask, exposure, and development processes. The pixel definition layer may be formed with multiple pixel openings exposing the anode layer.

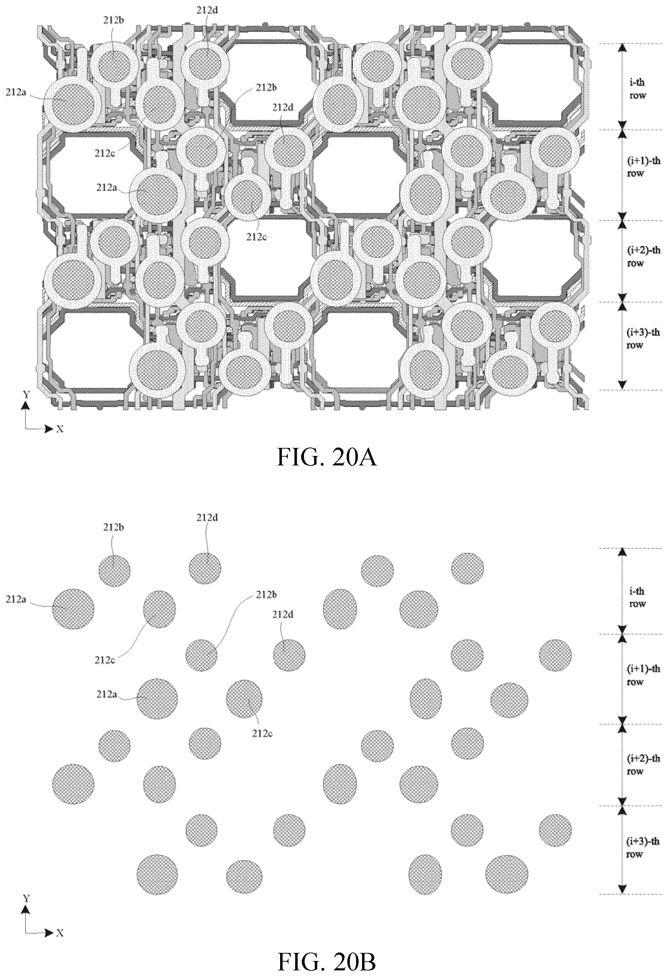

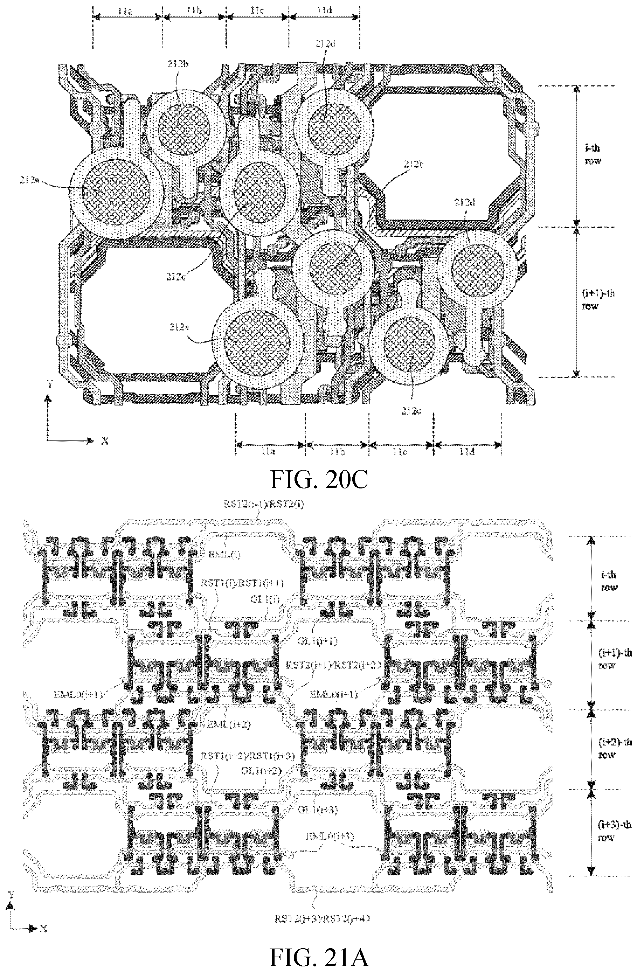

FIG. 20A is a schematic diagram of the first display region after a pixel definition layer is formed. FIG. 20B is a schematic diagram of the pixel definition layer in FIG. 20A. FIG. 20C is a schematic partial enlarged diagram in FIG. 20A.

In some examples, as shown in FIGS. 20A to 20C, the first display region may include a plurality of pixel openings (e.g., a pixel opening 212a, a pixel opening 212b, a pixel opening 212c, a pixel opening 212d). An orthographic projection of the pixel opening 212a on the base substrate at least partially overlaps an orthographic projection of the corresponding anode 211a on the base substrate, an orthographic projection of the pixel opening 212b on the base substrate at least partially overlaps an orthographic projection of the corresponding anode 211b on the base substrate, an orthographic projection of the pixel opening 212c on the base substrate at least partially overlaps an orthographic projection of the corresponding anode 211c on the base substrate, and an orthographic projection of the pixel opening 212d on the base substrate at least partially overlaps an orthographic projection of the corresponding anode 211d on the base substrate. For example, an orthographic projection of the pixel opening 212a on the base substrate is within the range of an orthographic projection of the body part 210 of the corresponding anode 211a on the base substrate, and a portion of a surface of the body part 210 of the anode 211a can be exposed. An orthographic projection of the pixel opening 212b on the base substrate is within the range of an orthographic projection of the body part 210 of the corresponding anode 211b on the base substrate, and a portion of a surface of the body part 210 of the anode 211b can be exposed. An orthographic projection of the pixel opening 212c on the base substrate is within the range of an orthographic projection of the body part 210 of the corresponding anode 211c on the base substrate, and a portion of a surface of the body part 210 of the anode 211c can be exposed. An orthographic projection of the pixel opening 212d on the base substrate is within the range of an orthographic projection of the body part 210 of the corresponding anode 211d on the base substrate, and a portion of a surface of the body part 210 of the anode 211d can be exposed.

In some examples, the pixel opening may be substantially circular or elliptical.

In some examples, the subsequent acts may include forming an organic light emitting layer within the pixel openings formed above, and the organic emitting layer is connected with the anode layer. Subsequently, a cathode thin film is deposited, and the cathode thin film is patterned through a patterning process to form a pattern of a cathode, and the cathode is connected with the organic emitting layer.

In some examples, a light emitting area of the light emitting element emitting light of a first color may be larger than a light emitting area of the light emitting element emitting light of a third color. A light emitting area of the light emitting element emitting light of a third color may be larger than a light emitting area of the light emitting element emitting light of a second color or the light emitting element emitting light of a fourth color. A light emitting area of the light emitting element emitting light of a second color and the light emitting element emitting light of a fourth color may be the same, and the light of the second color and the light of the fourth color may be the same. A light emitting area of the light emitting element of the present example may refer to an area of a region where the anode exposed by the pixel opening of the pixel definition layer and the organic light emitting layer and the cathode are overlapped.

In some examples, after preparation of the light emitting structure layer, an encapsulation layer may be formed on the cathode and the encapsulation layer may include a stacked structure of an inorganic material/an organic material/an inorganic material.

In some examples, the first conductive layer, the second conductive layer, the third conductive layer, the fourth conductive layer, the fifth conductive layer, and the sixth conductive layer may be made of a metal material such as any one or more of silver (Ag), copper (Cu), aluminum (Al), and molybdenum (Mo), or an alloy material of the above metals, such as an aluminum-neodymium alloy (AlNd) or a molybdenum-niobium alloy (MoNb), may be of a single-layer structure or a multi-layer composite structure such as Mo/Cu/Mo, etc. The first insulation layer, the second insulation layer, the third insulation layer, the fourth insulation layer, the fifth insulation layer and the sixth insulation layer may be made of any one or more of Silicon Oxide (SiOx,x>0), Silicon Nitride (SiNy,y>0), and Silicon OxyNitride (SiON), and may be a single layer, a multi-layer, or a composite layer. The seventh insulation layer, the eighth insulation layer and the ninth insulation layer may be made of an organic material, such as polyimide, acrylic, or polyethylene terephthalate. The pixel definition layer may be made of an organic material, such as polyimide, acrylic, or polyethylene terephthalate. The anode layer may be made of a reflective material such as a metal, and the cathode may be made of a transparent conductive material. However, the embodiment is not limited thereto.

A structure and a manufacturing process of the display substrate of this embodiment are merely illustrative. In some exemplary implementation, a corresponding structure may be changed and a patterning process may be added or removed according to actual needs. The manufacturing process of the exemplary embodiment may be implemented using an existing mature manufacturing device, and may be compatible well with an existing manufacturing process, simple in process implementation, easy to implement, high in a production efficiency, low in a production cost, and high in yield. The display substrate according to embodiments of the present disclosure may be applied to other display devices having pixel drive circuits, such as quantum dot displays and the like, which is not limited in the present disclosure.

In other embodiments, the preparation process of the display substrate is substantially the same as that of the above acts (101) to (115), the difference lies in the first conductive layer formed in the act (103), the third conductive layer formed in the act (106), the fifth insulation layer formed in the act (107), and the fourth conductive layer formed in the act (108). The differences between the first conductive layer, the third conductive layer, the fifth insulation layer and the fourth conductive layer from the above embodiments are described in detail below in connection with FIGS. 21A to 24C.

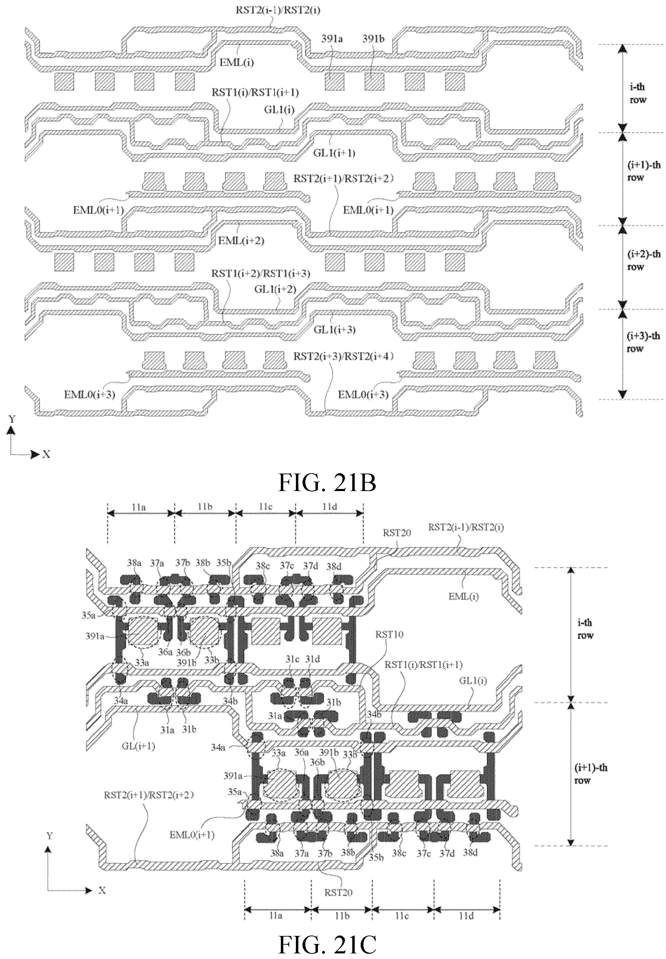

In an exemplary embodiment, as shown in FIG. 21A, which is a schematic diagram of a planar structure after the first conductive layer is formed and FIG. 21B is a schematic diagram of the first conductive layer in FIG. 21A. FIG. 21C is a schematic partial enlarged diagram in FIG. 21A. As shown in FIGS. 21A to 21C, the difference from FIGS. 8A to 8C is that the light emitting control line EML(i+1) in the (i+1)-th row and the light emitting control line EML(i+3) in the (i+3)-th row are disconnected at a position of the fourth sub-region to form and the light emitting control electrodes EMLO (i+1) and EMLO (i+3).

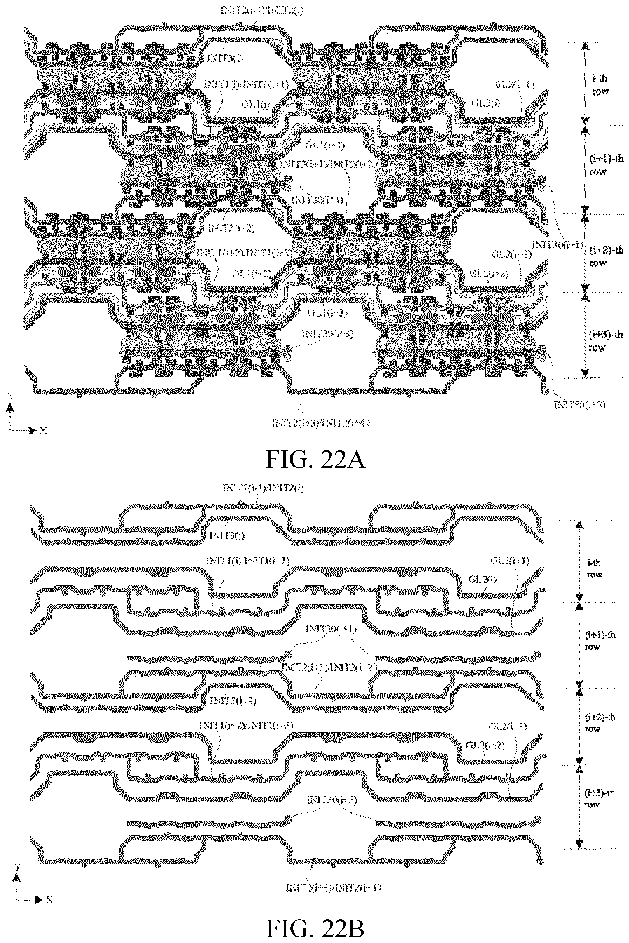

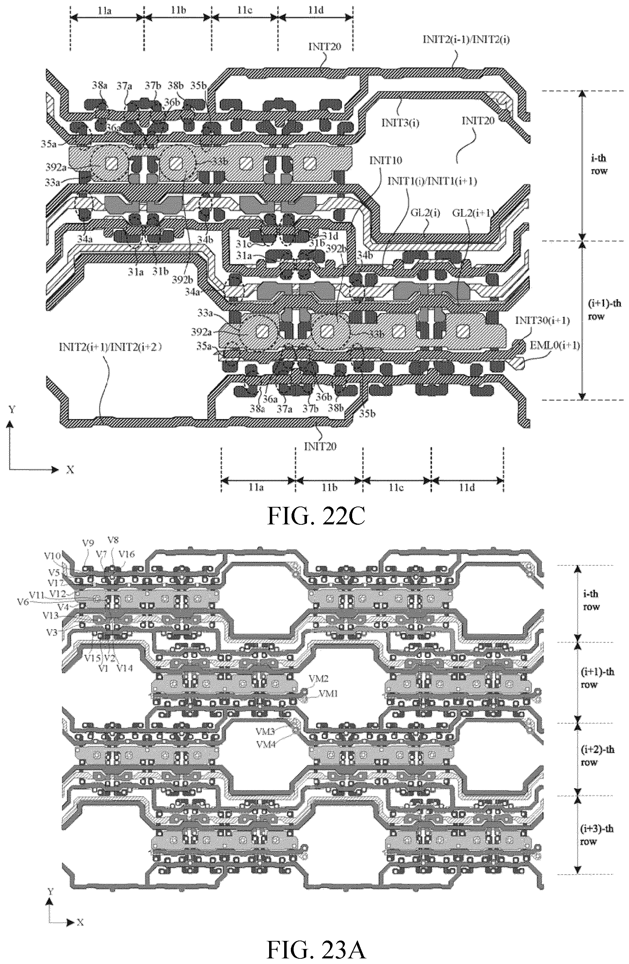

In an exemplary embodiment, as shown in FIG. 22A, which is a schematic diagram of a planar structure after the third conductive layer is formed, and FIG. 22B is a schematic diagram of the third conductive layer in FIG. 22A. FIG. 22C is a schematic partial enlarged diagram in FIG. 22A. As shown in FIGS. 22A to 22C, the difference from FIGS. 11A to 11C is that the third initial signal line INIT3(i+1) in the (i+1)-th row and the third initial signal line INIT3(i+3) in the (i+3)-th row are disconnected at a position of the fourth sub-region to form the third initial signal electrodes INIT30 (i+1) and INIT30 (i+3). In an exemplary embodiment, there are an overlapping region and a non-overlapping region between an orthographic projection of the third initial signal electrode INIT30 (i+1) on the base substrate and an orthographic projection of the light emitting control electrode EMLO (i+1) on the base substrate; there are an overlapping region and a non-overlapping region between an orthographic projection of the third initial signal electrode INIT30 (i+3) on the base substrate and an orthographic projection of the light emitting control electrode EMLO (i+3) on the base substrate. For example, there is an overlapping region between an orthographic projection of the body part of the third initial signal electrode INIT30 (i+1) on the base substrate and an orthographic projection of the body part of the light emitting control electrode EMLO (i+1) on the base substrate, and an orthographic projection of at least one end of the third initial signal electrode INIT30 (i+1) on the base substrate and an orthographic projection of at least one end of the light emitting control electrode EMLO (i+1) on the base substrate do not overlap; there is an overlapping region between an orthographic projection of the body part of the third initial signal electrode INIT30 (i+3) on the base substrate and an orthographic projection of the body part of the light emitting control electrode EMLO (i+3) on the base substrate, and an orthographic projection of at least one end of the third initial signal electrode INIT30 (i+3) on the base substrate and an orthographic projection of at least one end of the light emitting control electrode EMLO (i+3) on the base substrate do not overlap. In an exemplary embodiment, there are an overlapping region and a non-overlapping region between an orthographic projection of the third initial signal line INIT30 (i) on the base substrate and an orthographic projection of the light emitting control line EML(i) on the base substrate, and there are an overlapping region and a non-overlapping region between an orthographic projection of the third initial signal line INIT30 (i+2) on the base substrate and an orthographic projection of the light emitting control line EML(i+2) on the base substrate; the non-overlapping region between an orthographic projection of the third initial signal line INIT3(i) on the base substrate and an orthographic projection of the light emitting control line EML(i) on the base substrate, and the non-overlapping region between an orthographic projection of the third initial signal electrode INIT30 (i-1) on the base substrate and an orthographic projection of the light emitting control electrode EMLO (i-1) on the base substrate are located at a same side of the third sub-region along the first direction X and at a same side of the fourth sub-region along the first direction X; the non-overlapping region between an orthographic projection of the third initial signal line INIT30 (i+2) on the base substrate and an orthographic projection of the light emitting control line EML(i+2) on the base substrate, and the non-overlapping region between an orthographic projection of the third initial signal electrode INIT30 (i+1) on the base substrate and an orthographic projection of the light emitting control electrode EMLO (i+1) on the base substrate are located at a same side of the third sub-region along the first direction X and at a same side of the fourth sub-region along the first direction X.

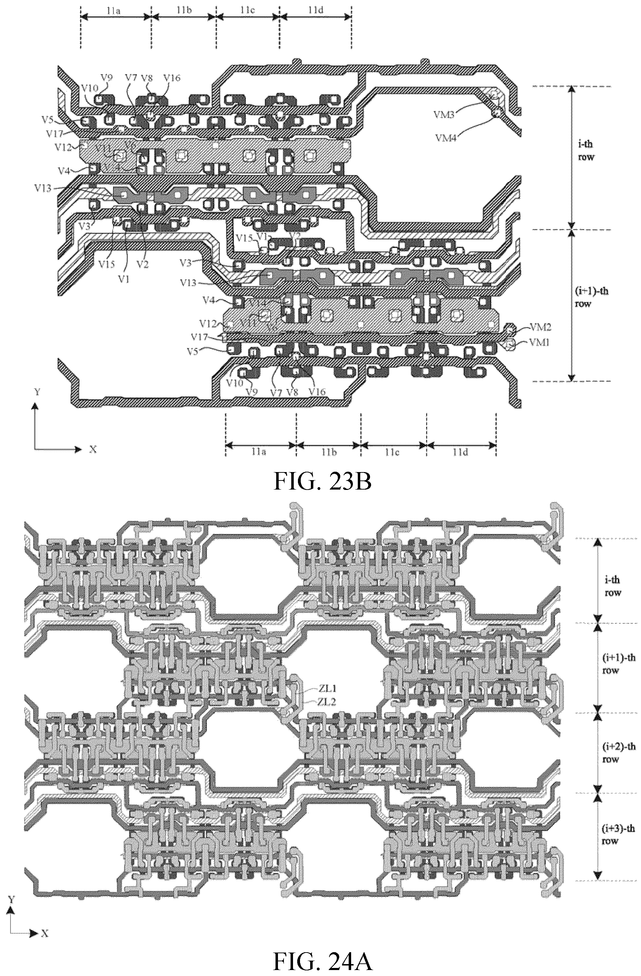

In an exemplary embodiment, as shown in FIG. 23A, which is a schematic diagram of a planar structure after the fifth insulation layer is formed, FIG. 23B is a schematic partial enlarged diagram in FIG. 23A. As shown in FIGS. 23A to 23B, the difference from FIGS. 12A to 12B is that a first transfer via VM1, a second transfer via VM2, a third transfer via VM3, and a fourth transfer via VM4 are newly added. In an exemplary embodiment, an orthographic projection of the first transfer via VM1 on the base substrate is within the range of orthographic projections of the light emitting control electrodes EMLO (i+1), EMLO (i+3) on the base substrate, the fifth insulation layer, the fourth insulation layer, the third insulation layer and the second insulation layer within the first transfer via VM1 can be removed to expose the surfaces of the light emitting control electrodes EMLO (i+1), EMLO (i+3), the first transfer via VM1 is configured so that the first transfer electrode formed subsequently is electrically connected to the corresponding light emitting control electrode through this via; an orthographic projection of the second transfer via VM2 on the base substrate is within the range of an orthographic projection of the third initial signal electrodes INIT30 (i+1) and INIT30 (i+3) on the base substrate, the fifth insulation layer in the second transfer via VM2 can be removed to expose the surfaces of the third initial signal electrodes INIT30 (i+1) and INIT30 (i+3), the second transfer via VM2 is configured such that the subsequently formed second transfer electrode is electrically connected to the third initial signal electrodes INIT30 (i+1) and INIT30 (i+3) through this via; an orthographic projection of the third transfer via VM3 on the base substrate is within the range of orthographic projections of the light emitting control electrode EML(i+2) in the i-th row and the light emitting control line EML(i+2) in the (i+2)-th row on the base substrate, the fifth insulation layer, the fourth insulation layer, the third insulation layer and the second insulation layer in the third transfer via VM3 can be removed to expose the surfaces of the light emitting control line EML(i) in the i-th row and the light emitting control line EML(i+2) in the (i+2)-th row, the third transfer via VM3 is configured such that the first transfer electrode formed subsequently is electrically connected with the corresponding light emitting control line EML(i) in the i-th row and the light emitting control line EML(i+2) in the (i+2)-th row through this via; an orthographic projection of the fourth transfer via VM4 on the base substrate is within the range of orthographic projections of the third initial signal line INIT3 (i) in the i-th row and the third initial signal line INIT3 (i+2) in the (i+2)-th row on the base substrate, the fifth insulation layer in the fourth transfer via VM4 can be removed to expose the surfaces of the third initial signal line INIT3(i) in the i-th row and the third initial signal line INIT3(i+2) in the (i+2)-th row and the fourth transfer via VM4 is configured such that the second transfer electrode formed subsequently is electrically connected to the corresponding third initial signal line INIT3(i) in the i-th row and the third initial signal line INIT3(i+2) in the (i+2)-th row through this via.

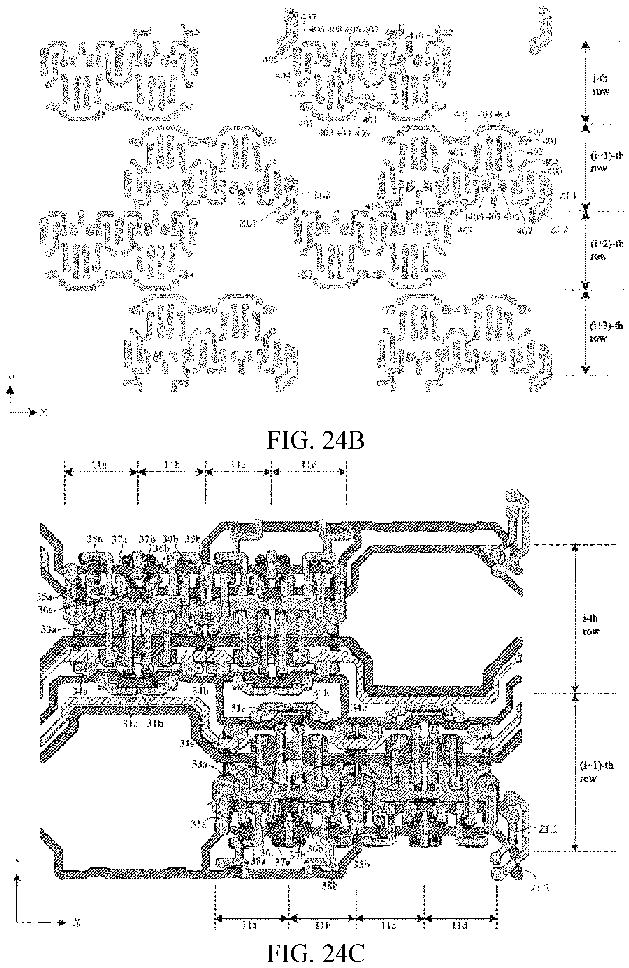

In an exemplary embodiment, as shown in FIG. 24A, which is a schematic diagram of a planar structure after the fourth conductive layer is formed, and FIG. 24B is a schematic diagram of the fourth conductive layer in FIG. 24A. FIG. 24C is a schematic partial enlarged diagram in FIG. 24A. As shown in FIGS. 24A to 24C, the difference from FIGS. 13A to 13C is that a first transfer electrode ZL1 and a second transfer electrode ZL2 are newly added. In an exemplary embodiment, in the first direction X, the first transfer electrode ZL1 and the second transfer electrode ZL2 are located at a side of the first pixel circuit 11d away from the first pixel circuit 11a, and the second transfer electrode ZL2 is located at a side of the first transfer electrode ZL1 away from the first pixel circuit 11d; in the second direction Y, the first transfer electrode ZL1 and the second transfer electrode ZL2 may be substantially in a shape of a bending line extending in the second direction Y, and the first transfer electrode ZL1 and the second transfer electrode ZL2 may be located in two adjacent first pixel circuits. For example, in the first pixel circuits in the (i+1)-th row and an (i+2)-th row, the first transfer electrode ZL1 and the second transfer electrode ZL2 may extend from the first pixel circuit in the (i+1)-th row to the pixel circuit in the (i+2)-th row along the second direction Y, one end of the first transfer electrode ZL1 is electrically connected with the light emitting control electrode EMLO (i+1) in the (i+1)-th row through the first transfer via VM1, and another end is electrically connected with the light emitting control line EML(i+2) in the (i+2)-th row through the third transfer via VM3 so that the light emitting control line EML(i+2) in the (i+2)-th row can provide a light emitting control signal to the first pixel circuit in the (i+2)-th row and the first pixel circuit in the (i+1)-th row; One end of the second transfer electrode ZL2 is electrically connected to the third initial signal electrode INIT30 (i+1) located in the (i+1)-th row through the second transfer via VM2, and another end is electrically connected to the third initial signal line INIT3(i+2) located in the (i+2)-th row through the fourth transfer via, so that the third initial signal line INIT3(i+2) in the (i+2)-th row can provide an initial signal to the first pixel circuit in the (i+2)-th row and the first pixel circuit in the (i+1)-th row. Similarly, the light emitting control line EML(i+4) located in the (i+4)-th row can provide the light emitting control signal to the first pixel circuit in the (i+4)-th row and the first pixel circuit in the (i+3)-th row, and the third initial signal line INIT3(i+4) located in the (i+4)-th row can provide the initial signal to the first pixel circuit in the (i+4)-th row and the first pixel circuit in the (i+3)-th row. In the scheme according to an embodiment of the present disclosure, a third initial signal line provides an initial signal to two rows of first pixel circuits, and a light emitting control signal is provided to the two rows of first pixel circuits through a light emitting control line, so that the quantity of signal lines can be reduced, the space of the display substrate can be saved, and the light transmittance of the display substrate can be improved (the light transmittance of the third sub-region and the fourth sub-region can be improved).

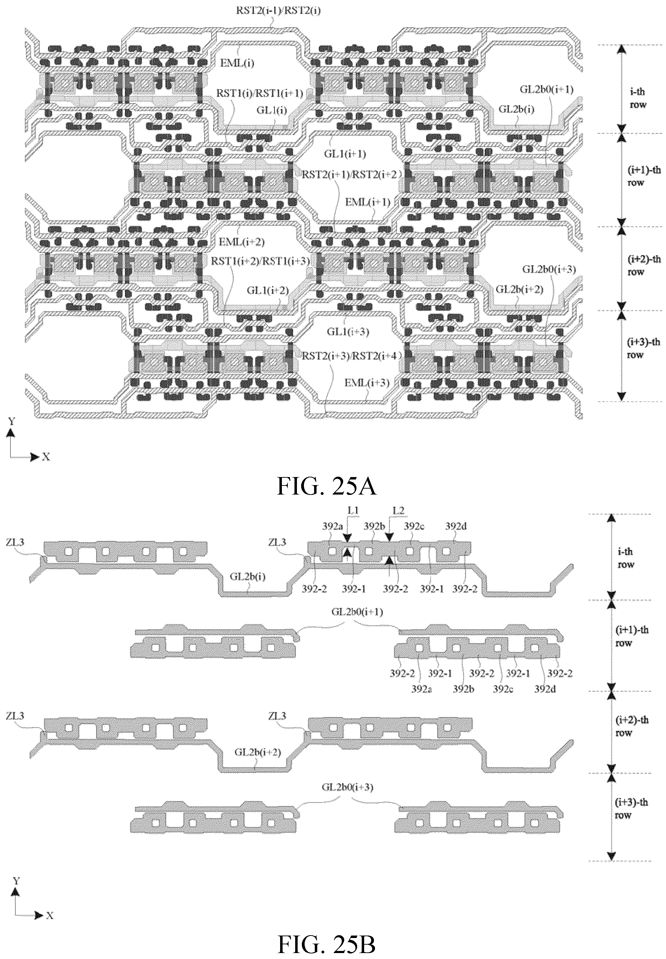

In other embodiments, the preparation process of the display substrate is substantially the same as that of the above acts (101) to (115), the difference lies in the second conductive layer formed in the act (104), the third conductive layer formed in the act (106), the fifth insulation layer formed in the act (107), and the fourth conductive layer formed in the act (108). The differences between the second conductive layer, the third conductive layer, the fifth insulation layer and the fourth conductive layer from the above embodiments are described in detail below in connection with FIGS. 25A to 28C.

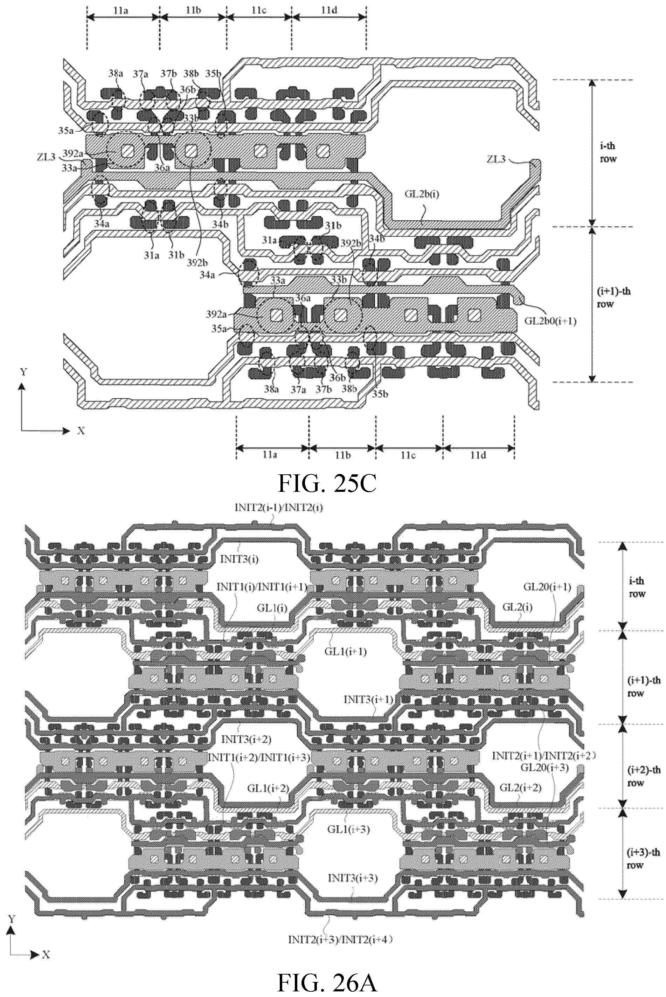

In an exemplary embodiment, as shown in FIG. 25A, which is a schematic diagram of a planar structure after the second conductive layer is formed, and FIG. 25B is a schematic diagram of the second conductive layer in FIG. 25A. FIG. 25C is a schematic partial enlarged diagram in FIG. 25A. As shown in FIGS. 25A to 25C, the difference from FIGS. 9A to 9C is that the second scan auxiliary line GL2b(i+1) in the (i+1)-th row and the second scan auxiliary line GL2b(i+3) in the (i+3)-th row are disconnected at a position of the fourth sub-region to form the second scan auxiliary electrode GL2b0 (i+1) and the second scan auxiliary electrode GL2b0 (i+3), and a plurality of third transfer electrodes ZL3 are newly added. In an exemplary embodiment, in the first direction X, the third transfer electrode ZL3 is provided at a side of the second scan auxiliary line GL2b(i) and the second scan auxiliary line GL2b(i+2) in the (i+2)-th row close to the third sub-region, and in the second direction Y, the third transfer connection electrode ZL3 is provided at a side of the second scan auxiliary line GL2b(i) in the i-th row and the second scan auxiliary line GL2b(i+2) in the (i+2)-th row along the second direction Y.

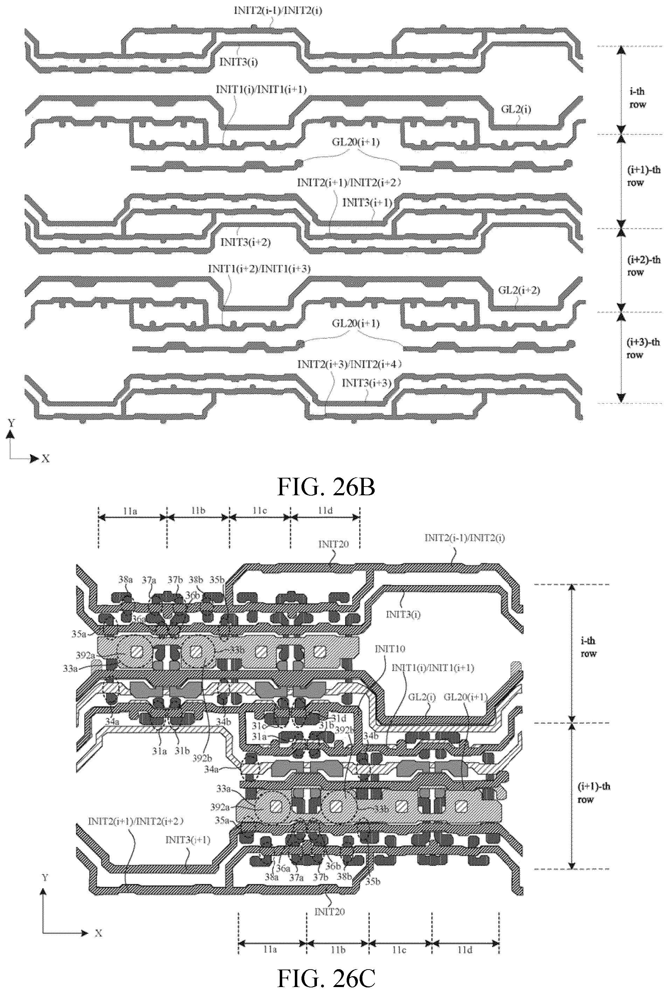

In an exemplary embodiment, as shown in FIG. 26A, which is a schematic diagram of a planar structure after the third conductive layer is formed and FIG. 26B is a schematic diagram of the third conductive layer in FIG. 26A. FIG. 26C is a schematic partial enlarged diagram in FIG. 26A. As shown in FIGS. 26A to 26C, the difference from FIGS. 11A to 11C is that the second scan line GL2(i+1) in the (i+1)-th row and the second scan line GL2(i+3) in the (i+3)-th row are disconnected at a position of the fourth sub-region , and the second scan electrode GL20 (i+1) and the second scan electrode GL20 (i+3) are formed. In an exemplary embodiment, there are an overlapping region and a non-overlapping region between an orthographic projection of the second scan electrode GL20 (i+1) on the base substrate and an orthographic projection of the second scan auxiliary electrode GL2b0 (i+1) on the base substrate; there are an overlapping region and a non-overlapping region between an orthographic projection of the second scan electrode GL20 (i+3) on the base substrate and an orthographic projection of the second scan auxiliary electrode GL2b0 (i+3) on the base substrate. For example, there is an overlapping region between an orthographic projection of the body part of the second scan electrode GL20 (i+1) on the base substrate and an orthographic projection of the body part of the second scan auxiliary electrode GL2b0 (i+1) on the base substrate, and an orthographic projection of at least one end of the second scan electrode GL20 (i+1) on the base substrate and an orthographic projection of at least one end of the second scan auxiliary electrode GL2b0 (i+1) on the base substrate do not overlap; there is an overlapping region between an orthographic projection of the body part of the second scan electrode GL20 (i+3) on the base substrate and an orthographic projection of the body part of the second scan auxiliary electrode GL2b0 (i+3) on the base substrate, and an orthographic projection of at least one end of the second scan electrode GL20 (i+3) on the base substrate and an orthographic projection of at least one end of the second scan auxiliary electrode GL2b0 (i+3) on the base substrate do not overlap. In an exemplary embodiment, a non-overlapping region between an orthographic projection of the second scan electrode GL20 (i+1) on the base substrate and an orthographic projection of the second scan auxiliary electrode GL2b0 (i+1) on the base substrate and an orthographic projection of the third transfer electrode ZL3 on the base substrate are located at a same side of the third sub-region along the first direction X and at a same side of the fourth sub-region along the first direction X.

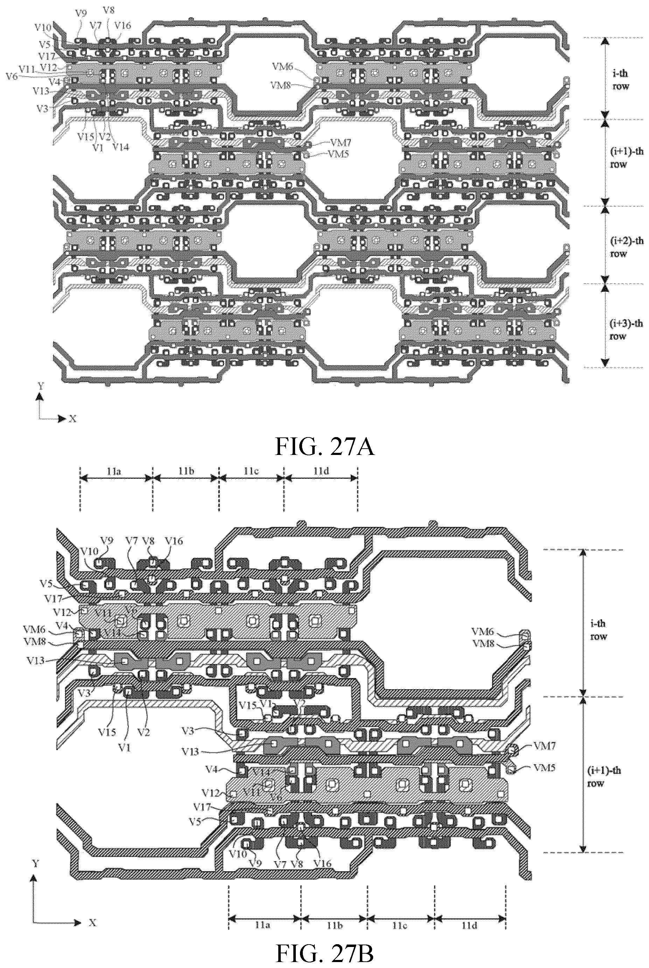

In an exemplary embodiment, as shown in FIG. 27A, which is a schematic diagram of a planar structure after the fifth insulation layer is formed, FIG. 27B is a schematic partial enlarged diagram in FIG. 27A. As shown in FIGS. 27A to 27B, the difference from FIGS. 12A to 12B is that a fifth transfer via VM5, a sixth transfer via VM6, a seventh transfer via VM7, and an eighth transfer via VM8 are newly added. In an exemplary embodiment, an orthographic projection of the fifth transfer via VM5 on the base substrate is within the range of an orthographic projection of the second scan auxiliary electrode on the base substrate, the fifth insulation layer and the fourth insulation layer within the fifth transfer via VM5 may be removed to expose a surface of the second scan auxiliary electrode, the fifth transfer via VM5 is configured such that the fourth transfer electrode formed subsequently is electrically connected to the corresponding second scan auxiliary electrode through this via; An orthographic projection of the sixth transfer via VM6 on the base substrate is within the range of an orthographic projection of the third transfer electrode on the base substrate, the fifth insulation layer and the fourth insulation layer in the sixth transfer via VM6 can be removed to expose a surface of the third transfer electrode, and the sixth transfer via VM6 is configured such that the subsequently formed fourth transfer electrode is electrically connected to the third transfer electrode through this via; an orthographic projection of the seventh transfer via VM7 on the base substrate is within the range of orthographic projections of the second scan electrode GL20 (i+1) and the second scan electrode GL20 (i+3) on the base substrate, the fifth insulation layer in the seventh transfer via VM7 can be removed to expose the surfaces of the second scan electrode GL20 (i+1) in the (i+1)-th row and the second scan electrode GL20 (i+3) in the (i+3)-th row, and the seventh transfer via VM7 is configured such that the fourth transfer electrode formed subsequently is electrically connected with the corresponding second scan electrode GL20 (i+1) in the (i+1)-th row and the second scan electrode GL20 (i+3) in the (i+3)-th row through this via; an orthographic projection of the eighth transfer via VM8 on the base substrate is within the range of an orthographic projection of the second scan line GL2 (i+1) in the i-th row and the second scan line GL2 (i+3) in the (i+3) row on the base substrate, the fifth insulation layer in the eighth transfer via VM8 can be removed to expose the surfaces of the second scan line GL2(i+1) in the (i+1)-th row and the second scan line GL2(i+3) in the (i+3)-th row, and the eighth transfer via VM8 is configured such that the fourth transfer electrode formed subsequently is electrically connected to the corresponding second scan line GL2(i+1) in the (i+1)-th row and the second scan line GL2(i+3) in the (i+3)-th row through this via.

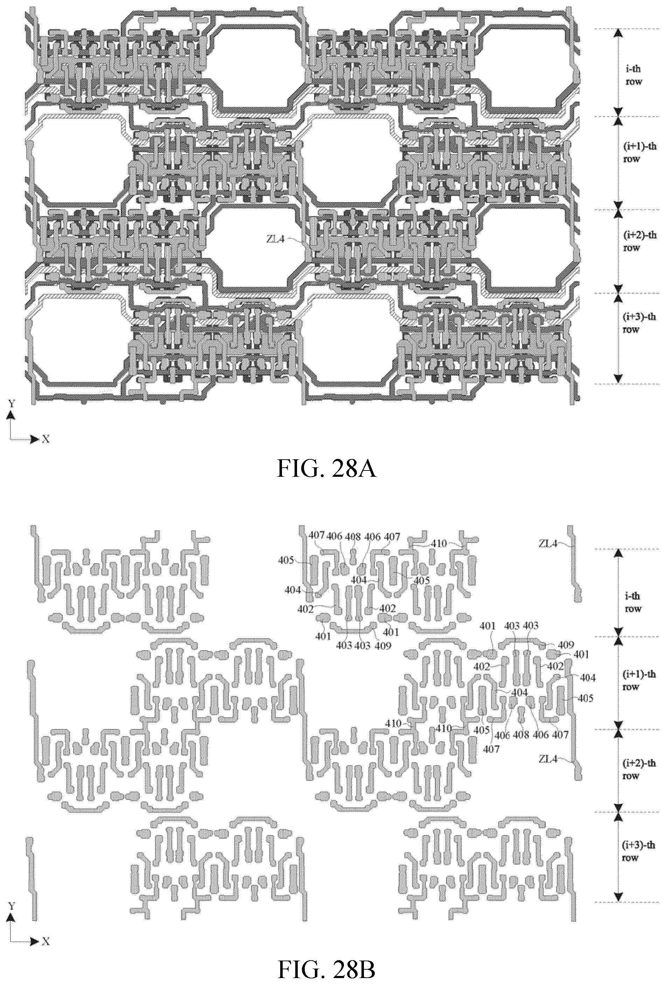

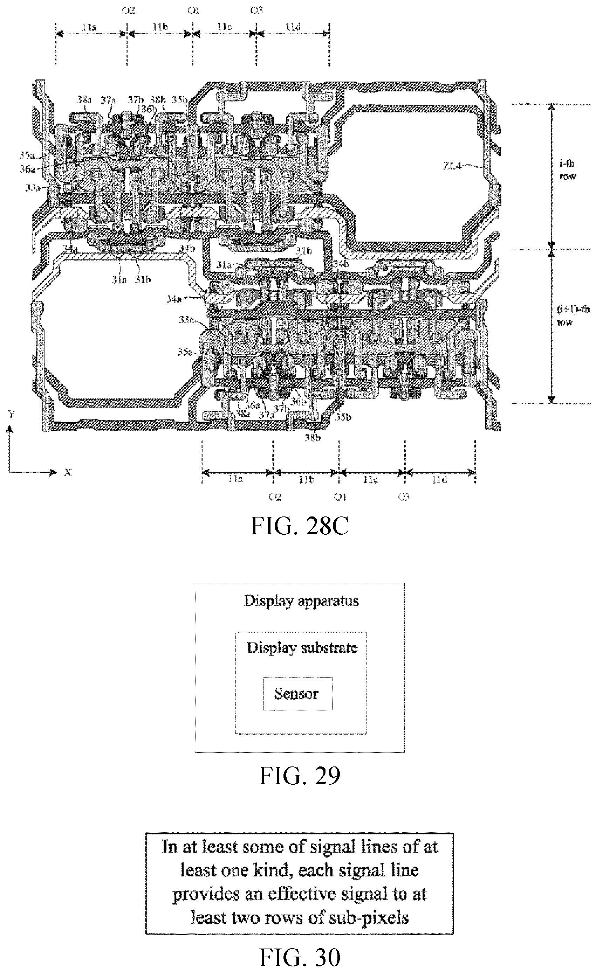

In an exemplary embodiment, as shown in FIG. 28A, which is a schematic diagram of a planar structure after the fourth conductive layer is formed, and FIG. 28B is a schematic diagram of the fourth conductive layer in FIG. 28A. FIG. 28C is a schematic partial enlarged diagram in FIG. 28A. As shown in FIGS. 28A to 28C, the difference from FIGS. 13A to 13C is that a fourth transfer electrode ZL4 is newly added. In an exemplary embodiment, in the first direction X, the fourth transfer electrodes ZL4 may be located at a side of the first pixel circuit 11a away from the first pixel circuit 11d; in the second direction Y, the fourth transfer electrode ZL4 may be substantially in a shape of a bending line extending in the second direction Y, and the fourth transfer electrode ZL4 may be located in two adjacent first pixel circuits, for example, in the first pixel circuits in the (i+1)-th row and the (i+2)-th row, the fourth transfer electrode ZL4 may extend along the second direction Y from the first pixel circuit in the (i+1)-th row to the pixel circuit in the (i+2)-th row, one end of the fourth transfer electrode ZL4 is electrically connected to the second scan auxiliary electrode GL2b0 (i+1) in the (i+1)-th row through the fifth transfer via VM5, and another end is electrically connected to the second scan auxiliary line GL2b(i+2) in the (i+2)-th row through the sixth transfer via VM6, so that the second scan auxiliary line GL2b (i+2) in the (i+2)-th row can provide signals to the first pixel circuit in the (i+2)-th row and the first pixel circuit in the (i+1)-th row; one end of the fourth transfer electrode ZL4 can also be electrically connected to the second scan electrode GL20 (i+1) located in the (i+1)-th row through the seventh transfer via VM7, and another end can be electrically connected to the second scan line GL2(i+2) located in the (i+2)-th row through the eighth transfer via VM8, so that the second scan line GL2(i+2) in the (i+2)-th row can provide a second scan signal to the first pixel circuit in the (i+2)-th row and the first pixel circuit in the (i+1)-th row . Similarly, the second scan line GL2(i+4) located in the (i+4)-th row can provide the second scan signal to the first pixel circuit in the (i+4)-th row and the first pixel circuit in the (i+3)-th row, and the second scan auxiliary electrode GL2b0 (i+4) located in the (i+4)-th row can provide a signal to the first pixel circuit in the (i+4)-th row and the first pixel circuit in the (i+3)-th row. In the scheme according to an embodiment of the present disclosure, signals can be provided to two rows of first pixel circuits through a second scan auxiliary line, and scan signals can be provided to two rows of first pixel circuits through a second scan line, so that the quantity of signal lines can be reduced, the space of the display substrate can be saved, and the light transmittance of the display substrate can be improved (the light transmittance of the third sub-region and the fourth sub-region can be improved).

In an exemplary embodiment, the first direction X may be the row direction X described above and the second direction Y may be the column direction Y described above.

Embodiments of the present disclosure further provide a display apparatus. As shown in FIG. 29, the display apparatus may include a display substrate of any of the above embodiments and a sensor located on a side of a non-display surface of the display substrate. The display substrate may include a first display region, and an orthographic projection of the sensor on the display substrate at least partially overlaps the first display region of the display substrate.

In an exemplary embodiment, as shown in FIG. 1, the display substrate may include a first display region A1 and a second display region A2, the second display region A2 may be located at least one side of the first display region A1, for example, the second display region A2 is disposed around the first display region A1. In some examples, as shown in FIG. 1, the first display region A1 may be a light-transmitting display region, and may also be referred to as a Full Display with Camera (FDC) region, and the second display region A2 may be referred to as a normal display region. For example, an orthographic projection of a sensor (such as a camera and other hardware) on the display substrate may be located within the first display region A1 of the display substrate. In some examples, as shown in FIG. 1, the first display region A1 may be circular, and a size of an orthographic projection of the sensor on the display substrate may be less than or equal to a size of the first display region A1. However, the embodiment is not limited thereto. In some other examples, the first display region A1 may be rectangular, and a size of the orthographic projection of the sensor on the display substrate may be less than or equal to a size of an inscribed circle of the first display region A1.

In an exemplary embodiment, the display apparatus may be any product or component with a display function, such as a mobile phone, a tablet computer, a television, a display, a laptop computer, a digital photo frame, or a navigator.

Embodiments of the present disclosure further provide a driving method for a display substrate configured to drive the display substrate of any of the above embodiments, the display substrate comprises K rows of sub-pixels and a plurality of kinds of signal lines extending along the row direction, the quantity of signal lines of a same kind is a positive integer less than or equal to K, and each row of sub-pixels are electrically connected with one of signal lines of a same kind; as shown in FIG. 30, the driving method includes:

In at least some of signal lines of at least one kind, each signal line provides an effective signal to at least two rows of sub-pixels.

In an exemplary embodiment, in at least some of the signal lines of at least one kind, each signal line simultaneously provides an effective signal to two rows of sub-pixels adjacent thereto.

In an exemplary embodiment, the signal lines of at least one kind includes a first type of signal lines, the first type of signal lines at least include a first reset control line and a first initial signal line.

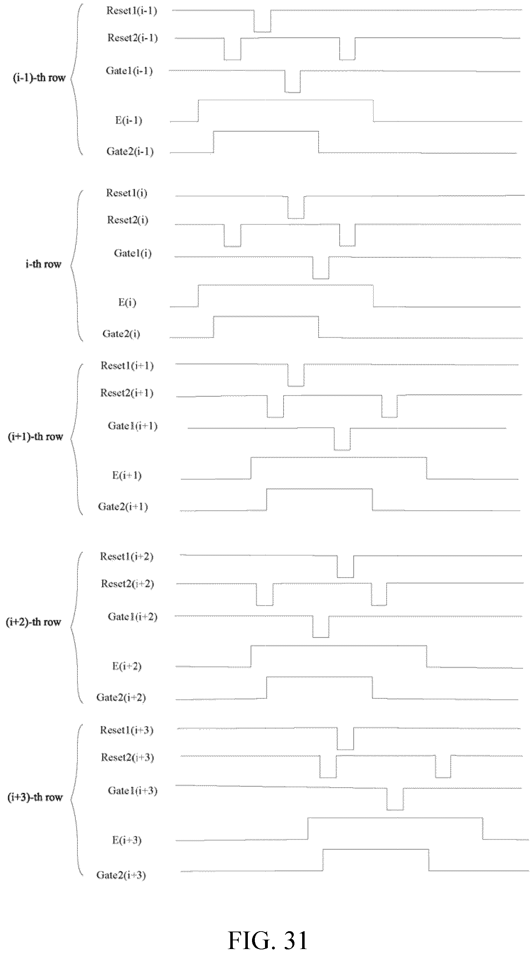

In the first type of signal lines, in two adjacent signal lines of signal lines of a same kind, one of the signal lines is configured to simultaneously provide an effective signal to an i-th row of sub-pixels and an (i+1)-th row of sub-pixels, and another signal line is configured to simultaneously provide an effective signal to an (i+2)-th row of sub-pixels and an (i+3)-th row of sub-pixels, where i is an integer greater than or equal to 1 and less than K. For example, as shown in FIGS. 4A and 31, in two adjacent first reset control lines among the plurality of first reset control lines, one of the first reset control lines (e.g., the first reset control line Reset1(i)/Reset1(i+1) shared by an i-th row of sub-pixels and an (i+1)-th row of sub-pixels) is configured to simultaneously provide a first reset signal to the i-th row of sub-pixels and the (i+1)-th row of sub-pixels, and another first reset control line (e.g., the first reset control line Reset1(i+2)/Reset1(i+3) shared by an (i+2)-th row of sub-pixels and an (i+3)-th row of sub-pixels) is configured to simultaneously provide a first reset signal to the (i+2)-th row of sub-pixels and the (i+3)-th row of sub-pixels. As shown in FIG. 4B, in two adjacent first initial signal lines among the plurality of first initial signal lines, one of the first initial signal lines (e.g., the first initial signal line INIT1(i)/INIT1(i+1) shared by an i-th row of sub-pixels and an (i+1)-th row of sub-pixels) is configured to simultaneously provide a first reset signal to the i-th row of sub-pixels and the (i+1)-th row of sub-pixels, and another first reset control line (e.g., the first reset control line INIT1(i+2)/INIT1(i+3) shared by an (i+2)-th row of sub-pixels and an (i+3)-th row of sub-pixels) is configured to simultaneously provide a first reset signal to the (i+2)-th row of sub-pixels and the (i+3)-th row of sub-pixels.

In an exemplary embodiment, the signal lines of at least one kind include a second type of signal lines, the second type of signal lines include one or more of a second reset control line, a second initial signal line, a third initial signal line, a light emitting control line, and a second scan line.

In the second type of signal lines, in two adjacent signal lines of signal lines of a same kind, one of the signal lines is configured to simultaneously provide an effective signal to an (i-1)-th row of sub-pixels and an i-th row of sub-pixels, and another signal line is configured to simultaneously provide an effective signal to an (i+1)-th row of sub-pixels and an (i+2)-th row of sub-pixels, where i is an integer greater than 1 and less than K. In the display substrate, the driving method thereof, and the display apparatus according to an embodiment of the present disclosure, in at least some of signal lines of at least one kind, each signal line is configured to be electrically connected to at least two rows of sub-pixels, in the signal lines of at least one kind, the quantity of signal lines of a same kind is a positive integer less than K, so that the quantity of signal lines is reduced and the light transmittance of the display substrate can be improved. For example, as shown in FIGS. 4A, 4B, and 31, in two adjacent second reset control lines among a plurality of second reset control lines, one of the second reset control lines (e.g., the second reset control line Reset2(i-1)/Reset2(i) shared by an (i-1)-th row of sub-pixels and an i-th row of sub-pixels) is configured to simultaneously provide a second reset signal to the (i-1)-th row of sub-pixels and the i-th row of sub-pixels, and another second reset control line (e.g., the second reset control line Reset2(i+1)/Reset1(i+2) shared by an (i+1)-th row of sub-pixels and an (i+2)-th row of sub-pixels) is configured to simultaneously provide a first reset signal to the (i+1)-th row of sub-pixels and the (i+2)-th row of sub-pixels.

As shown in FIG. 4B, in two adjacent second initial signal lines of a plurality of second initial signal lines, one of the second initial signal lines (e.g., the second initial signal line INIT2(i-1)/INIT2(i) shared by an (i-1)-th row of sub-pixels and an i-th row of sub-pixels) is configured to simultaneously provide a second initial signal to the (i-1)-th row of sub-pixels and the i-th row of sub-pixels, and another second initial signal line (e.g., the second initial signal INIT2(i+1)/INIT2(i+2) shared by an (i+1)-th row of sub-pixels and an (i+2)-th row of sub-pixels) is configured to simultaneously provide a second initial signal to the (i+1)-th row of sub-pixels and the (i+2)-th row of sub-pixels.

As shown in FIGS. 6B to 6C, in two adjacent third initial signal lines of a plurality of third initial signal lines, one of the third initial signal lines (e.g., the third initial signal line INIT3(i) shared by an (i-1)-th row of sub-pixels and an i-th row of sub-pixels ) is configured to simultaneously provide the third initial signal to the (i-1)-th row of sub-pixels and the i-th row of sub-pixels, and another third initial signal line (e.g., the third initial signal INIT2(i+2) shared by an (i+1)-th row of sub-pixels and an (i+2)-th row of sub-pixels) is configured to simultaneously provide a third initial signal to the (i+1)-th row of sub-pixels and the (i+2)-th row of sub-pixels.

As shown in FIGS. 6A, 6C, and 31, in two adjacent light emitting control lines among a plurality of light emitting control lines, one of the light emitting control lines (e.g., the light emitting control line EML(i) shared by an (i-1)-th row of sub-pixels and an i-th row of sub-pixels) is configured to simultaneously provide a light emitting control signal to the (i-1)-th row of sub-pixels and the i-th row of sub-pixels, and another light emitting control line(e.g., the light emitting control line EML(i+2) shared by an (i+1)-th row of sub-pixels and an (i+2)-th row of sub-pixels) is configured to simultaneously provide a light emitting control signal to the (i+1)-th row of sub-pixels and the (i+2)-th row of sub-pixels.

As shown in FIGS. 5A to 5C and FIG. 31, two adjacent second scan lines among a plurality of second scan lines, one of the second scan lines (e.g., the second scan line GL2(i) shared by an (i-1)-th row of sub-pixels and an i-th row of sub-pixels) is configured to simultaneously provide a second scan signal to the (i-1)-th row of sub-pixels and the i-th row of sub-pixels, and another second scan line (e.g., the second scan line GL2L(i+2) shared by an (i+1)-th row of sub-pixels and an (i+2)-th row of sub-pixels) is configured to simultaneously provide a second scan signal to the (i+1)-th row of sub-pixels and the (i+2)-th row of sub-pixels.

In an exemplary embodiment, an effective signal can be a signal provided by a signal line that enables the sub-pixels electrically connected thereto to function properly. For example, as shown in FIG. 31, the effective signal of the light emitting control line, the first reset control line, the second reset control line and the first scan line may be at a low level, and the effective signal provided by the second scan line may be at a high level, that is, the light emitting control signal provided by the light emitting control line, the first reset control signal provided by the first reset control line, the second reset control signal provided by the second reset control line, the first scan signal provided by the first scan line may be low-level signals, the second scan signal provided by the second scan line may be at a high level, and the effective signal can be set at a high level or a low level in conjunction with the transistors in the first pixel circuit, and is not limited to the above-described way of setting the high level or the low level. **In** an exemplary embodiment, the effective signals provided by the first initial signal line, the second initial signal line, and the third initial signal line may be set according to the actual first pixel circuit, for example, the first initial signal provided by the first initial signal line, the second initial signal provided by the second initial signal line, and the third initial signal provided by the third initial signal line may be, but are not limited to, low-level signals, and the first initial signal to the third initial signal may alternatively be set to high-level signals according to the first pixel circuit. Here, no limitation is made thereto in embodiments of the present disclosure.

The drawings of the embodiments of the present disclosure only involve structures involved in the embodiments of the present disclosure, and other structures may refer to a general design.

The embodiments of the present disclosure, that is, features in the embodiments, may be combined with each other to obtain a new embodiment in a situation of no conflicts.

Although the implementations disclosed in the embodiments of the present disclosure are described above, contents are only implementations for facilitating understanding of the embodiments of the present disclosure, but are not intended to limit the embodiments of the present disclosure. Any person skilled in the art to which the embodiments of the present disclosure pertain may make any modifications and variations in forms and details of implementation without departing from the spirit and the scope disclosed in the embodiments of the present disclosure. Nevertheless, the scope of patent protection of the embodiments of the present disclosure shall still be subject to the scope defined by the appended claims.

**Claims**

1. A display substrate, comprising: a base substrate, K rows of sub-pixels, and a plurality of kinds of signal lines extending along a row direction provided on the base substrate, wherein:

   a quantity of signal lines of a same kind is multiple, a plurality of signal lines of a same kind are arranged at intervals along a column direction, and each row of sub-pixels are electrically connected with one of signal lines of a same kind; on a plane parallel to the display substrate, the row direction is intersected with the column direction; and in at least some of signal lines of at least one kind, each signal line is configured to be electrically connected to at least two rows of sub-pixels, in the signal lines of at least one kind, the quantity of signal lines of a same kind is a positive integer less than K.

2. The display substrate according to claim 1, wherein in at least some of the signal lines of at least one kind, each signal line is configured to electrically connected to two rows of sub-pixels adjacent thereto.

3. The display substrate according to claim 2, wherein the signal lines of at least one kind comprises a first type of signal lines, wherein: the first type of signal lines comprise at least two adjacent signal lines of a same kind, in the two adjacent signal lines of the same kind, one of the signal lines is configured to be electrically connected to an i-th row of sub-pixels and an (i+1)-th row of sub-pixels, and another signal line is configured to be electrically connected to an (i+2)-th row of sub-pixels and an (i+3)-th row of sub-pixels, wherein i is an integer greater than or equal to 1 and less than K.

4. The display substrate according to claim 3, wherein categories of signal lines in the first type of signal lines comprise a first reset control line and/or a first initial signal line.

5. The display substrate according to claim 4, wherein the first initial signal line and the first reset control line are located at different conductive layers, and an orthographic projection of the first initial signal line on the base substrate is at least partially overlapped with an orthographic projection of the first reset control line on the base substrate in a same row of sub-pixels.

6. The display substrate according to claim 3, wherein the signal lines of at least one kind further comprises a second type of signal lines, the second type of signal lines comprise at least two adjacent signal lines of a same kind, in the two adjacent signal lines of the same kind, one of the signal lines is configured to be electrically connected to an (i-1)-th row of sub-pixels and an i-th row of sub-pixels, and another signal line is configured to be electrically connected to an (i+1)-th row of sub-pixels and an (i+2)-th row of sub-pixels, wherein i is greater than 1.

7. The display substrate according to claim 6, wherein categories of signal lines in the second type of signal lines comprise a second reset control line and/or a second initial signal line.

8. The display substrate according to claim 7, wherein the second reset control line and the second initial signal line are located at different conductive layers, and an orthographic projection of the second reset control line on the base substrate is at least partially overlapped with an orthographic projection of the second initial signal line on the base substrate in a same row of sub-pixels.

9. The display substrate according to claim 7, wherein the categories of signal lines in the second type of signal lines further comprises at least one of a third initial signal line, a light emitting control line, and a second scan line.

10. The display substrate according to claim 9, wherein the light emitting control line and the third initial signal line are located at different conductive layers, and an orthographic projection of the light emitting control line on the base substrate is at least partially overlapped with an orthographic projection of the third initial signal line on the base substrate in a same row of sub-pixels.

11. The display substrate according to claim 9, wherein the categories of signal lines in the second type of signal lines further comprises a second scan auxiliary line, an orthographic projection of the second scan auxiliary line on the base substrate is at least partially overlapped with an orthographic projection of the second scan line on the base substrate in a same row of sub-pixels.

12. The display substrate according to any one of claims 1 to 11, wherein the K rows of sub-pixels comprise a plurality of first sub-pixel rows and a plurality of second sub-pixel rows, the first sub-pixel rows and the second sub-pixel rows are alternately arranged along the column direction, in the at least some of the signal lines of at least one kind, each signal line is configured to be electrically connected to a first sub-pixel row and a second sub-pixel row adjacent thereto.

13. The display substrate according to claim 12, wherein: each row of sub-pixels comprises a plurality of sub-pixels sequentially disposed along the row direction, the plurality of sub-pixels form a plurality of pixel units, and at least some of the pixel units comprise at least three sub-pixels sequentially disposed along the row direction; and
the display substrate comprises a first display region, the first display region comprises a plurality of first sub-regions, a plurality of second sub-regions, a plurality of third sub-regions and a plurality of fourth sub-regions, the first sub-regions and the third sub-regions are alternately arranged along the row direction, the second sub-regions and the fourth sub-regions are alternately arranged along the row direction, a plurality of pixel units in the first sub-pixel row are respectively located in the plurality of first sub-regions, a plurality of pixel units in the second sub-pixel row are respectively located in the plurality of second sub-regions, the plurality of pixel units located in the first sub-pixel row are spaced apart through the third sub-regions, and the plurality of pixel units in the second sub-pixel row are spaced apart through the fourth sub-regions.

14. The display substrate according to claim 13, wherein at least some of sub-pixels comprise a first pixel circuit, and at least some of pixel units comprise four sub-pixels arranged sequentially in the row direction; in a same pixel unit, four first pixel circuits are symmetrically arranged with respect to a first midline of the four first pixel circuits extending along the column direction, a first first pixel circuit and a second first pixel circuit of the four first pixel circuits are symmetrically arranged with respect to a second midline of the two first pixel circuits extending along the column direction, and a third first pixel circuit and a fourth first pixel circuit are symmetrically arranged with respect to a third midline of the two first pixel circuits extending along the column direction.

15. The display substrate according to claim 14, wherein: the plurality of first sub-regions form a plurality of columns of first sub-regions and the plurality of second sub-regions form a plurality of columns of second sub-regions, and the first sub-regions and the second sub-regions are staggered in the column direction; and
a third first pixel circuit and a fourth first pixel circuit of four first pixel circuits in a pixel unit of the first sub-region are located in a same column as a first first pixel circuit and a second first pixel circuit of four first pixel circuits in a pixel unit of an adjacent second sub-region, respectively.

16. The display substrate according to claim 14, wherein the pixel unit further comprises four light emitting elements, the four light emitting elements are respectively electrically connected with four first pixel circuits in the pixel unit, the light emitting elements comprise anodes; in a same pixel unit, orthographic projections of the anodes of the four light emitting elements on the base substrate and orthographic projections of the third sub-region and the fourth sub-region on the base substrate are at least partially not overlapped; in the first sub-pixel row, orthographic projections of the anodes of the four light emitting elements on the base substrate are at least partially overlapped with an orthographic projection of the first sub-region on the base substrate; in the second sub-pixel row, orthographic projections of the anodes of the four light emitting elements on the base substrate are at least partially overlapped with the second sub-region.

17. The display substrate according to claim 15, wherein:

at least some of the first pixel circuits comprise a first transistor to an eighth transistor;
in a first pixel circuit in the first sub-pixel row located in an i-th row, in the column direction, the first transistor, the second transistor, and the fourth transistor are located at a side of the third transistor close to the second sub-pixel row located in an (i+1)-th row, the second transistor is located between the first transistor and the third transistor; the fifth transistor to the eighth transistor are located at a side of the third transistor close to the second sub-pixel row located in an (i-1)-th row, and the sixth transistor is located between the third transistor and the seventh transistor; where i is a positive integer greater than 1 and less than K; and
in a first pixel circuit in the second sub-pixel row located in an (i+1) row, the first transistor, the second transistor and the fourth transistor are located at a side of the third transistor close to the first sub-pixel row located in the i-th row, the second transistor is located between the first transistor and the third transistor; the fifth transistor to the eighth transistor are located at a side of the third transistor close to the first sub-pixel row located in an (i+2)-th row, and the sixth transistor is located between the third transistor and the seventh transistor.

18. The display substrate according to claim 17, wherein: in a direction perpendicular to a plane where the display substrate is located, the display substrate comprises: a circuit structure layer located on the base substrate; the circuit structure layer comprises the plurality of first pixel circuits; at least some of the plurality of first pixel circuits comprise at least one of a first type of transistors, at least one of a second type of transistors, and a storage capacitor; the first type of transistors comprise at least the first transistor, the third transistor to the eighth transistor, and the second type of transistors comprise at least the second transistor; and
the circuit structure layer comprises a first semiconductor layer, a first conductive layer, a second conductive layer, a second semiconductor layer and a third conductive layer provided on the base substrate; the first semiconductor layer at least comprises: active layers of the first type of transistors of the pixel circuit; the first conductive layer at least comprises: gates of the first type of transistors and a first electrode of the storage capacitor of the pixel circuit; the second conductive layer at least comprises: a second electrode of the storage capacitor of the pixel circuit; the second semiconductor layer at least comprises: active layers of the second type of transistors of the pixel circuit; the third conductive layer comprises at least gates of the second type of transistors of the pixel circuit.

19. The display substrate according to claim 18, wherein: the first conductive layer further comprises: a first scan line, a light emitting control line, a first reset control line, and a second reset control line electrically connected to the first type of transistors in the first pixel circuit; the first scan line, the light emitting control line, the first reset control line, and the second reset control line extend along the row direction; and

in the column direction, the first scan line and the first reset control line electrically connected to the first sub-pixel row bypass from a side of the third sub-region, and the light emitting control line electrically connected to the first sub-pixel row bypasses from another side of the third sub-region; the first scan line electrically connected to the second sub-pixel row bypasses a side of the fourth sub-region, and the light emitting control line and the second reset control line electrically connected to the second sub-pixel row bypass another side of the fourth sub-region.

20. The display substrate according to claim 19, wherein: the third conductive layer further comprises a first initial signal line electrically connected to the first transistor in the first pixel circuit, a second initial signal line electrically connected to the seventh transistor in the first pixel circuit, and a third initial signal line electrically connected to the eighth transistor; the first initial signal line, the second initial signal line, and the third initial signal line extend along the row direction; and

in a same row of sub-pixels, an orthographic projection of the first initial signal line on the base substrate is at least partially overlapped with an orthographic projection of the first reset control line on the base substrate, an orthographic projection of the second initial signal line on the base substrate is at least partially overlapped with an orthographic projection of the second reset control line on the base substrate, and an orthographic projection of the third initial signal line on the base substrate is at least partially overlapped with an orthographic projection of the light emitting control line on the base substrate.

21. The display substrate according to claim 20, wherein: at a location where a first sub-region of the first sub-pixel row located in an i-th row and a second sub-region of the second sub-pixel row located in an (i-1)-th row are adjacent, the second reset control line and the second initial signal line have an annular structure, in the column direction, a side of the annular structure close to the first sub-region is overlapped with orthographic projections of the seventh transistor and the eighth transistor in a third first pixel circuit to a fourth first pixel circuit in the first sub-region on the base substrate, and a side of the annular structure close to the second sub-region is overlapped with orthographic projections of the seventh transistor and the eighth transistor in a first first pixel circuit to a second first pixel circuit in the second sub-region on the base substrate; and

at a location where a first sub-region of the first sub-pixel row located in an i-th row and a second sub-region of the second sub-pixel row located in an (i+1)-th row are adjacent, the first reset control line and the first initial signal line have an annular structure, in the column direction, a side of the annular structure close to the first sub-region is overlapped with orthographic projections of first transistors in a third first pixel circuit to a fourth first pixel circuit in the first sub-region on the base substrate; a side of the annular structure close to the second sub-region is overlapped with orthographic projections of first transistors in a first first pixel circuit to a second first pixel circuit in the second sub-region on the base substrate.

22. The display substrate according to claim 18, wherein: the second conductive layer further comprises a second scan auxiliary line electrically connected to a second transistor in the first pixel circuit; the third conductive layer further comprises a second scan line electrically connected with the second transistor in the first pixel circuit; orthographic projections of the second scan auxiliary line and the second scan line in a same row of sub-pixels on the base substrate are at least partially overlapped; the second scan auxiliary line and the second scan line extend along the row direction; and

in the column direction, the second scan line and the second scan auxiliary line electrically connected to the first sub-pixel row bypass from a side of the third sub-region, and the second scan line and the second scan auxiliary line electrically connected to the second sub-pixel row bypass from a side of the fourth sub-region; the second scan line and the second scan auxiliary line electrically connected to the first sub-pixel row bypass the third sub-region in a direction opposite to a direction in which the second scan line and second scan auxiliary line electrically connected to the second sub-pixel row bypass the fourth sub-region.

23. The display substrate according to claim 18, further comprising a fourth conductive layer, wherein:

the fourth conductive layer comprises a fourth transfer electrode; the fourth transfer electrode extends along the column direction;

the second conductive layer further comprises a plurality of second scan auxiliary lines and a plurality of second scan auxiliary electrodes electrically connected with the second transistor in the first pixel circuit; the third conductive layer further comprises a plurality of second scan lines and a plurality of second scan electrodes electrically connected with the second transistor in the first pixel circuit; in a same row of sub-pixels, orthographic projections of the second scan auxiliary lines and the second scan lines on the base substrate are at least partially overlapped, and orthographic projections of the second scan electrodes and the second scan auxiliary electrodes on the base substrate are at least partially overlapped; the second scan auxiliary electrodes, the second scan electrodes, the second scan auxiliary lines, and the second scan lines extend along the row direction;

the plurality of second scan auxiliary electrodes and the plurality of second scan electrodes are respectively electrically connected with a plurality of pixel units in the second sub-pixel row, the plurality of second scan auxiliary lines and the plurality of second scan lines are electrically connected with a plurality of first pixel circuits in the first sub-pixel row; the second scan auxiliary lines and the second scan lines located in an i-th row are electrically connected to the plurality of second scan auxiliary electrodes and the plurality of second scan electrodes located in an (i-1)-th row through the fourth transfer electrode, and the second scan auxiliary lines and the second scan lines located in an (i+2)-th row are electrically connected to the plurality of second scan auxiliary electrodes and the plurality of second scan electrodes located in an (i+1)-th row through the fourth transfer electrode; and

in the column direction, the second scan lines and the second scan auxiliary lines electrically connected to the first sub-pixel row bypass from a side of the fourth sub-region; the plurality of the second scan electrodes and the plurality of the second scan auxiliary electrodes electrically connected to the second sub-pixel row are respectively located in a plurality of the second sub-regions.

24. The display substrate according to claim 18, further comprising a fourth conductive layer located at a side of the third conductive layer away from the base substrate, wherein:

the fourth conductive layer comprises a plurality of first transfer electrodes and a plurality of second transfer electrodes; the first transfer electrodes and the second transfer electrodes extend along the column direction; the first conductive layer further comprises a plurality of light emitting control lines respectively electrically connected to the plurality of the first sub-pixel rows and a plurality of light emitting control electrodes respectively electrically connected to the plurality of the second sub-pixel rows; the light emitting control lines and the light emitting control electrodes extend along the row direction; the third conductive layer further comprises a plurality of third initial signal lines respectively electrically connected to the plurality of the first sub-pixel rows and a plurality of third initial signal electrodes respectively electrically connected to the plurality of the second sub-pixel rows; the third initial signal lines and the third initial signal electrodes extend along the row direction;

the light emitting control lines located in an i-th row is electrically connected with the plurality of light emitting control electrodes located in an (i-1)-th row through the first transfer electrode, and the light emitting control lines located in an (i+2)-th row is electrically connected with the plurality of light emitting control electrodes located in an (i+1)-th row through the first transfer electrode; a third initial signal line located in an i-th row is electrically connected to a plurality of third initial signal electrodes located in an (i-1)-th row through the second transfer electrode, and a third initial signal line located in an (i+2)-th row is electrically connected to a plurality of third initial signal electrodes located in an (i+1)-th row through the second transfer electrode; and

the light emitting control electrodes and the third initial signal electrodes are located in the second sub-region, and the light emitting control line and the third initial signal line electrically connected to the first sub-pixel row bypass from a side of the fourth sub-region in the column direction; in a same row of sub-pixels, orthographic projections of the light emitting control line and the third initial signal line on the base substrate are at least partially overlapped, and orthographic projections of the light emitting control electrodes and the third initial signal electrode on the base substrate are at least partially overlapped.

25. A display apparatus, comprising a display substrate according to any one of claims 1 to 24 and a sensor located on a side of a non-display surface of the display substrate, wherein the display substrate comprises a first display region, an orthographic projection of the sensor on the display substrate is at least partially overlapped with the first display region of the display substrate.

26. A driving method for a display substrate, configured to drive the display substrate according to any one of claims 1 to 24, wherein: the display substrate comprises K rows of sub-pixels and a plurality of kinds of signal lines extending along the row direction, the quantity of signal lines of a same kind is a positive integer less than or equal to K, and each row of sub-pixels are electrically connected with one of signal lines of a same kind; and the driving method comprises:

in at least some of signal lines of at least one kind, each signal line provides an effective signal to at least two rows of sub-pixels.

27. The driving method according to claim 26, wherein in at least some of the signal lines of at least one kind, each signal line simultaneously provides the effective signal to two rows of sub-pixels adjacent thereto.

28. The driving method according to claim 27, wherein: the signal lines of at least one kind comprises a first type of signal lines, the first type of signal lines comprise at least one of a first reset control line and a first initial signal line; and in the first type of signal lines, in two adjacent signal lines of signal lines of a same kind, one of the signal lines is configured to simultaneously provide an effective signal to an i-th row of sub-pixels and an (i+1)-th row of sub-pixels, and another signal line is configured to simultaneously provide an effective signal to an (i+2)-th row of sub-pixels and an (i+3)-th row of sub-pixels, where i is an integer greater than or equal to 1 and less than K.

29. The driving method according to claim 27 or 28, wherein: the signal lines of at least one kind comprise a second type of signal lines, the second type of signal lines comprise one or more of a second reset control line, a second initial signal line, a third initial signal line, a light emitting control line, and a second scan line; and in the second type of signal lines, in two adjacent signal lines of signal lines of a same kind, one of the signal lines is configured to simultaneously provide an effective signal to an (i-1)-th row of sub-pixels and an i-th row of sub-pixels, and another signal line is configured to simultaneously provide an effective signal to an (i+1)-th row of sub-pixels and an (i+2)-th row of sub-pixels, where i is an integer greater than 1 and less than K.

FIG. 1

FIG. 2

FIG. 3

FIG. 4A

FIG. 4B

FIG. 4C

FIG. 4D

FIG. 5A

49

FIG. 5B

FIG. 5C

FIG. 6A

FIG. 6B

FIG. 6C

FIG. 7A

FIG. 7B

FIG. 8A

FIG. 8B

FIG. 8C

RST2(i-1)/RST2(i)

EML(i)

RST1(i)/RST1(i+1)

GL1(i)

GL2b(i+1)

GL2b(i)

i-th row

GL1(i+1)

RST2(i+1)/RST2(i+2)

EML(i+1)

(i+1)-th row

EML(i+2)

RST1(i+2)/RST1(i+3)

GL1(i+2)

GL2b(i+3)

GL2b(i+2)

(i+2)-th row

GL1(i+3)

RST2(i+3)/RST2(i+4)

EML(i+3)

(i+3)-th row

**FIG. 9A**

L1    L2

392a   392b   392c   392d

GL2b(i)

392-2   392-1   392-2   392-1   392-2

i-th row

GL2b(i+1)

392-2   392-1   392-2   392-1   392-2

392a   392b   392c   392d

(i+1)-th row

GL2b(i+2)

(i+2)-th row

GL2b(i+3)

(i+3)-th row

**FIG. 9B**

FIG. 9C

FIG. 10A

FIG. 10B

FIG. 10C

FIG. 11A

FIG. 11B

FIG. 11C

FIG. 12A

FIG. 12B

FIG. 13A

FIG. 13B

FIG. 13C

**FIG. 13D**

**FIG. 13E**

FIG. 13F

FIG. 14A

FIG. 14B

FIG. 15A

FIG. 15B

FIG. 15C

FIG. 16A

FIG. 16B

FIG. 17A

FIG. 17B

FIG. 17C

FIG. 18A

FIG. 18B

FIG. 19A

FIG. 19B

FIG. 19C

FIG. 20A

FIG. 20B

FIG. 20C

FIG. 21A

FIG. 21B

FIG. 21C

FIG. 22A

FIG. 22B

FIG. 22C

FIG. 23A

FIG. 23B

FIG. 24A

FIG. 24B

FIG. 24C

RST2(i-1)/RST2(i)

EML(i)

RST1(i)/RST1(i+1)

GL1(i)

GL2b0(i+1)

GL2b(i)

GL1(i+1)

RST2(i+1)/RST2(i+2)

EML(i+1)

EML(i+2)

RST1(i+2)/RST1(i+3)

GL1(i+2)

GL2b0(i+3)

GL2b(i+2)

GL1(i+3)

RST2(i+3)/RST2(i+4)

EML(i+3)

i-th row

(i+1)-th row

(i+2)-th row

(i+3)-th row

Y

X

**FIG. 25A**

ZL3

L1    L2

392a   392b   392c   392d

ZL3

GL2b(i)

392-2   392-1   392-2   392-1   392-2

GL2b0(i+1)

392-2   392-1   392-2   392-1   392-2

392a   392b   392c   392d

ZL3

ZL3

GL2b(i+2)

GL2b0(i+3)

i-th row

(i+1)-th row

(i+2)-th row

(i+3)-th row

Y

X

**FIG. 25B**

FIG. 25C

FIG. 26A

FIG. 26B

FIG. 26C

FIG. 27A

FIG. 27B

FIG. 28A

FIG. 28B

FIG. 28C

FIG. 29

In at least some of signal lines of at least one kind, each signal line provides an effective signal to at least two rows of sub-pixels

FIG. 30

FIG. 31

## INTERNATIONAL SEARCH REPORT

| International application No. |
|---|
| **PCT/CN2023/115538** |

| A. | CLASSIFICATION OF SUBJECT MATTER |
|---|---|

G09G 3/3208(2016.01)i

According to International Patent Classification (IPC) or to both national classification and IPC

| B. | FIELDS SEARCHED |
|---|---|

Minimum documentation searched (classification system followed by classification symbols)

IPC,CPC:G09G3/32+,H01L27/-

Documentation searched other than minimum documentation to the extent that such documents are included in the fields searched

Electronic data base consulted during the international search (name of data base and, where practicable, search terms used)

CNTXT, VEN, ENTXT, WPABS: 基板, 衬底, 像素, 行, 信号线, 共用, 共用, 同时, 两行, 投影, 区域, 透光, 重叠, 交叠, substrate, pixel, line, row, common, share, same, overlap

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2023050055 A1 (BOE TECHNOLOGY GROUP CO., LTD. et al.) 06 April 2023 (2023-04-06) description, paragraphs [0068]-[0078], and figures 1-3 | 1-4, 6-7, 9, 12-29 |
| Y | WO 2023050055 A1 (BOE TECHNOLOGY GROUP CO., LTD. et al.) 06 April 2023 (2023-04-06) description, paragraphs [0068]-[0078], and figures 1-3 | 5, 8, 10-11 |
| Y | WO 2023039886 A1 (BOE TECHNOLOGY GROUP CO., LTD. et al.) 23 March 2023 (2023-03-23) description, paragraph [0115] | 5, 8, 10-11 |
| A | CN 114120905 A (HEFEI BOE JOINT TECHNOLOGY CO., LTD. et al.) 01 March 2022 (2022-03-01) entire document | 1-29 |
| A | CN 114373774 A (BOE TECHNOLOGY GROUP CO., LTD. et al.) 19 April 2022 (2022-04-19) entire document | 1-29 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **11 May 2024** | **24 May 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/115538** |

**C. DOCUMENTS CONSIDERED TO BE RELEVANT**

| Category* | Citation of document, with indication, where appropriate, of the relevant passages | Relevant to claim No. |
|---|---|---|
| A | CN 114823835 A (BOE TECHNOLOGY GROUP CO., LTD. et al.) 29 July 2022 (2022-07-29) entire document | 1-29 |
| A | WO 2023028944 A1 (BOE TECHNOLOGY GROUP CO., LTD. et al.) 09 March 2023 (2023-03-09) entire document | 1-29 |

Form PCT/ISA/210 (second sheet) (July 2022)

## INTERNATIONAL SEARCH REPORT
### Information on patent family members

International application No.

**PCT/CN2023/115538**

| Patent document cited in search report | | | Publication date (day/month/year) | Patent family member(s) | | | Publication date (day/month/year) |
|---|---|---|---|---|---|---|---|
| WO | 2023050055 | A1 | 06 April 2023 | WO | 2023050055 | A9 | 26 October 2023 |
| WO | 2023039886 | A1 | 23 March 2023 | None | | | |
| CN | 114120905 | A | 01 March 2022 | None | | | |
| CN | 114373774 | A | 19 April 2022 | None | | | |
| CN | 114823835 | A | 29 July 2022 | None | | | |
| WO | 2023028944 | A1 | 09 March 2023 | EP | 4307860 | A1 | 17 January 2024 |
| | | | | EP | 4307860 | A4 | 10 April 2024 |

Form PCT/ISA/210 (patent family annex) (July 2022)